(19) Europäisches Patentamt
European Patent Office
Office européen des brevets

(11) **EP 2 273 683 B1**

(12) **EUROPEAN PATENT SPECIFICATION**

(45) Date of publication and mention
of the grant of the patent:
**19.06.2013 Bulletin 2013/25**

(51) Int Cl.:
*H04L 1/00* (2006.01)   *H03M 13/11* (2006.01)
*H03M 13/25* (2006.01)   *H03M 13/29* (2006.01)
*H03M 13/00* (2006.01)   *H04L 27/20* (2006.01)
*H04L 27/34* (2006.01)   *H04L 27/36* (2006.01)
*H04L 27/18* (2006.01)   *H04L 25/06* (2006.01)
*H04H 40/90* (2008.01)   *H03M 13/35* (2006.01)
*H03M 13/15* (2006.01)   *H03M 13/09* (2006.01)

(21) Application number: **10178955.0**

(22) Date of filing: **03.07.2003**

(54) **Encoding of low density parity check (LDPC) codes**

Kodierung von Low Density Parity Check (LDPC) Kodes

Codage de codes LDPC (Low Density Parity Check)

(84) Designated Contracting States:
**AT BE BG CH CY CZ DE DK EE ES FI FR GB GR HU IE IT LI LU MC NL PT RO SE SI SK TR**

(30) Priority: **03.07.2002 US 393457 P**
**26.07.2002 US 398760 P**
**15.08.2002 US 403812 P**
**25.10.2002 US 421505 P**
**29.10.2002 US 421999 P**
**04.11.2002 US 423710 P**
**15.01.2003 US 440199 P**
**14.02.2003 US 447641 P**
**20.03.2003 US 456220 P**
**09.05.2003 US 469356 P**
**24.06.2003 US 482112 P**
**24.06.2003 US 482107 P**

(43) Date of publication of application:
**12.01.2011 Bulletin 2011/02**

(62) Document number(s) of the earlier application(s) in accordance with Art. 76 EPC:
**03763495.3 / 1 413 059**

(73) Proprietor: **DTVG LICENSING, INC**
**El Segundo CA 90245 (US)**

(72) Inventors:
• **Eroz, Mustafa**
  **Germantown, MD 20874 (US)**
• **Sun, Feng-Wen**
  **Germantown, MD 20874 (US)**
• **Lee, Lin-Nan**
  **Potomac, MD 20854 (US)**

(74) Representative: **Brunner, John Michael Owen**
**Carpmaels & Ransford**
**One Southampton Row**
**London**
**WC1B 5HA (GB)**

(56) References cited:
**EP-A1- 1 093 231    WO-A2-02/099976**

• **BOND J W ET AL: "Constructing low-density parity-check codes", PROC., INFORMATION SYSTEMS FOR ENHANCED PUBLIC SAFETY AND SECURITY, EUROCOMM 2000, IEEE/AFCEA 17 MAY 2000, PISCATAWAY, NJ, USA, 1 January 2000 (2000-01-01), pages 260-262, XP010515080, ISBN: 978-0-7803-6323-6**
• **BOND J W ET AL: "Constructing low-density parity-check codes with circulant matrices", INFORMATION THEORY AND NETWORKING WORKSHOP, 1999 METSOVO, GREECE 27 JUNE-1 JULY 1999, PISCATAWAY, NJ, USA, IEEE, US LNKD- DOI:10.1109/ITNW.1999.814359, 27 June 1999 (1999-06-27), page 52, XP010365561, ISBN: 978-0-7803-5954-3**
• **YU YI ET AL: "Design of semi-algebraic low-density parity-check (SA-LDPC) codes for multilevel coded modulation", PROC., IEEE INTERNAT. CONFERENCE ON PARALLEL AND DISTRIBUTED COMPUTING, APPLICATIONS AND TECHNOLOGIES, PDCAT'2003, 27 August 2003 (2003-08-27), pages 931-934, XP010661473, ISBN: 978-0-7803-7840-7**

- **BANE VASIC ET AL: "Low-Density Parity Check Codes for Long-Haul Optical Communication Systems", IEEE PHOTONICS TECHNOLOGY LETTERS, IEEE SERVICE CENTER, PISCATAWAY, NJ, US, vol. 14, no. 8, 1 August 2002 (2002-08-01) , XP011067271, ISSN: 1041-1135**
- **LI PING ET AL: "Low density parity check codes with semi-random parity check matrix", ELECTRONICS LETTERS, IEE STEVENAGE, GB LNKD- DOI:10.1049/EL:19990065, vol. 35, no. 1, 7 January 1999 (1999-01-07), pages 38-39, XP006011650, ISSN: 0013-5194**
- **ELEFTHERIOU E ET AL: "Low-density parity-check codes for digital subscriber lines", PROC., IEEE INTERNATIONAL CONFERENCE ON COMMUNICATIONS, NEW YORK, NY,USA, vol. 1 OF 5, 28 April 2002 (2002-04-28), - 2 May 2002 (2002-05-02), pages 1752-1757, XP010589787, ISBN: 0-7803-7400-2**
- **ZHANG T. ET AL: "Joint code and decoder design for implementation-oriented (3, k)-regular LDPC codes", PROC., THE 35TH. ASILOMAR CONFERENCE ON SIGNALS, SYSTEMS, & COMPUTERS. PACIFIC GROOVE, CA, USA, vol. 1 OF 2. CONF. 35, 4 November 2001 (2001-11-04), - 7 November 2001 (2001-11-07), pages 1232-1236, XP010582236, ISBN: 0-7803-7147-X**
- **ECHARD R ET AL: "THE PI-ROTATION LOW-DENSITY PARITY CHECK CODES", GLOBECOM'01. 2001 IEEE GLOBAL TELECOMMUNICATIONS CONFERENCE. SAN ANTONIO, TX, NOV. 25 - 29, 2001; [IEEE GLOBAL TELECOMMUNICATIONS CONFERENCE], NEW YORK, NY : IEEE, US LNKD- DOI: 10.1109/GLOCOM.2001.965564, 25 November 2001 (2001-11-25), pages 980-984, XP001099251, ISBN: 978-0-7803-7206-1**
- **SARAH J JOHNSON ET AL: "A Family of Irregular LDPC Codes With Low Encoding Complexity", IEEE COMMUNICATIONS LETTERS, IEEE SERVICE CENTER, PISCATAWAY, NJ, US, vol. 7, no. 2, 1 February 2003 (2003-02-01), XP011066488, ISSN: 1089-7798**
- **BANE VASIC ET AL: "Kirkman Systems and Their Application in Perpendicular Magnetic Recording", IEEE TRANSACTIONS ON MAGNETICS, IEEE SERVICE CENTER, NEW YORK, NY, US, vol. 38, no. 4, 1 July 2002 (2002-07-01), XP011075224, ISSN: 0018-9464**

**Description**

FIELD OF THE INVENTION

The present invention relates to communication systems, and more particularly to coded systems.

BACKGROUND OF THE INVENTION

Communication systems employ coding to ensure reliable communication across noisy communication channels. These communication channels exhibit a fixed capacity that can be expressed in terms of bits per symbol at certain signal to noise ratio (SNR), defining a theoretical upper limit (known as the Shannon limit). As a result, coding design has aimed to achieve rates approaching this Shannon limit. Conventional coded communication systems have separately treated the processes of coding and modulation. Moreover, little attention has been paid to labeling of signal constellations.

A signal constellation provides a set of possible symbols that are to be transmitted, whereby the symbols correspond to codewords output from an encoder. One choice of constellation labeling involves Gray-code labeling. With Gray-code labeling, neighboring signal points differ in exactly one bit position. The prevailing conventional view of modulation dictates that any reasonable labeling scheme can be utilized, which in part is responsible for the paucity of research in this area.

With respect to coding, one class of codes that approach the Shannon limit is Low Density Parity Check (LDPC) codes. Traditionally, LDPC codes have not been widely deployed because of a number of drawbacks. One drawback is that the LDPC encoding technique is highly complex. Encoding an LDPC code using its generator matrix would require storing a very large, non-sparse matrix. Additionally, LDPC codes require large blocks to be effective; consequently, even though parity check matrices of LDPC codes are sparse, storing these matrices is problematic.

From an implementation perspective, a number of challenges are confronted. For example, storage is an important reason why LDPC codes have not become widespread in practice. Also, a key challenge in LDPC code implementation has been how to achieve the connection network between several processing engines (nodes) in the decoder. Further, the computational load in the decoding process, specifically the check node operations, poses a problem.

"Constructing Low-Density Parity-Check Codes", J.W.Bond et al. (Proc., IEEE/AFCEA Information Systems for Enhanced Public Safety and Security, EUROCOMM 2000, 17 May 2000) describes the construction of powerful LDPC codes with code rates 1/2 and 4/7.

There is a need for using LDPC codes efficiently to support high data rates, without introducing greater complexity. There is also a need to improve performance of LDPC encoders and decoders.

SUMMARY OF THE INVENTION

These and other needs are addressed by the present invention which is defined in the appendant claims. An encoder, such as a Low Density Parity Check (LDPC) encoder, generates encoded signals by transforming an input message into a codeword represented by a plurality of set of bits.

According to one aspect of an embodiment of the present invention, a method for generating encoded signals is disclosed. The method includes receiving one of a plurality of set of bits of a codeword from an encoder for transforming an input message into the codeword.

According to another aspect of an embodiment of the present invention, an encoder for generating encoded signals is disclosed. The encoder is configured to transform an input message into a codeword represented by a plurality of set of bits.

Still other aspects, features, and advantages of the present invention are readily apparent from the following detailed description, simply by illustrating a number of particular embodiments and implementations, including the best mode contemplated for carrying out the present invention. The present invention is also capable of other and different embodiments, and its several details can be modified in various obvious respects, all without departing from the scope of the present invention. Accordingly, the drawing and description are to be regarded as illustrative in nature, and not as restrictive.

BRIEF DESCRIPTION OF THE DRAWINGS

The present invention is illustrated by way of example, and not by way of limitation, in the figures of the accompanying drawings and in which like reference numerals refer to similar elements and in which:

FIG. 1 is a diagram of a communications system configured to utilize Low Density Parity Check (LDPC) codes;

FIGs. 2A and 2B are diagrams of exemplary LDPC encoders deployed in the transmitter of FIG. 1;

FIG. 3 is a diagram of an exemplary receiver in the system of FIG. 1;

FIG. 4 is a diagram of a sparse parity check matrix;

FIG. 5 is a diagram of a bipartite graph of an LDPC code of the matrix of FIG. 4;

FIG. 6 is a diagram of a sub-matrix of a sparse parity check matrix, wherein the sub-matrix contains parity check values restricted to the lower triangular region;

FIG. 7 is a graph showing performance between codes utilizing unrestricted parity check matrix (H matrix) versus restricted H matrix having a sub-matrix as in FIG. 6;

FIGs. 8A and 8B are, respectively, a diagram of a non-Gray 8-PSK modulation scheme, and a Gray 8-PSK modulation, each of which can be used in the system of FIG. 1;

FIG. 8C is a diagram of a process for bit labeling for a higher order signal constellation;

FIG. 8D is a diagram of exemplary 16-APSK (Amplitude Phase Shift Keying) constellations;

FIG. 8E is a graph of Packet Error Rate (PER) versus signal-to-noise for the constellations of FIG. 8D;

FIG. 8F is a diagram of constellations for Quadrature Phase Shift Keying (QPSK), 8-PSK, 16-APSK and 32-APSK symbols;

FIG. 8G is a diagram of alternative constellations for 8-PSK, 16-APSK and 32-APSK symbols;

FIG. 8H is a graph of Packet Error Rate (PER) versus signal-to-noise for the constellations of FIG. 8F;

FIG. 9 is a graph showing performance between codes utilizing Gray labeling versus non-Gray labeling;

FIG. 10 is a flow chart of the operation of the LDPC decoder using non-Gray mapping;

FIG. 11 is a flow chart of the operation of the LDPC decoder of FIG. 3 using Gray mapping;

FIGs. 12A-12C are diagrams of the interactions between the check nodes and the bit nodes in a decoding process;

FIGs. 13A and 13B are flowcharts of processes for computing outgoing messages between the check nodes and the bit nodes using, respectively, a forward-backward approach and a parallel approach,;

FIGs. 14A-14C are graphs showing simulation results of LDPC codes generated;

FIGs. 15A and 15B are diagrams of the top edge and bottom edge, respectively, of memory organized to support structured access as to realize randomness in LDPC coding; and

FIG. 16 is a diagram of a computer system that can perform the processes of encoding and decoding of LDPC codes.

## DESCRIPTION OF THE PREFERRED EMBODIMENT

In the following description, for the purposes of explanation, numerous specific details are set forth in order to provide a thorough understanding of the present invention. It is apparent, however, to one skilled in the art that the present invention may be practiced without these specific details or with an equivalent arrangement. In other instances, well-known structures and devices are shown in block diagram form in order to avoid unnecessarily obscuring the present invention.

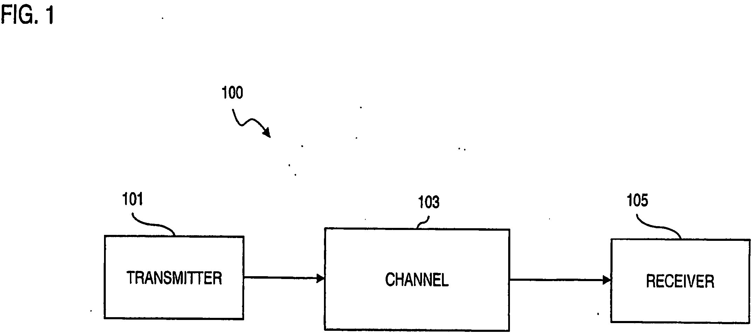

FIG. 1 is a diagram of a communications system configured to utilize Low Density Parity Check (LDPC) codes, according to an embodiment of the present invention. A digital communications system 100 includes a transmitter 101 that generates signal waveforms across a communication channel 103 to a receiver 105. In this discrete communications system 100, the transmitter 101 has a message source that produces a discrete set of possible messages; each of the possible messages has a corresponding signal waveform. These signal waveforms are attenuated, or otherwise altered, by communications channel 103. To combat the noise channel 103, LDPC codes are utilized.

The LDPC codes that are generated by the transmitter 101 enables high speed implementation without incurring any performance loss. These structured LDPC codes output from the transmitter 101 avoid assignment of a small number of check nodes to the bit nodes already vulnerable to channel errors by virtue of the modulation scheme (e.g., 8-PSK).

Such LDPC codes have a parallelizable decoding algorithm (unlike turbo codes), which advantageously involves simple operations such as addition, comparison and table look-up. Moreover, carefully designed LDPC codes do not exhibit any sign of error floor.

According to one embodiment of the present invention, the transmitter 101 generates, using a relatively simple encoding technique, LDPC codes based on parity check matrices (which facilitate efficient memory access during decoding) to communicate with the receiver 105. The transmitter 101 employs LDPC codes that can outperform concatenated turbo+RS (Reed-Solomon) codes, provided the block length is sufficiently large.

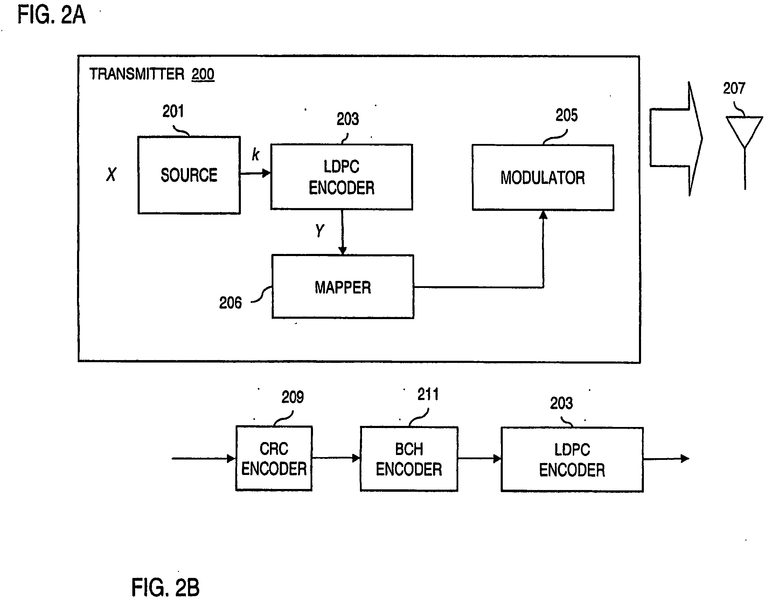

FIGs. 2A and 2B are diagrams of exemplary LDPC encoders deployed in the transmitter of FIG. 1. As seen in FIG. 2A, a transmitter 200 is equipped with an LDPC encoder 203 that accepts input from an information source 201 and outputs coded stream of higher redundancy suitable for error correction processing at the receiver 105. The information source 201 generates k signals from a discrete alphabet, $X$. LDPC codes are specified with parity check matrices. On the other hand, encoding LDPC codes require, in general, specifying the generator matrices. Even though it is possible to obtain generator matrices from parity check matrices using Gaussian elimination, the resulting matrix is no longer sparse and storing a large generator matrix can be complex.

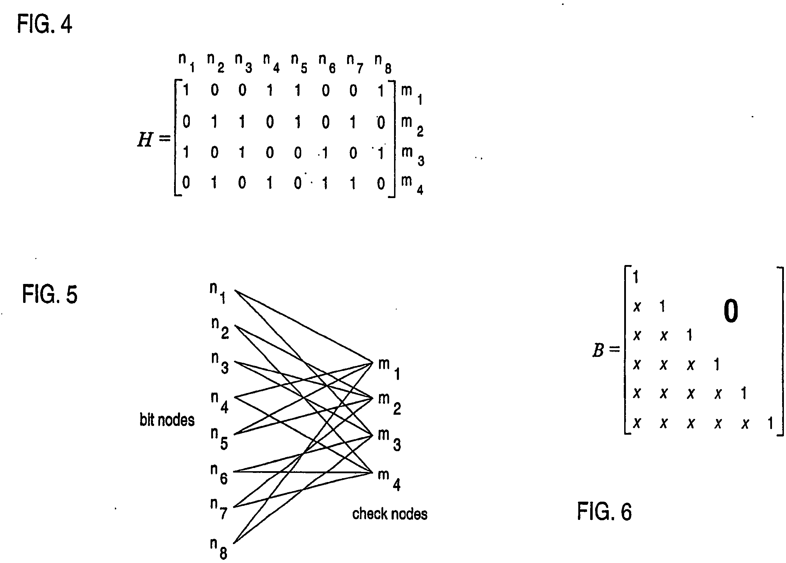

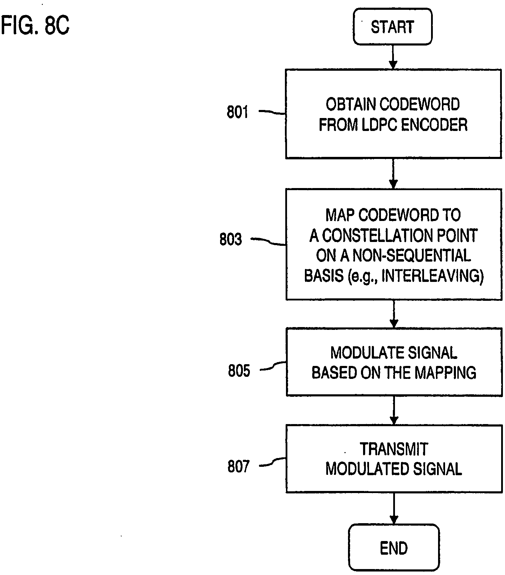

Encoder 203 generates signals from alphabet *Y* to a signal mapper 206, which provides a mapping of the alphabet *Y* to the symbols of the signal constellation corresponding to the modulation scheme employed by a modulator 205. This mapping follows a non-sequential scheme, such as interleaving. Exemplary mappings are more fully described below with respect to FIGs. 8C. The encoder 203 uses a simple encoding technique that makes use of only the parity check matrix by imposing structure onto the parity check matrix. Specifically, a restriction is placed on the parity check matrix by constraining certain portion of the matrix to be triangular. The construction of such a parity check matrix is described more fully below in FIG. 6. Such a restriction results in negligible performance loss, and therefore, constitutes an attractive trade-off.

The modulator 205 modulates the symbols of the signal constellation from the mapper 206 to signal waveforms that are transmitted to a transmit antenna 207, which emits these waveforms over the communication channel 103. The transmissions from the transmit antenna 207 propagate to a receiver, as discussed below.

FIG. 2B shows an LDPC encoder utilized with a Bose Chaudhuri Hocquenghem (BCH) encoder and a cyclic redundancy check (CRC) encoder. Under this scenario, the codes generated by the LDPC encoder 203, along with the CRC encoder 209 and the BCH encoder 211, have a concatenated outer BCH code and inner low density parity check (LDPC) code. Furthermore, error detection is achieved using cyclic redundancy check (CRC) codes. The CRC encoder 209, in an exemplary embodiment, encodes using an 8-bit CRC code with generator polynomial $(x^5+x^4+x^3+x^2+1)(x^2+x+1)$ $(x+1)$.

The LDPC encoder 203 systematically encodes an information block of size $k_{ldpc}$, $i=(i_0, i_1,...,i_{kldpc-1})$ onto a codeword of size $n_{ldpc}$, $c = (i_0, i_1,..., i_{kldpc-1}, p_0, p_1,..p_{nlppc-kldpc-1})$ The transmission of the codeword starts in the given order from $i_0$ and ends with $p_{nldpc-kldpc-1}$. LDPC code parameters $(n_{ldpc},k_{ldpc})$ are given in Table 1 below whereby the LDPC codes with rates 1/2, 2/3, 3/4 and 5/6 are examples which are not part of the invention.

Table 1

| LDPC Code Parameters ($n_{ldpc}$, $k_{ldpc}$) | | |
|---|---|---|
| Code Rate | LDPC Uncoded Block Length $k_{ldpc}$ | LDPC Coded Block Length $n_{ldpc}$ |
| 1/2 | 32400 | 64800 |
| 2/3 | 43200 | 64800 |
| 3/4 | 48600 | 64800 |
| 4/5 | 51840 | 64800 |
| 5/6 | 54000 | 64800 |
| 3/5 | 38880 | 64800 |
| 8/9 | 57600 | 64800 |
| 9/10 | 58320 | 64800 |

The task of the LDPC encoder 203 is to determine $n_{ldpc}$ - $k_{ldpc}$ parity bits $(p_0, p_1,..., p_{nldpc-kldpc-1})$ for every block of $k_{ldpc}$ information bits, $(i_0, i_1,..., i_{kldpc-1})$. The procedure is as follows. First, the parity bits are initialized; $p_0 = p_1 = p_2 = ... = p_{nldpc-kldpc-1} = 0$. The first information bit, $i_0$, are accumulated at parity bit addresses specified in the first row of Tables 3 through 10. For example, for rate 2/3 (Table 3), the following results:

$$p_0 = p_0 \oplus i_0$$

$$p_{10491} = p_{10491} \oplus i_0$$

$$p_{16043} = p_{16043} \oplus i_0$$

$$p_{506} = p_{506} \oplus i_0$$

$$p_{12826} = p_{12826} \oplus i_0$$

$$p_{8065} = p_{8065} \oplus i_0$$

$$p_{8226} = p_{8226} \oplus i_0$$

$$p_{27167} = p_{27167} \oplus i_0$$

$$p_{240} = p_{240} \oplus i_0$$

$$p_{18673} = p_{18673} \oplus i_0$$

$$p_{9279} = p_{9279} \oplus i_0$$

$$p_{10579} = p_{10579} \oplus i_0$$

$$p_{20928} = p_{20928} \oplus i_0$$

(All additions are in GF(2)).

Then, for the next 359 information bits, $i_m$, $m = 1,2,...,359$ , these bits are accumulated at parity bit addresses $\{x + m \bmod 360 \times q\} \bmod(n_{ldpc}-k_{ldpc})$, where $x$ denotes the address of the parity bit accumulator corresponding to the first bit $i_0$, and $q$ is a code rate dependent constant specified in Table 2. Continuing with the example, $q = 60$ for rate 2/3. By way of example, for information bit $i_1$, the following operations are performed:

$$p_{60} = p_{60} \oplus i_1$$

$$p_{10551} = p_{10551} \oplus i_1$$

$$p_{16103} = p_{16103} \oplus i_1$$

$$p_{566} = p_{566} \oplus i_1$$

$$p_{12886} = p_{12886} \oplus i_1$$

$$p_{8125} = p_{8125} \oplus i_1$$

$$p_{8286} = p_{8286} \oplus i_1$$

$$p_{2827} = p_{2827} \oplus i_1$$

$$p_{300} = p_{300} \oplus i_1$$

$$p_{18733} = p_{18733} \oplus i_1$$

$$p_{9339} = p_{9339} \oplus i_1$$

$$p_{10639} = p_{10639} \oplus i_1$$

$$p_{20988} = p_{20988} \oplus i_1$$

For the 361st information bit $i_{360}$, the addresses of the parity bit accumulators are given in the second row of the Tables 3 through 10. In a similar manner the addresses of the parity bit accumulators for the following 359 information bits $i_m$, $m$ = 361,362,...,719 are obtained using the formula $\{x+m \bmod 360\times q\} \bmod(n_{ldpc}\text{-}k_{ldpc})$, where $x$ denotes the address of the parity bit accumulator corresponding to the information bit $i_{360}$, i.e., the entries in the second row of the Tables 3-10. In a similar manner, for every group of 360 new information bits, a new row from Tables 3 through 10 are used to find the addresses of the parity bit accumulators.

After all of the information bits are exhausted, the final parity bits are obtained as follows. First, the following operations are performed, starting with $i$=1

$$p_i = p_i \oplus p_{i-1}, \quad i = 1,2,...,n_{ldpc} - k_{ldpc} - 1.$$

Final content of $p_i$, $i$ = 0,1,.., $n_{ldpc}$-$k_{ldpc}$-1 is equal to the parity bit $p_i$.

Table 2

| Code Rate | q |
|:---:|:---:|
| 2/3 | 60 |
| 5/6 | 30 |
| 1/2 | 90 |
| 3/4 | 45 |
| 4/5 | 36 |
| 3/5 | 72 |
| 8/9 | 20 |
| 9/10 | 18 |

Table 3

| Address of Parity Bit Accumulators (Rate 2/3) |
|---|
| 0 10491 16043 50612826 8065 8226 2767 24018673 9279 10579 20928 |
| 1 17819 8313 6433 6224 5120 5824 12812 17187 9940 13447 13825 18483 |
| 2 17957 6024 8681 18628 12794 5915 1457610970 12064 20437 4455 7151 |
| 3 19777 6183 997214536 8182 17749 11341 5556 4379 1743415477 18532 |
| 4 4651 19689 1608 659 16707 14335 6143 3058 14618 17894 20684 5306 |

(continued)

| Address of Parity Bit Accumulators (Rate 2/3) |
|---|
| 5 9778 25521 20961 2369 15198 16890 4851 3109 1700 18725 1997 15882 |
| 6 486 6111 13743 11537 5591 7433 15227 14145 1483 3887 17431 12430 |
| 7 20647 14311 11734 4180 8110 5525 12141 15761 18661 18441 10569 8192 |
| 8 3791 14759 15264 19918 10132 9062 10010 12786 10675 9682 19246 5454 |
| 9 19525 9485 7777 19999 8378 9209 3163 20232 6690 16518 716 7353 |
| 10 4588 6709 20202 10905 915 4317 11073 13576 16433 368 3508 21171 |
| 11 14072 4033 19959 12608 631 19494 14160 8249 10223 21504 12395 4322 |
| 12 13800 14161 |
| 13 2948 9647 |
| 14 14693 16027 |
| 15 20506 11082 |
| 16 1143 9020 |
| 17 13501 4014 |
| 18 1548 2190 |
| 19 12216 21556 |
| 20 2095 19897 |
| 21 4189 7958 |
| 22 15940 10048 |
| 23 515 12614 |
| 24 8501 8450 |
| 25 17595 16784 |
| 26 5913 8495 |
| 27 16394 10423 |
| 28 7409 6981 |
| 29 6678 15939 |
| 30 20344 12987 |
| 31 2510 14588 |
| 32 17918 6655 |
| 33 6703 19451 |
| 34 496 4217 |
| 35 7290 5766 |
| 36 10521 8925 |
| 37 20379 11905 |
| 38 4090 5838 |
| 39 19082 17040 |
| 40 20233 12352 |
| 41 19365 19546 |
| 42 6249 19030 |
| 43 11037 19193 |
| 44 19760 11772 |
| 45 19644 7428 |
| 46 16076 3521 |
| 47 11779 21062 |
| 48 13062 9682 |
| 49 8934 5217 |
| 50 11087 3319 |
| 51 18892 4356 |
| 52 7894 3898 |
| 53 5963 4360 |
| 54 7346 11726 |

(continued)

| Address of Parity Bit Accumulators (Rate 2/3) |
|---|
| 55 5182 5609 |
| 56 2412 17295 |
| 57 9845 20494 |
| 58 6687 1864 |
| 59 20564 5216 |
| 0 18226 17207 |
| 1 9380 8266 |
| 2 7073 3065 |
| 3 18252 13437 |
| 4 9161 15642 |
| 5 10714 10153 |
| 6 11585 9078 |
| 7 5359 9418 |
| 8 9024 9515 |
| 9 1206 16354 |
| 10 14994 1102 |
| 11 9375 20796 |
| 12 15964 6027 |
| 13 14789 6452 |
| 14 8002 18591 |
| 15 14742 14089 |
| 16 253 3045 |
| 17 1274 19286 |
| 18 14777 2044 |
| 19 13920 9900 |
| 20 452 7374 |
| 21 18206 9921 |
| 22 6131 5414 |
| 23 10077 9726 |
| 24 12045 5479 |
| 25 4322 7990 |
| 26 15616 5550 |
| 27 15561 10661 |
| 28 20718 7387 |
| 29 2518 18804 |
| 30 8984 2600 |
| 31 6516 17909 |
| 32 11148 98 |
| 33 20559 3704 |
| 34 7510 1569 |
| 35 16000 11692 |
| 36 9147 10303 |
| 37 16650 191 |
| 38 1557718685 |
| 39 17167 20917 |
| 40 4256 3391 |
| 41 20092 17219 |
| 42 9218 5056 |
| 43 18429 8472 |
| 44 12093 20753 |

(continued)

| Address of Parity Bit Accumulators (Rate 2/3) |
|---|
| 45 16345 12748 |
| 46 16023 11095 |
| 47 5048 17595 |
| 48 18995 4817 |
| 49 16483 3536 |
| 50 1439 16148 |
| 51 3661 3039 |
| 52 19010 18121 |
| 53 8968 11793 |
| 54 13427 18003 |
| 55 5303 3083 |
| 56 531 16668 |
| 57 4771 6722 |
| 58 5695 7960 |
| 59 3589 14630 |

Table 4

| Address of Parity Bit Accumulators (Rate 5/6) |
|---|
| 0 4362 416 8909 4156 3216 3112 2560 2912 6405 8593 4969 6723 |
| 1 2479 1786 8978 3011 4339 9313 6397 2957 7288 5484 6031 10217 |
| 2 10175 9009 9889 3091 4985 7267 4092 8874 5671 2777 2189 8716 |
| 3 9052 4795 3924 3370 10058 1128 9996 10165 9360 4297 434 5138 |
| 4 2379 7834 4835 2327 9843 804 329 8353 7167 3070 1528 7311 |
| 5 3435 7871 348 3693 1876 6585 10340 7144 5870 2084 4052 2780 |
| 6 3917 3111 3476 1304 10331 5939 5199 1611 1991 699 8316 9960 |
| 7 6883 3237 1717 10752 7891 9764 4745 3888 10009 4176 4614 1567 |
| 8 10587 2195 1689 2968 5420 2580 2883 6496 111 6023 1024 4449 |
| 9 3786 8593 2074 3321 5057 1450 3840 5444 6572 3094 9892 1512 |
| 10 8548 1848 10372 4585 7313 6536 6379 1766 9462 2456 5606 9975 |
| 11 8204 10593 7935 3636 3882 394 5968 8561 2395 7289 9267 9978 |
| 12 7795 74 1633 9542 6867 7352 6417 7568 10623 725 2531 9115 |
| 13 7151 2482 4260 5003 10105 7419 9203 6691 8798 2092 8263 3755 |
| 14 3600 570 4527 200 9718 6771 1995 8902 5446 768 1103 6520 |
| 15 6304 7621 |
| 16 6498 9209 |
| 17 7293 6786 |
| 18 5950 1708 |
| 19 8521 1793 |
| 20 6174 7854 |
| 21 9773 1190 |
| 22 9517 10268 |
| 23 2181 9349 |
| 24 1949 5560 |
| 25 1556 555 |
| 26 8600 3827 |
| 27 5072 1057 |
| 28 7928 3542 |
| 29 3226 3762 |

(continued)

| Address of Parity Bit Accumulators (Rate 5/6) |
| --- |
| 0 7045 2420 |
| 1 9645 2641 |
| 2 2774 2452 |
| 3 5331 2031 |
| 4 9400 7503 |
| 5 1850 2338 |
| 6 10456 9774 |
| 7 1692 9276 |
| 8 10037 4038 |
| 9 3964 338 |
| 10 2640 5087 |
| 11 858 3473 |
| 12 5582 5683 |
| 13 9523 916 |
| 14 4107 1559 |
| 15 4506 3491 |
| 16 8191 4182 |
| 17 10192 6157 |
| 18 5668 3305 |
| 19 3449 1540 |
| 20 4766 2697 |
| 21 4069 6675 |
| 22 1117 1016 |
| 23 5619 3085 |
| 24 8483 8400 |
| 25 8255 394 |
| 26 6338 5042 |
| 27 6174 5119 |
| 28 7203 1989 |
| 29 1781 5174 |
| 0 1464 3559 |
| 1 3376 4214 |
| 2 7238 67 |
| 3 10595 8831 |
| 4 1221 6513 |
| 5 5300 4652 |
| 6 1429 9749 |
| 7 7878 5131 |
| 8 4435 10284 |
| 9 6331 5507 |
| 10 6662 4941 |
| 11 9614 10238 |
| 12 8400 8025 |
| 13 9156 5630 |
| 14 7067 8878 |
| 15 9027 3415 |
| 16 1690 3866 |
| 17 2854 8469 |
| 18 6206 630 |
| 19 363 5453 |

(continued)

| Address of Parity Bit Accumulators (Rate 5/6) |
|---|
| 20 4125 7008 |
| 21 1612 6702 |
| 22 9069 9226 |
| 23 5767 4060 |
| 24 3743 9237 |
| 25 7018 5572 |
| 26 8892 4536 |
| 27 853 6064 |
| 28 8069 5893 |
| 29 2051 2885 |
| 0 10691 3153 |
| 1 3602 4055 |
| 2 328 1717 |
| 3 2219 9299 |
| 4 1939 7898 |
| 5 617 206 |
| 6 8544 1374 |
| 7 10676 3240 |
| 8 6672 9489 |
| 9 3170 7457 |
| 10 7868 5731 |
| 11 6121 10732 |
| 12 4843 9132 |
| 13 580 9591 |
| 14 6267 9290 |
| 15 3009 2268 |
| 16 195 2419 |
| 17 8016 1557 |
| 18 1516 9195 |
| 19 8062 9064 |
| 20 2095 8968 |
| 21 753 7326 |
| 22 6291 3833 |
| 23 2614 7844 |
| 24 2303 646 |
| 25 2075 611 |
| 26 4687 362 |
| 27 8684 9940 |
| 28 4830 2065 |
| 29 7038 1363 |
| 0 1769 7837 |
| 1 3801 1689 |
| 2 10070 2359 |
| 3 3667 9918 |
| 4 1914 6920 |
| 5 4244 5669 |
| 6 10245 7821 |
| 7 7648 3944 |
| 8 3310 5488 |
| 9 6346 9666 |

(continued)

| Address of Parity Bit Accumulators (Rate 5/6) |
|---|
| 10 7088 6122 |
| 11 1291 7827 |
| 12 10592 8945 |
| 13 3609 7120 |
| 14 9168 9112 |
| 15 6203 8052 |
| 16 3330 2895 |
| 17 4264 10563 |
| 18 10556 6496 |
| 19 8807 7645 |
| 20 1999 4530 |
| 21 9202 6818 |
| 22 3403 1734 |
| 23 2106 9023 |
| 24 6881 3883 |
| 25 3895 2171 |
| 26 4062 6424 |
| 27 3755 9536 |
| 28 4683 2131 |
| 29 7347 8027 |

Table 5

| Address of Parity Bit Accumulators (Rate 1/2) |
|---|
| 54 9318 14392 27561 26909 10219 2534 8597 |
| 55 7263 4635 2530 28130 3033 23830 3651 |
| 56 24731 23583 26036 17299 5750 792 9169 |
| 57 5811 26154 18653 11551 15447 13685 16264 |
| 58 12610 11347 28768 2792 3174 29371 12997 |
| 59 16789 16018 21449 6165 21202 15850 3186 |
| 60 31016 21449 17618 6213 12166 8334 18212 |
| 61 22836 14213 11327 5896 718 11727 9308 |
| 62 20912494129966 23634 9013 15587 5444 |
| 63 22207 3983 16904 28534 21415 27524 25912 |
| 64 25687 4501 22193 14665 14798 16158 5491 |
| 65 4520 17094 23397 4264 22370 1694121526 |
| 66 10490 6182 32370 9597 30841 25954 2762 |
| 67 22120 22865 29870 15147 13668 14955 19235 |
| 68 6689 18408 18346 9918 25746 5443 20645 |
| 69 29982 12529 13858 4746 30370 10023 24828 |
| 70 1262 28032 29888 13063 24033 21951 7863 |
| 71 6594 29642 31451 14831 9509 9335 31552 |
| 72 1358 6454 16633 2035424598 624 5265 |
| 73 19529 295 180113080 13364 8032 15323 |
| 74 11981 1510 7960 21462 9129 11370 25741 |
| 75 9276 29656 4543 30699 20646 21921 28050 |
| 76 15975 25634 5520 31119 13715 21949 19605 |
| 77 18688 4608 31755 30165 13103 10706 29224 |
| 78 21514 23117 12245 26035 31656 25631 30699 |

(continued)

| Address of Parity Bit Accumulators (Rate 1/2) |
|---|
| 79 9674 24966 31285 29908 17042 24588 31857 |
| 80 21856 27777 29919 27000 14897 11409 7122 |
| 81 29773 23310 263 4877 28622 20545 22092 |
| 82 15605 565121864 3967 14419 22757 15896 |
| 83 30145 1759 10139 29223 26086 10556 5098 |
| 84 18815 16575 2936 24457 26738 6030 505 |
| 85 30326 22298 27562 2013126390 6247 24791 |
| 86 928 29246 21246 12400 15311 32309 18608 |
| 87 20314 6025 26689 16302 2296 3244 19613 |
| 88 6237 11943 22851 15642 23857 15112 20947 |
| 89 26403 25168 19038 18384 8882 12719 7093 |
| 0 14567 24965 |
| 1 3908 100 |
| 2 10279 240 |
| 3 24102 764 |
| 4 12383 4173 |
| 5 1386115918 |
| 6 21327 1046 |
| 7 5288 14579 |
| 8 28158 8069 |
| 9 16583 11098 |
| 10 16681 28363 |
| 11 13980 24725 |
| 12 32169 17989 |
| 13 10907 2767 |
| 14 21557 3818 |
| 15 26676 12422 |
| 16 7676 8754 |
| 17 14905 20232 |
| 18 15719 24646 |
| 19 31942 8589 |
| 20 19978 27197 |
| 21 27060 15071 |
| 22 6071 26649 |
| 23 10393 11176 |
| 24 9597 13370 |
| 25 7081 17677 |
| 26 1433 19513 |
| 27 26925 9014 |
| 28 19202 8900 |
| 29 18152 30647 |
| 30 20803 1737 |
| 31 1180425221 |
| 32 31683 17783 |
| 33 29694 9345 |
| 34 12280 26611 |
| 35 6526 26122 |
| 36 26165 11241 |
| 37 7666 26962 |
| 38 16290 8480 |

(continued)

| Address of Parity Bit Accumulators (Rate 1/2) |
|---|
| 39 11774 10120 |
| 40 3005130426 |
| 41 1335 15424 |
| 42 6865 17742 |
| 43 31779 12489 |
| 44 32120 21001 |
| 45 14508 6996 |
| 46 979 25024 |
| 47 4554 21896 |
| 48 7989 21777 |
| 49 4972 20661 |
| 50 6612 2730 |
| 51 127424418 |
| 52 29194595 |
| 53 19267 20113 |

Table 6

| Address of Parity Bit Accumulators (Rate 3/4) |
|---|
| 0 6385 7901 14611 13389 11200 3252 5243 2504 2722 8217374 |
| 1 11359 2698 357 13824 12772 7244 6752 15310 852 2001 11417 |
| 2 7862 7977 6321 13612 12197 14449 15137 13860 1708 6399 13444 |
| 3 1560 11804 6975 13292 3646 3812 8772 7306 5795 14327 7866 |
| 4 7626 11407 14599 9689 1628 2113 10809 9283 1230 152414870 |
| 5 1610 5699 15876 9446 12515 1400 6303 5411 14181 13925 7358 |
| 6 4059 8836 3405 7853 7992 15336 5970 10368 10278 9675 4651 |
| 7 44413963 9153 2109 12683 7459 1203012221629 15212 406 |
| 8 6007 8411 5771 3497 543 14202 875 9186 6235 13908 3563 |
| 9 3232 6625 4795 546 978120717312 3399 7250 4932 12652 |
| 10 8820 10088 11090 7069 6585 13134 10158 7183 488 7455 9238 |
| 11 1903 10818 119 215 7558 11046 10615 11545 14784 7961 15619 |
| 12 3655 8736 4917 15874 5129 2134 15944 14768 7150 2692 1469 |
| 13 8316 3820 505 8923 6757 806 7957 4216 15589 13244 2622 |
| 14 14463 4852 15733 3041 11193 12860 13673 8152 6551 15108 8758 |
| 15 3149 11981 |
| 16 13416 6906 |
| 17 13098 13352 |
| 18 2009 14460 |
| 19 7207 4314 |
| 20 3312 3945 |
| 21 4418 6248 |
| 22 2669 13975 |
| 23 7571 9023 |
| 24 14172 2967 |
| 25 7271 7138 |
| 26 6135 13670 |
| 27 7490 14559 |
| 28 8657 2466 |
| 29 8599 12834 |

(continued)

| Address of Parity Bit Accumulators (Rate 3/4) |
|---|
| 30 3470 3152 |
| 31 13917 4365 |
| 32 6024 13730 |
| 33 10973 14182 |
| 34 2464 13167 |
| 35 5281 15049 |
| 36 11031849 |
| 37 2058 1069 |
| 38 9654 6095 |
| 39 14311 7667 |
| 40 15617 8146 |
| 41 4588 11218 |
| 42 13660 6243 |
| 43 8578 7874 |
| 44 11741 2686 |
| 0 1022 1264 |
| 1 12604 9965 |
| 2 8217 2707 |
| 3 315611793 |
| 4 354 1514 |
| 5 6978 14058 |
| 6 7922 16079 |
| 7 15087 12138 |
| 8 5053 6470 |
| 9 12687 14932 |
| 10 15458 1763 |
| 11 8121 1721 |
| 12 12431 549 |
| 13 4129 7091 |
| 14 1426 8415 |
| 15 9783 7604 |
| 16 6295 11329 |
| 17 1409 12061 |
| 18 8065 9087 |
| 19 2918 8438 |
| 20 1293 14115 |
| 21 3922 13851 |
| 22 3851 4000 |
| 23 5865 1768 |
| 24 2655 14957 |
| 25 5565 6332 |
| 26 4303 12631 |
| 27 11653 12236 |
| 28 16025 7632 |
| 29 4655 14128 |
| 30 9584 13123 |
| 31 13987 9597 |
| 32 15409 12110 |
| 33 8754 15490 |
| 34 7416 15325 |

(continued)

| Address of Parity Bit Accumulators (Rate 3/4) |
|---|
| 35 2909 15549 |
| 36 2995 8257 |
| 37 9406 4791 |
| 38 11111 4854 |
| 39 28128521 |
| 40 8476 14717 |
| 41 7820 15360 |
| 42 1179 7939 |
| 43 2357 8678 |
| 44 7703 6216 |
| 0 3477 7067 |
| 1 3931 13845 |
| 2 7675 12899 |
| 3 1754 8187 |
| 4 77851400 |
| 5 9213 5891 |
| 6 2494 7703 |
| 7 2576 7902 |
| 8 4821 15682 |
| 9 10426 11935 |
| 10 1810 904 |
| 11 11332 9264 |
| 12 11312 3570 |
| 13 14916 2650 |
| 14 7679 7842 |
| 15 6089 13084 |
| 16 39382751 |
| 17 8509 4648 |
| 18 12204 8917 |
| 19 5749 12443 |
| 20 12613 4431 |
| 21 1344 4014 |
| 22 8488 13850 |
| 23 1730 14896 |
| 24 14942 7126 |
| 25 14983 8863 |
| 26 6578 8564 |
| 27 4947 396 |
| 28 297 12805 |
| 29 13878 6692 |
| 30 11857 11186 |
| 31 14395 11493 |
| 32 16145 12251 |
| 33 13462 7428 |
| 34 14526 13119 |
| 35 2535 11243 |
| 36 6465 12690 |
| 37 6872 9334 |
| 38 15371 14023 |
| 39 8101 10187 |

(continued)

| Address of Parity Bit Accumulators (Rate 3/4) |
|---|
| 40 11963 4848 |
| 41 15125 6119 |
| 42 8051 14465 |
| 43 11139 5167 |
| 44 2883 14521 |

Table 7

| Address of Parity Bit Accumulators (Rate 4/5) |
|---|
| 0 149 11212 5575 6360 12559 8108 8505 408 10026 12828 |
| 1 5237 490 10677 4998 3869 3734 3092 3509 7703 10305 |
| 2 8742 5553 2820 7085 12116 10485 564 7795 2972 2157 |
| 3 2699 4304 8350 712 2841 3250 4731 10105 517 7516 |
| 4 12067 1351 11992 12191 11267 5161537 6166 4246 2363 |
| 5 6828 7107 2127 3724 5743 11040 10756 4073 1011 3422 |
| 6 11259 1216 9526 1466 10816 940 3744 2815 11506 11573 |
| 7 4549 11507 1118 1274 11751 5207 7854 12803 4047 6484 |
| 8 8430 4115 9440 413 4455 2262 7915 12402 8579 7052 |
| 9 3885 9126 5665 4505 2343 253 4707 3742 4166 1556 |
| 10 1704 8936 6775 8639 8179 7954 8234 7850 8883 8713 |
| 11 11716 4344 9087 11264 2274 8832 9147 11930 6054 5455 |
| 12 7323 3970 10329 2170 8262 3854 2087 12899 9497 11700 |
| 13 4418 1467 2490 5841 817 11453 533 11217 11962 5251 |
| 14 1541 4525 7976 3457 9536 7725 3788 2982 6307 5997 |
| 15 11484 2739 4023 12107 6516 5512572 6628 8150 9852 |
| 16 6070 17614627 6534 7913 3730 11866 1813 12306 8249 |
| 17 12441 5489 8748 7837 7660 2102 11341 2936 6712 11977 |
| 18 10155 4210 |
| 19 1010 10483 |
| 20 8900 10250 |
| 21 10243 12278 |
| 22 7070 4397 |
| 23 12271 3887 |
| 24 11980 6836 |
| 25 9514 4356 |
| 26 7137 10281 |
| 27 11881 2526 |
| 28 1969 11477 |
| 29 3044 10921 |
| 30 2236 8724 |
| 31 9104 6340 |
| 32 7342 8582 |
| 33 11675 10405 |
| 34 6467 12775 |
| 35 3186 12198 |
| 0 9621 11445 |
| 1 7486 5611 |
| 2 4319 4879 |
| 3 2196 344 |

(continued)

| Address of Parity Bit Accumulators (Rate 4/5) |
|---|
| 4 7527 6650 |
| 5 10693 2440 |
| 6 6755 2706 |
| 7 5144 5998 |
| 8 11043 8033 |
| 9 4846 4435 |
| 10 4157 9228 |
| 11 12270 6562 |
| 12 11954 7592 |
| 13 7420 2592 |
| 14 8810 9636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |
| 28 12157 7405 |
| 29 6598 11495 |
| 30 11805 4455 |
| 31 9625 2090 |
| 32 4731 2321 |
| 33 3578 2608 |
| 34 8504 1849 |
| 35 4027 1151 |
| 0 5647 4935 |
| 1 4219 1870 |
| 2 10968 8054 |
| 3 6970 5447 |
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |
| 14 7200 3283 |
| 15 1502 11282 |
| 16 12318 2202 |
| 17 4523 965 |

(continued)

| Address of Parity Bit Accumulators (Rate 4/5) |
|---|
| 18 9587 7011 |
| 19 2552 2051 |
| 20 12045 10306 |
| 21 11070 5104 |
| 22 6627 6906 |
| 23 9889 2121 |
| 24 829 9701 |
| 25 2201 1819 |
| 26 6689 12925 |
| 27 2139 8757 |
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |
| 6 786 3021 |
| 7 710 2086 |
| 8 7423 5601 |
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |
| 18 6838 9011 |
| 19 6174 9410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |
| 28 12323 9511 |
| 29 8231 1752 |
| 30 497 9022 |
| 31 9288 3080 |

(continued)

| Address of Parity Bit Accumulators (Rate 4/5) |
|---|
| 32 24817515 |
| 33 2696 268 |
| 34 4023 12341 |
| 35 7108 5553 |

Table 8

| Address of Parity Bit Accumulators (Rate 3/5) |
|---|
| 22422 10282 11626 19997 11161 2922 3122 99 5625 17064 8270 179 |
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 14487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 1972125420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 2421017833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |
| 4127 2971 17499 16287 22368 21463 7943 18880 5567 8047 23363 6797 |
| 10651 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 1031125767 17057 3691 |
| 20473 11294 9914 22815 2574 8439 3699 543124840 21908 16088 18244 |
| 8208 5755 19059 854124924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |
| 1 10502 3002 |
| 2 9368 10761 |
| 3 12299 7828 |
| 4 15048 13362 |

(continued)

| Address of Parity Bit Accumulators (Rate 3/5) |
|---|
| 5 18444 24640 |
| 6 20775 19175 |
| 7 18970 10971 |
| 8 5329 19982 |
| 9 11296 18655 |
| 10 15046 20659 |
| 11 7300 22 140 |
| 12 22029 14477 |
| 13 11129 742 |
| 14 13254 13813 |
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 1607121617 |
| 25 6393 3725 |
| 26 597 19968 |
| 27 5743 8084 |
| 28 6770 9548 |
| 29 4285 17542 |
| 30 13568 22599 |
| 31 1786 4617 |
| 32 23238 11648 |
| 33 19627 2030 |
| 34 13601 13458 |
| 35 13740 17328 |
| 36 25012 13944 |
| 37 22513 6687 |
| 38 4934 12587 |
| 39 21197 5133 |
| 40 22705 6938 |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |
| 51 24964 24690 |
| 52 14443 8816 |
| 53 6926 1291 |
| 54 6209 20806 |

(continued)

| Address of Parity Bit Accumulators (Rate 3/5) |
|---|
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |
| 63 12402 3702 |
| 64 8314 1357 |
| 65 20071 14616 |
| 66 17014 3688 |
| 67 19837 946 |
| 68 15195 12136 |
| 69 7758 22808 |
| 70 3564 2925 |
| 71 3434 7769 |

Table 9

| Address of Parity Bit Accumulators (Rate 8/9) |
|---|
| 0 6235 2848 3222 |
| 1 5800 3492 5348 |
| 2 2757 927 90 |
| 3 6961 4516 4739 |
| 4 1172 3237 6264 |
| 5 1927 2425 3683 |
| 6 3714 6309 2495 |
| 7 3070 6342 7154 |
| 8 2428 613 3761 |
| 9 2906 264 5927 |
| 10 1716 1950 4273 |
| 11 4613 6179 3491 |
| 12 4865 3286 6005 |
| 13 1343 5923 3529 |
| 14 4589 4035 2132 |
| 15 1579 3920 6737 |
| 16 1644 1191 5998 |
| 17 1482 23814620 |
| 18 6791 6014 6596 |
| 19 2738 5918 3786 |
| 0 5156 6166 |
| 1 1504 4356 |
| 2 130 1904 |
| 3 6027 3187 |
| 4 6718 759 |
| 5 6240 2870 |
| 6 2343 1311 |
| 7 1039 5465 |

(continued)

| Address of Parity Bit Accumulators (Rate 8/9) |
|---|
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |
| 16 3215 4163 |
| 17 973 3117 |
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |
| 12 6528 2899 |
| 13 2243 3616 |
| 14 867 3733 |
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |
| 14 953 4964 |
| 15 4555 4410 |
| 16 4925 4842 |
| 17 5778 600 |

| Address of Parity Bit Accumulators (Rate 8/9) |
|---|
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |
| 6 1481 6847 |
| 7 4433 1932 |
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 20626599 |
| 2 4597 4870 |
| 3 1228 6913 |
| 4 4159 1037 |
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |
| 4 3694 657 |
| 5 1355 110 |
| 6 3329 6736 |
| 7 2505 3407 |

(continued)

| Address of Parity Bit Accumulators (Rate 8/9) |
|---|
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |
| 16 4320 6121 |
| 17 3961 1125 |
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |
| 12 4695 1600 |
| 13 680 2074 |
| 14 1801 6690 |
| 15 2669 1377 |
| 16 2463 1681 |
| 17 5972 5171 |
| 18 5728 4284 |
| 19 1696 1459 |

Table 10

| Address of Parity Bit Accumulators (Rate 9/10) |
|---|
| 0 5611 2563 2900 |
| 1 5220 3143 4813 |
| 2 2481 834 81 |
| 3 6265 4064 4265 |
| 4 1055 2914 5638 |
| 5 1734 2182 3315 |
| 6 3342 5678 2246 |
| 7 2185 552 3385 |
| 8 2615 236 5334 |
| 9 1546 1755 3846 |
| 10 4154 5561 3142 |
| 11 4382 2957 5400 |
| 12 1209 5329 3179 |

(continued)

| Address of Parity Bit Accumulators (Rate 9/10) |
|---|
| 13 1421 3528 6063 |
| 14 1480 1072 5398 |
| 15 3843 1777 4369 |
| 16 1334 2145 4163 |
| 17 2368 5055 260 |
| 0 6118 5405 |
| 1 2994 4370 |
| 2 3405 1669 |
| 3 4640 5550 |
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |
| 0 4165 884 |
| 1 2896 3744 |
| 2 874 2801 |
| 3 3423 5579 |
| 4 3404 3552 |
| 5 2876 5515 |
| 6 516 1719 |
| 7 765 3631 |
| 8 5059 1441 |
| 9 5629 598 |
| 10 5405 473 |
| 11 4724 5210 |
| 12 155 1832 |
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |
| 4 4286 3517 |
| 5 5531 3184 |
| 6 1935 4560 |
| 7 1174 131 |
| 8 3115 956 |

(continued)

| Address of Parity Bit Accumulators (Rate 9/10) |
|---|
| 9 3129 1088 |
| 10 5238 4440 |
| 11 5722 4280 |
| 12 3540 375 |
| 13 191 2782 |
| 14 906 4432 |
| 15 3225 1111 |
| 16 6296 2583 |
| 17 1457 903 |
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |
| 14 1907 1854 |
| 15 3601 5748 |
| 16 6056 3266 |
| 17 3322 4085 |
| 0 1768 3244 |
| 1 2149 144 |
| 2 1589 4291 |
| 3 5154 1252 |
| 4 1855 5939 |
| 5 4820 2706 |
| 6 1475 3360 |
| 7 4266 693 |
| 8 4156 2018 |
| 9 2103 752 |
| 10 3710 3853 |
| 11 5123 931 |
| 12 6146 3323 |
| 13 1939 5002 |
| 14 5140 1437 |
| 15 1263 293 |
| 16 5949 4665 |
| 17 4548 6380 |
| 0 3171 4690 |
| 1 5204 2114 |
| 2 6384 5565 |
| 3 5722 1757 |
| 4 2805 6264 |

(continued)

| Address of Parity Bit Accumulators (Rate 9/10) |
|---|
| 5 1202 2616 |
| 6 1018 3244 |
| 7 4018 5289 |
| 8 2257 3067 |
| 9 2483 3073 |
| 10 1196 5329 |
| 11 649 3918 |
| 12 3791 4581 |
| 13 5028 3803 |
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |
| 10 5161 2293 |
| 11 4682 3845 |
| 12 3045 643 |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |
| 14 1542 5401 |
| 15 5078 2687 |
| 16 316 1755 |
| 17 3392 1991 |

As regards the BCH encoder 211, the BCH code parameters are enumerated in Table 11.

Table 11

| LDPC Code Rate | BCH Uncoded Block Length $k_{bch}$ | BCH Coded Block Length $n_{bch}$ | BCH Error Correction (bits) |
|---|---|---|---|
| 1/2 | 32208 | 32400 | 12 |
| 2/3 | 43040 | 43200 | 10 |
| 3/4 | 48408 | 48600 | 12 |
| 4/5 | 51648 | 51840 | 12 |
| 5/6 | 53840 | 54000 | 10 |
| 3/5 | 38688 | 38880 | 12 |
| 8/9 | 57472 | 57600 | 8 |
| 9/10 | 58192 | 58320 | 8 |

It is noted that in the above table, $n_{bch} = k_{ldpc}$ .

The generator polynomial of the $t$ error correcting BCH encoder 211 is obtained by multiplying the first $t$ polynomials in the following list of Table 12:

Table 12

| $g1(x)$ | $1+x^2+x^3+x^5+x^{16}$ |
|---|---|
| $g_2(x)$ | $1+x+x^4+x^5+x^6+x^8+x^{16}$ |
| $g_3(x)$ | $1+x^2+x^3+x^4+x^5+x^7+x^8+x^9+x^{10}+x^{11}+x^{16}$ |
| $g_4(x)$ | $1+x^2+x^4+x^6+x^9+x^{11}+x^{12}+x^{14}+x^{16}$ |
| $g_5(x)$ | $1+x+x^2+x^3+x^5+x^8+x^9+x^{10}+x^{11}+x^{12}+x^{16}$ |
| $g_6(x)$ | $1+x^2+x^4+x^5+x^7+x^8+x^9+x^{10}+x^{12}+x^{13}+x^{14}+x^{15}+x^{16}$ |
| $g_7(x)$ | $1+x^2+x^5+x^6+x^8+x^9+x^{10}+x^{11}+x^{13}+x^{15}+x^{16}$ |
| $g_8(x)$ | $1+x+x^2+x^5+x^6+x^9+x^{12}+x^{13}+x^{13}+x^{14}+x^{16}$ |
| $g_9(x)$ | $1+x^5+x^7+x^9+x^{10}+x^{11}+x^{16}$ |
| $g_{10}(x)$ | $1+x+x^2+x^5+x^7+x^8+x^{10}+x^{12}+x^{13}+x^{14}+x^{16}$ |
| $g_{11}(x)$ | $1+x^2+x^3+x^5+x^9+x^{11}+x^{12}+x^{13}+x^{16}$ |
| $g_{12}(x)$ | $1+x+x^5+x^6+x^7+x^9+x^{11}+x^{12}+x^{16}$ |

BCH encoding of information bits $m = (m_{kbch-1}, m_{kbch-2} ,...,m_1,m_0)$ onto a codeword $c = (m_{kbch-1},m_{kbch-2},...,m_1, m_0,d_{n}bch-k_{bch-1}, d_{nbch-kbch-2},...,d_1,d_0)$ is achieved as follows. The message polynomial $m(x) = m_{kbch-1}x^{kbch-1} + m_{kbch-2}x^{kbch-2} +...+ m_1x + m_0$ is multiplied by $x^{nbch-kbch}$. Next, $x^{nbch-kbch} m(x)$ divided by $g(x)$. With $d(x) = d_{nbch-kbch-1}x^{nbch-kbch-1} +...+ d_1x+d_0$ as the remainder, the codeword polynomial is set as follows: $c(x) = x^{nbch-kbch} m(x) + d(x)$.

The above LDPC codes, in an exemplary embodiment, can be used to variety of digital video applications, such as MPEG (Motion Pictures Expert Group) packet transmission.

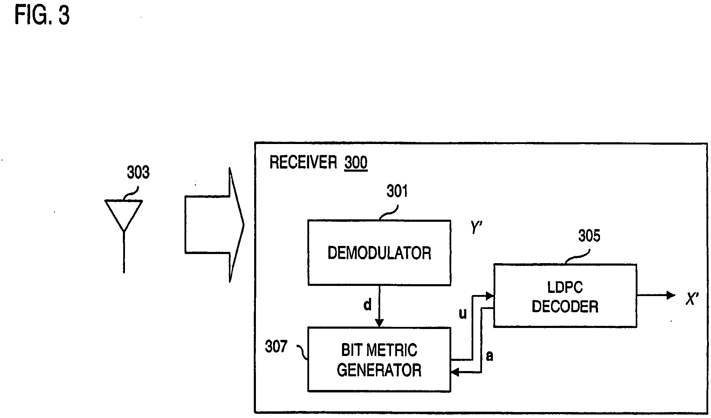

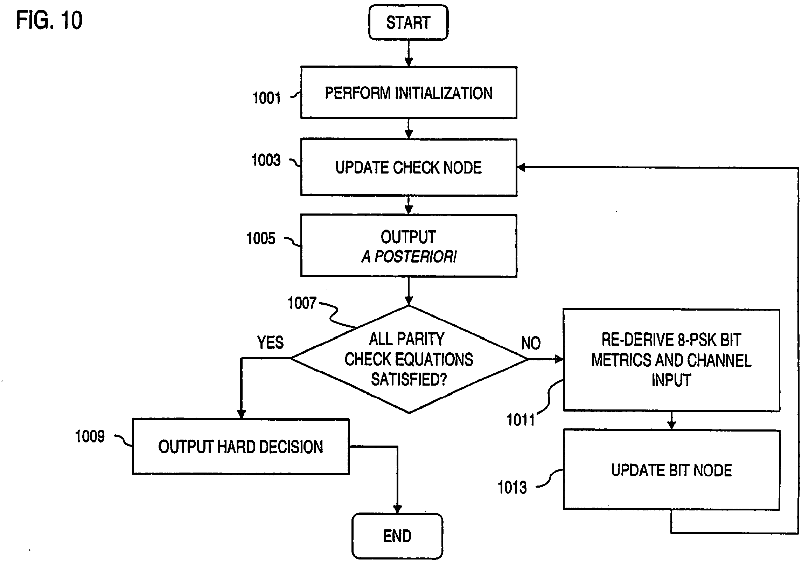

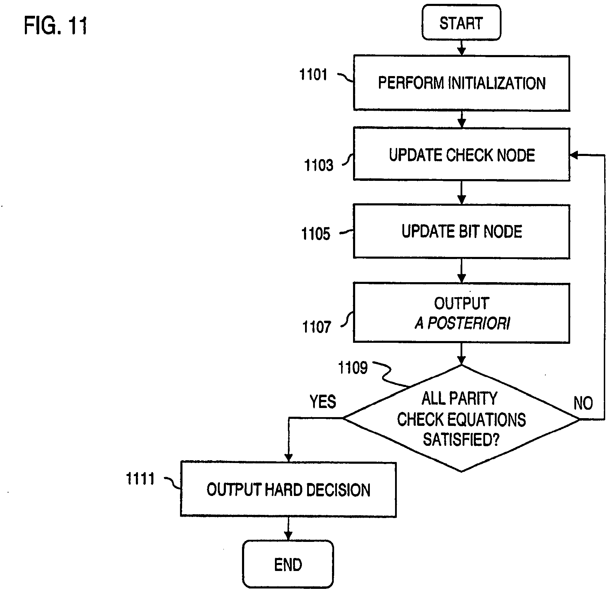

FIG. 3 is a diagram of an exemplary receiver in the system of FIG. 1. At the receiving side, a receiver 300 includes a demodulator 301 that performs demodulation of received signals from transmitter 200. These signals are received at a receive antenna 303 for demodulation. After demodulation, the received signals are forwarded to a decoder 305, which attempts to reconstruct the original source messages by generating messages, $X'$, in conjunction with a bit metric generator 307. With non-Gray mapping, the bit metric generator 307 exchanges probability information with the decoder 305 back and forth (iteratively) during the decoding process, which is detailed in FIG. 10. Alternatively, if Gray mapping is used, one pass of the bit metric generator is sufficient, in which further attempts of bit metric generation after each LDPC decoder iteration are likely to yield limited performance improvement; this approach is more fully described with respect to FIG. 11. To appreciate the advantages offered by the present invention, it is instructive to examine how LDPC codes are generated, as discussed in FIG. 4.

FIG. 4 is a diagram of a sparse parity check matrix. LDPC codes are long, linear block codes with sparse parity check matrix $H_{(n-k)m}$. Typically the block length, $n$, ranges from thousands to tens of thousands of bits. For example, a parity check matrix for an LDPC code of length $n=8$ and rate ½ is shown in FIG. 4. The same code can be equivalently represented by the bipartite graph, per FIG. 5.

FIG. 5 is a diagram of a bipartite graph of an LDPC code of the matrix of FIG. 4. Parity check equations imply that for each check node, the sum (over GF (Galois Field)(2)) of all adjacent bit nodes is equal to zero. As seen in the figure, bit nodes occupy the left side of the graph and are associated with one or more check nodes, according to a predetermined relationship. For example, corresponding to check node $m_1$, the following expression exists $n_1 + n_4 + n_5 + n_8 = 0$ with respect to the bit nodes.

Returning the receiver 303, the LDPC decoder 305 is considered a message passing decoder, whereby the decoder 305 aims to find the values of bit nodes. To accomplish this task, bit nodes and check nodes iteratively communicate with each other. The nature of this communication is described below.

From check nodes to bit nodes, each check node provides to an adjacent bit node an estimate ("opinion") regarding the value of that bit node based on the information coming from other adjacent bit nodes. For instance, in the above example if the sum of $n_4$, $n_5$ and $n_8$ "looks like" 0 to $m_1$, then $m_1$ would indicate to $n_1$ that the value of $n_1$ is believed to be 0 (since $n_1 + n_4 + n_5 + n_8 = 0$ ); otherwise $m_1$ indicate to $n_1$ that the value of $n_1$ is believed to be 1. Additionally, for soft decision decoding, a reliability measure is added.

From bit nodes to check nodes, each bit node relays to an adjacent check node an estimate about its own value based on the feedback coming from its other adjacent check nodes. In the above example $n_1$ has only two adjacent check nodes $m_1$ and $m_3$. If the feedback coming from $m_3$ to $n_1$ indicates that the value of $n_1$ is probably 0, then $n_1$ would notify $m_1$ that an estimate of $n_1$ 's own value is 0. For the case in which the bit node has more than two adjacent check nodes, the bit node performs a majority vote (soft decision) on the feedback coming from its other adjacent check nodes before reporting that decision to the check node it communicates. The above process is repeated until all bit nodes are considered to be correct (i.e., all parity check equations are satisfied) or until a predetermined maximum number of iterations is reached, whereby a decoding failure is declared.

FIG. 6 is a diagram of a sub-matrix of a sparse parity check matrix, wherein the sub-matrix contains parity check values restricted to the lower triangular region, according to an embodiment of the present invention. As described previously, the encoder 203 (of FIG. 2) can employ a simple encoding technique by restricting the values of the lower triangular area of the parity check matrix. According to an embodiment of the present invention, the restriction imposed on the parity check matrix is of the form:

$$H_{(n-k)m} = [A_{(n-k)xk} \ B_{(n-k)x(n-k)}]$$

, where $B$ is lower triangular.

Any information block i = $(i_0, i_1, ..., i_{k-1})$ is encoded to a codeword $c = (i_0, i_1, ..., i_{k-1}, p_0, p_1, ... p_{n-k-1})$ using $Hc^T = 0$, and recursively solving for parity bits; for example,

$$a_{00}i_0 + a_{01}i_1 + ... + a_{0,k-1}i_{k-1} + p_0 = 0 \Rightarrow Solve \ p_0 \qquad ,$$

$$a_{10}i_0 + a_{11}i_1 + ... + a_{1,k-1}i_{k-1} + b_{10}p_0 + p_1 = 0 \Rightarrow Solve \ p_1$$

and similarly for $p_2, p_3, ..., p_{n-k-1}$.

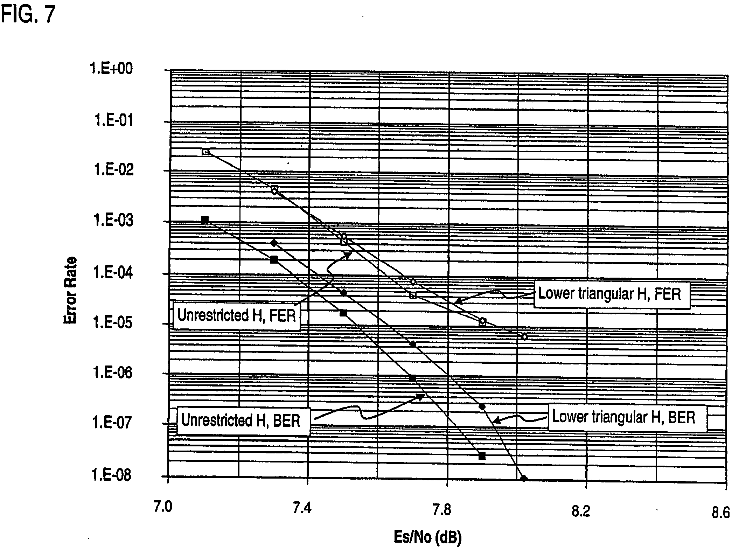

FIG. 7 is a graph showing performance between codes utilizing unrestricted parity check matrix (H matrix) versus restricted H matrix of FIG. 6. The graph shows the performance comparison between two LDPC codes: one with a general parity check matrix and the other with a parity check matrix restricted to be lower triangular to simplify encoding. The modulation scheme, for this simulation, is 8-PSK. The performance loss is within 0.1 dB. Therefore, the performance loss is negligible based on the restriction of the lower triangular H matrices, while the gain in simplicity of the encoding technique is significant. Accordingly, any parity check matrix that is equivalent to a lower triangular or upper triangular under row and/or column permutation can be utilized for the same purpose.

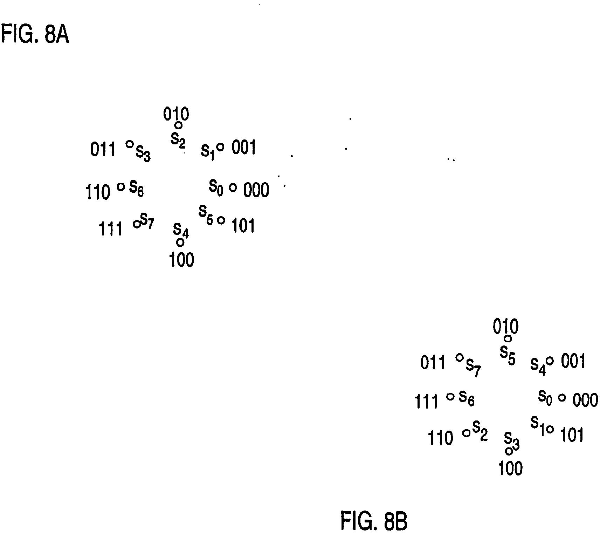

FIGs. 8A and 8B are, respectively, a diagram of a non-Gray 8-PSK modulation scheme, and a Gray 8-PSK modulation, each of which can be used in the system of FIG. 1. The non-Gray 8-PSK scheme of FIG. 8A can be utilized in the receiver of FIG. 3 to provide a system that requires very low Frame Erasure Rate (FER). This requirement can also be satisfied by using a Gray 8-PSK scheme, as shown in FIG. 8B, in conjunction with an outer code, such as Bose, Chaudhuri, and Hocquenghem (BCH), Hamming, or Reed-Solomon (RS) code.

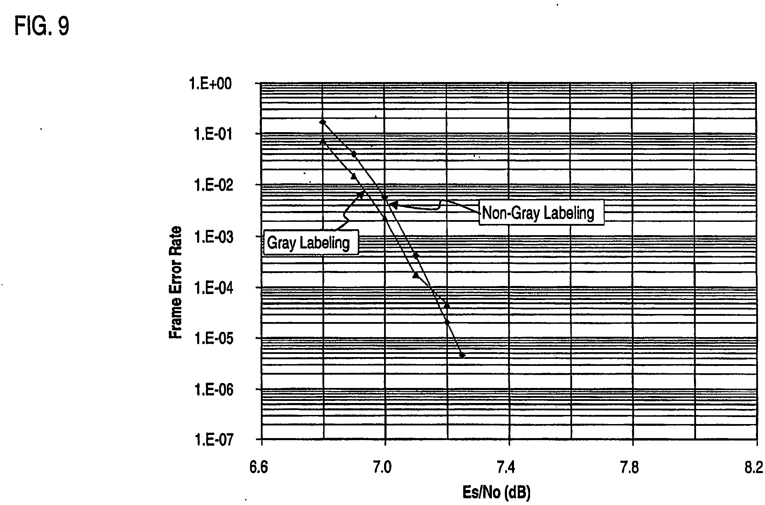

Under this scheme, there is no need to iterate between the LDPC decoder 305 (FIG. 3) and the bit metric generator 307, which may employ 8-PSK modulation. In the absence of an outer code, the LDPC decoder 305 using Gray labeling exhibit an earlier error floor, as shown in FIG. 9 below.

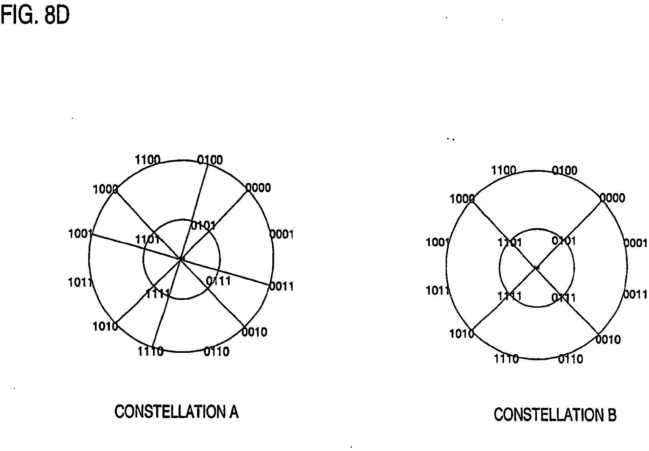

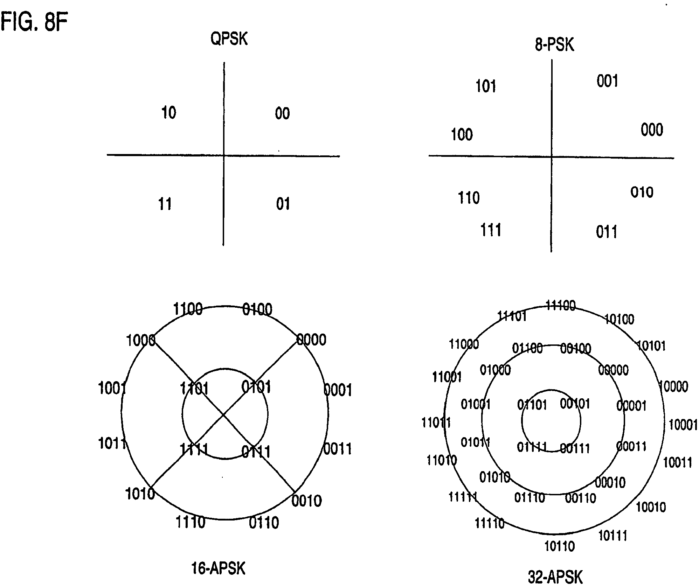

FIG. 8C shows a diagram of a process for bit labeling for a higher order signal constellation. A codeword is output from the LDPC encoder 203 (FIGs. 2A and 2B), and is mapped to a constellation point in a higher order signal constellation (as shown in FIGs. 8D and 8F), per steps 801, 803. This mapping is not performed sequentially as in traditional systems, but instead executed on a non-sequential basis, such as interleaving. Such a mapping is further detailed below with respect to FIG. 8F. The modulator 205 then modulates, as in step 805, the signal based on the mapping. The modulated signal is thereafter transmitted (step 807).

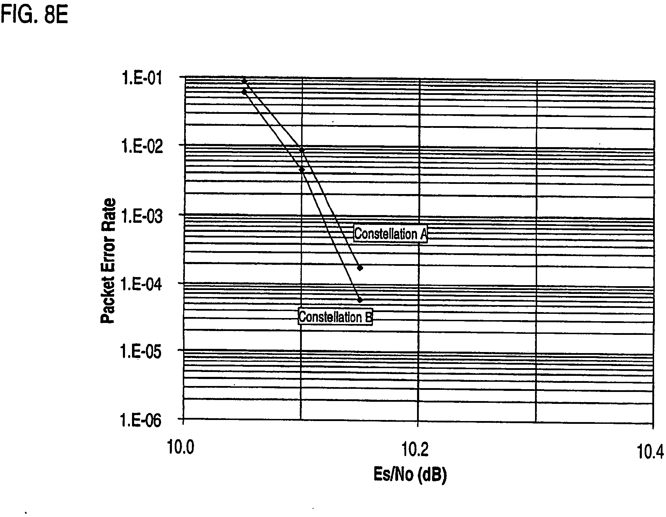

FIG. 8D shows a diagram of exemplary 16-APSK (Amplitude Phase Shift Keying) constellations. Constellations A and B are 16-APSK constellations. The only difference between the two constellations A and B is that the inner circle symbols of Constellation A are rotated 15 degrees counterclockwise with respect to the inner circle symbols of Constellation B, such that inner circle symbols fall between the outer circle symbols to maximize inter-symbol distances. Therefore, intuitively Constellation A is more attractive if the Forward Error Correction (FEC) decoder 305 used a symbolwise decoding algorithm. On the other hand, given the multiplicity of code rates and different constellations, using an FEC code tailored towards bitwise decoding is more flexible. In such a case, it is not apparent which constellations would perform better, in that while Constellation A maximizes symbolwise distances, Constellation B is more "Gray-coding friendly." AWGN (Additive White Gaussian Noise) simulations, with code rate 3/4, were performed (the results of which are shown in FIG. 8E) that with bitwise decoding, Constellation B performs slightly better.

FIG. 8F is a diagram of constellations for Quadrature Phase Shift Keying (QPSK), 8-PSK, 16-APSK and 32-APSK symbols;

FIGs. 8F show symmetric constellations for QPSK, 8-PSK, 16-APSK and 32-APSK symbols, respectively. With QSPK, two LDPC coded bits from the LDPC encoder 203 are mapped to a QPSK symbol. That is, bits $2i$ and $2i+1$ determines the $i^{th}$ QPSK symbol, where $i=0,1,2...$, $N/2-1$, and $N$ is the coded LDPC block size. For 8-PSK, bits $N/3+i$, $2N/3+i$ and $i$ determine the $i^{th}$ 8-PSK symbol, where $i=0,1,2,...,N/3-1$. For 16-APSK, bits $N/2+2i$, $2i$, $N/2+2i+1$ and $2i+1$ specify the $i^{th}$ 16-APSK symbol, where $i=0,1,2,...,N/4-1$. Further, for 32-APSK, bits $N/5+i$, $2N/5+i$, $4N/5+i$, $3N/5+i$ and $i$ determine the $i^{th}$ symbol, where $i=0,1,2,...,N/5-1$.

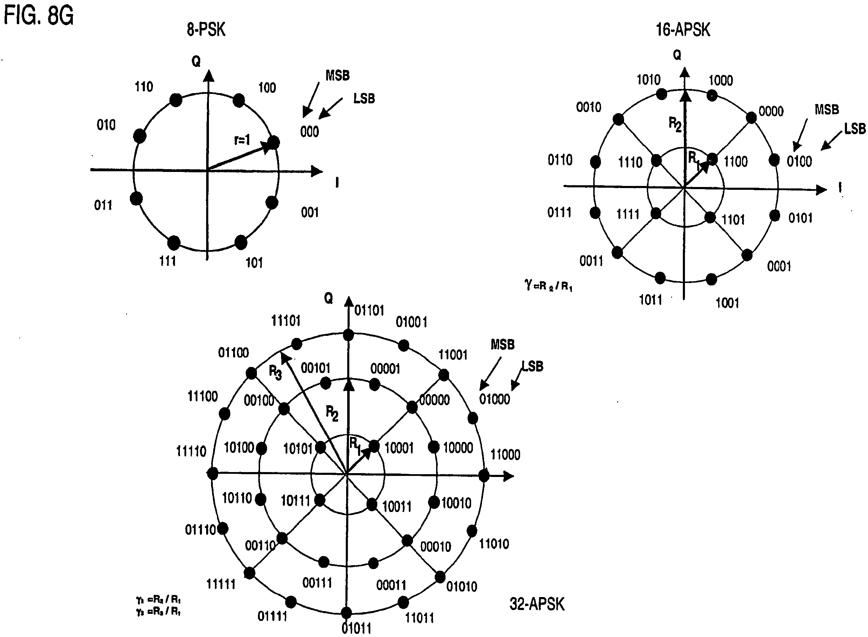

Alternatively, 8-PSK, 16-APSK and 32-APSK constellation labeling can be chosen as shown in FIG. 8G. With this labeling, $N$ LDPC encoded bits are first passed through a bit interleaver. The bit interleaving table, in an exemplary embodiment, is a two-dimensional array with $N/3$ rows and 3 columns for 8-PSK, $N/4$ rows and 4 columns for 16-APSK and $N/5$ rows and 5 columns for 32-APSK. The LDPC encoded bits are written to the interleaver table column by column, and read out row by row. It is noted that for the case of 8-PSK and 32-APSK, this row/column bit interleaver strategy with labeling as shown in FIG. 8G, is exactly equivalent to the bit interleaving strategy described above with respect to the labeling shown in FIG. 8F. For the case of 16-APSK, these two strategies are functionally equivalent; that is, they exhibit the same performance on an AWGN channel.

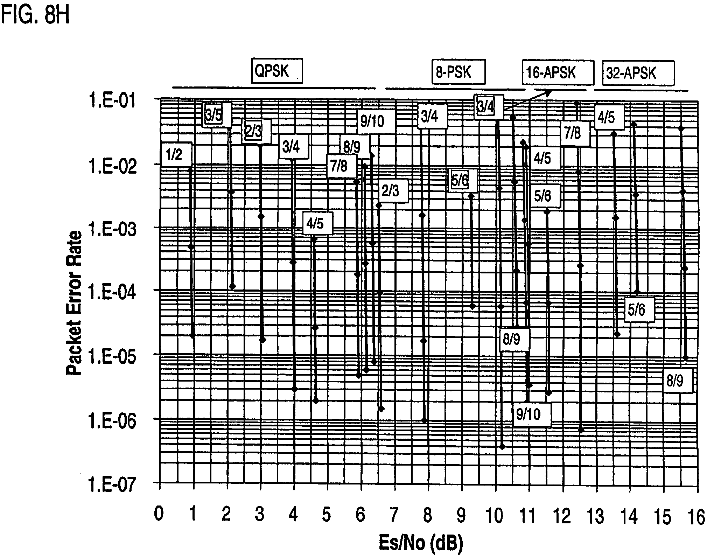

FIG. 8H illustrates the simulation results (on AWGN Channel) of the above symbol constellations. Table 13 summarizes expected performance at PER=$10^{-6}$ and distance from constrained capacity.

Table 13

| Code | Es/No (dB) | Distance to Capacity (dB) |
|---|---|---|
| 2/3, 8-PSK | 6.59 | 0.873 |
| 3/4, 8-PSK | 7.88 | 0.690 |
| 5/6, 8-PSK | 9.34 | 0.659 |
| 8/9, 8-PSK | 10.65 | 0.750 |
| 9/10, 8-PSK | 10.95 | 0.750 |
| 1/2, QPSK | 0.99 | 0.846 |
| 3/5, QPSK | 2.20 | 0.750 |
| 2/3, QPSK | 3.07 | 0.760 |
| 3/4, QPSK | 4.02 | 0.677 |
| 4/5, QPSK | 4.66 | 0.627 |

(continued)

| Code | Es/No (dB) | Distance to Capacity (dB) |
|---|---|---|
| 5/6, QPSK | 5.15 | 0.600 |
| 7/8, QPSK | 5.93 | 0.698 |
| 8/9, QPSK | 6.17 | 0.681 |
| 9/10, QPSK | 6.39 | 0.687 |
| 3/4, 16-APSK | 10.19 | 0.890 |
| 4/5, 16-APSK | 11.0 | 0.850 |
| 5/6, 16-APSK | 11.58 | 0.800 |
| 7/8, 16-APSK | 12.54 | 0.890 |
| 4/5, 32-APSK | 13.63 | 1.100 |
| 5/6, 32-APSK | 14.25 | 1.050 |
| 8/9, 32-APSK | 15.65 | 1.150 |

FIG. 9 is a graph showing performance between codes utilizing Gray labeling versus non-Gray labeling of FIGs. 8A and 8B. The error floor stems from the fact that assuming correct feedback from LDPC decoder 305, regeneration of 8-PSK bit metrics is more accurate with non-Gray labeling since the two 8-PSK symbols with known two bits are further apart with non-Gray labeling. This can be equivalently seen as operating at higher Signal-to-Noise Ratio (SNR). Therefore, even though error asymptotes of the same LDPC code using Gray or non-Gray labeling have the same slope (i.e., parallel to each other), the one with non-Gray labeling passes through lower FER at any SNR.

On the other hand, for systems that do not require very low FER, Gray labeling without any iteration between LDPC decoder 305 and 8-PSK bit metric generator 307 may be more suitable because re-generating 8-PSK bit metrics before every LDPC decoder iteration causes additional complexity. Moreover, when Gray labeling is used, re-generating 8-PSK bit metrics before every LDPC decoder iteration yields only very slight performance improvement. As mentioned previously, Gray labeling without iteration may be used for systems that require very low FER, provided an outer code is implemented.

The choice between Gray labeling and non-Gray labeling depends also on the characteristics of the LDPC code. Typically, the higher bit or check node degrees, the better it is for Gray labeling, because for higher node degrees, the initial feedback from LDPC decoder 305 to 8-PSK (or similar higher order modulation) bit metric generator 307 deteriorates more with non-Gray labeling.

When 8-PSK (or similar higher order) modulation is utilized with a binary decoder, it is recognized that the three (or more) bits of a symbol are not received "equally noisy". For example with Gray 8-PSK labeling, the third bit of a symbol is considered more noisy to the decoder than the other two bits. Therefore, the LDPC code design does not assign a small number of edges to those bit nodes represented by "more noisy" third bits of 8-PSK symbol so that those bits are not penalized twice.

FIG. 10 is a flow chart of the operation of the LDPC decoder using non-Gray mapping. Under this approach, the LDPC decoder and bit metric generator iterate one after the other. In this example, 8-PSK modulation is utilized; however, the same principles apply to other higher modulation schemes as well. Under this scenario, it is assumed that the demodulator 301 outputs a distance vector, d, denoting the distances between received noisy symbol points and 8-PSK symbol points to the bit metric generator 307, whereby the vector components are as follows:

$$d_i = -\frac{E_s}{N_0}\{(r_x - s_{i,x})^2 + (r_y - s_{i,y})^2\} \quad i = 0,1,...7.$$

The 8-PSK bit metric generator 307 communicates with the LDPC decoder 305 to exchange *a priori* probability information and *a posteriori* probability information, which respectively are represented as **u,** and **a.** That is, the vectors **u** and **a** respectively represent *a priori* and *a posteriori* probabilities of log likelihood ratios of coded bits.

The 8-PSK bit metric generator 307 generates the *a priori* likelihood ratios for each group of three bits as follows. First, extrinsic information on coded bits is obtained:

$$e_j = a_j - u_j \qquad j = 0,1,2 \,.$$

Next, 8-PSK symbol probabilities, $p_i$ i = 0,1,...,7, are determined.

$$* \, y_j = -f(0, e_j) \qquad j = 0,1,2 \text{ where } f(a,b) = \max(a,b) + LUT_f(a,b)$$

with

$$LUT_f(a,b) = \ln(1 + e^{-|a-b|})$$

$$* \, x_j = y_j + e_j \qquad\qquad j = 0,1,2$$

$$* \, p_0 = x_0 + x_1 + x_2 \qquad p_4 = y_0 + x_1 + x_2$$

$$p_1 = x_0 + x_1 + y_2 \qquad p_5 = y_0 + x_1 + y_2$$

$$p_2 = x_0 + y_1 + x_2 \qquad p_6 = y_0 + y_1 + x_2$$

$$p_3 = x_0 + y_1 + y_2 \qquad p_7 = y_0 + y_1 + y_2$$

Next, the bit metric generator 307 determines *a priori* log likelihood ratios of the coded bits as input to LDPC decoder 305, as follows:

$$u_0 = f(d_0 + p_0, d_1 + p_1, d_2 + p_2, d_3 + p_3) - f(d_4 + p_4, d_5 + p_5, d_6 + p_6, d_7 + p_7) - e_0$$

$$u_1 = f(d_0 + p_0, d_1 + p_1, d_4 + p_4, d_5 + p_5) - f(d_2 + p_2, d_3 + p_3, d_6 + p_6, d_7 + p_7) - e_1$$

$$u_2 = f(d_0 + p_0, d_2 + p_2, d_4 + p_4, d_6 + p_6) - f(d_1 + p_1, d_3 + p_3, d_5 + p_5, d_7 + p_7) - e_2$$

It is noted that the function $f(.)$ with more than two variables can be evaluated recursively; e.g. *f (a, b, c) = f (f (a, b), c)*.

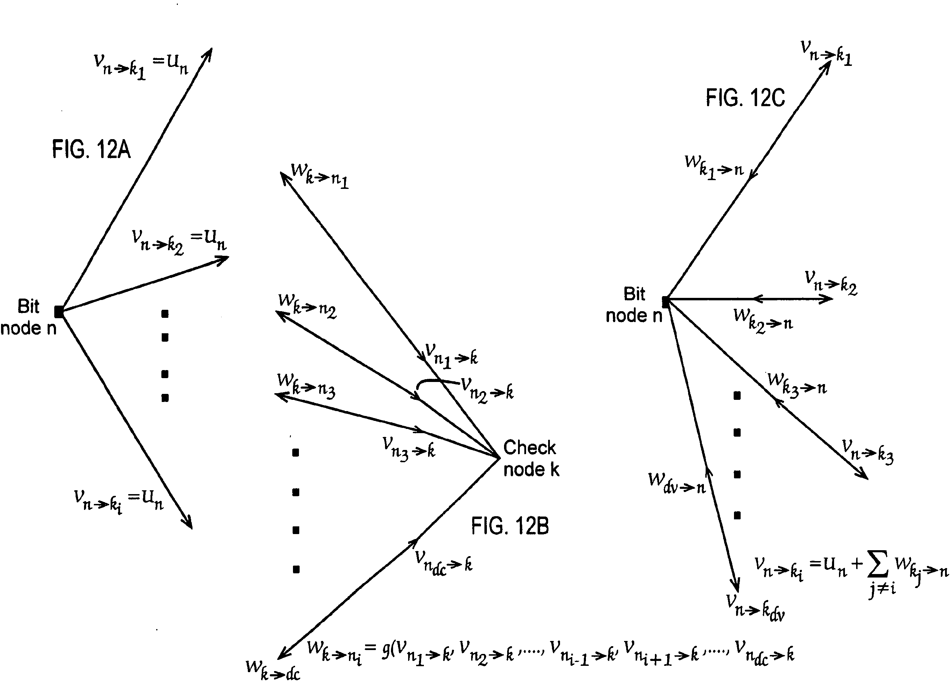

The operation of the LDPC decoder 305 utilizing non-Gray mapping is now described. In step 1001, the LDPC decoder 305 initializes log likelihood ratios of coded bits, *v*, before the first iteration according to the following (and as shown in FIG. 12A):

$$v_{n \to k_i} = u_n, \qquad n = 0,1,...,N-1, \quad i = 1,2,...,\deg(\textit{bit node } n)$$

Here, $v_{n \to k1}$ denotes the message that goes from bit node *n* to its adjacent check node $k_i$, $u_n$ denotes the demodulator output for the bit *n* and *N* is the codeword size.

In step 1003, a check node, *k*, is updated, whereby the input *v* yields the output *w*. As seen in FIG. 12B, the incoming messages to the check node *k* from its $d_c$ adjacent bit nodes are denoted by $v_{n1 \to k}$, $v_{n2 \to k}$,..., $v_{ndc \to k}$. The goal is to compute the outgoing messages from the check node *k* back to $d_c$ adjacent bit nodes. These messages are denoted by $w_{k \to n1}$, $w_{k \to n2}$,..., $w_{k \to ndc}$, where

$$w_{k \to n_l} = g(v_{n_1 \to k}, v_{n_2 \to k}, \dots, v_{n_{l-1} \to k}, v_{n_{l+1} \to k}, \dots, v_{n_{d_c} \to k}).$$

The function g() is defined as follows:

$$g(a,b) = sign(a) \times sign(b) \times \{\min(|a|,|b|)\} + LUT_g(a,b),$$

where $LUT_g(a,b) = \ln(1+e^{-|a+b|}) - \ln(1+e^{-|a-b|})$. Similar to function $f$, function $g$ with more than two variables can be evaluated recursively.

Next, the decoder 305, per step 1205, outputs *a posteriori* probability information (FIG. 12C), such that:

$$a_n = u_n + \sum_j w_{k_j \to n}.$$

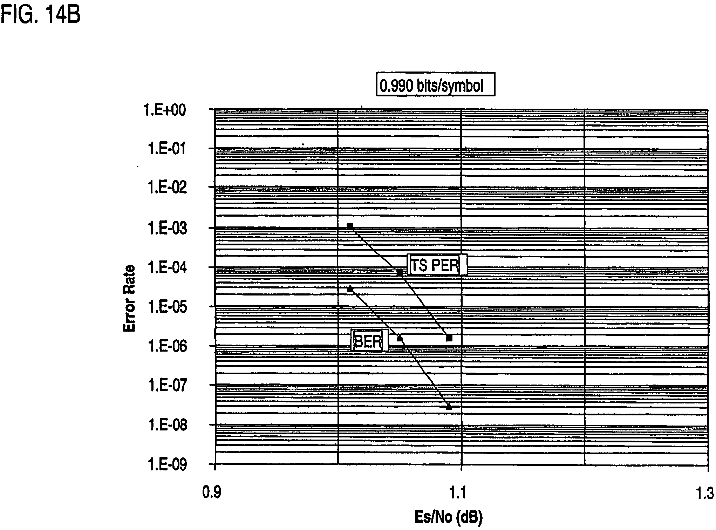

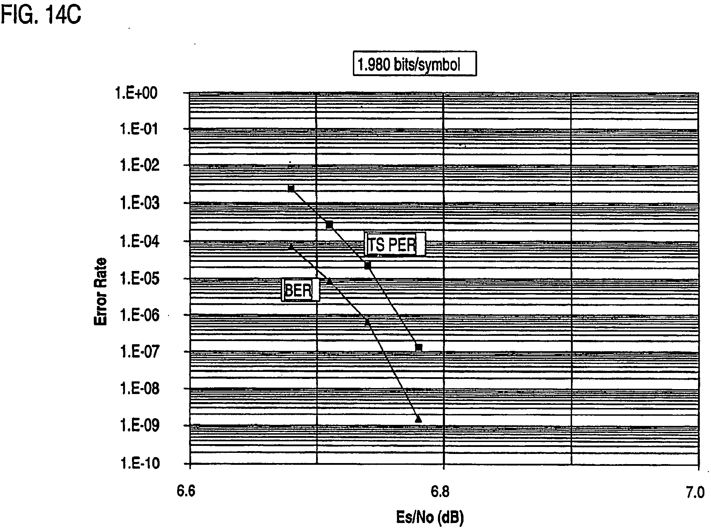

Per step 1007, it is determined whether all the parity check equations are satisfied. If these parity check equations are not satisfied, then the decoder 305, as in step 1009, re-derives 8-PSK bit metrics and channel input $u_n$. Next, the bit node is updated, as in step 1011. As shown in FIG. 14C, the incoming messages to the bit node n from its $d_v$ adjacent check nodes are denoted by $w_{k1 \to n}$, $w_{k2 \to n}, \dots$, $w_{kdv \to n}$ The outgoing messages from the bit node n are computed back to $d_v$ adjacent check nodes; such messages are denoted by $v_{n \to k1}$, $v_{n \to k2}, \dots$, $v_{n \to kdv}$, and computed as follows:

$$v_{n \to k_l} = u_n + \sum_{j \neq l} w_{k_j \to n}$$

In step 1013, the decoder 305 outputs the hard decision (in the case that all parity check equations are satisfied):

$$\hat{c}_n = \begin{cases} 0, & a_n \geq 0 \\ 1, & a_n < 0 \end{cases} \qquad \text{Stop if } H\hat{c}^T = 0$$

The above approach is appropriate when non-Gray labeling is utilized. However, when Gray labeling is implemented, the process of FIG. 11 is executed.

FIG. 11 is a flow chart of the operation of the LDPC decoder of FIG. 3 using Gray mapping. When Gray labeling is used, bit metrics are advantageously generated only once before the LDPC decoder, as re-generating bit metrics after every LDPC decoder iteration may yield nominal performance improvement. As with steps 1001 and 1003 of FIG. 10, initialization of the log likelihood ratios of coded bits, $v$, are performed, and the check node is updated, per steps 1101 and 1103. Next, the bit node $n$ is updated, as in step 1105. Thereafter, the decoder outputs the *a posteriori* probability information (step 1107). In step 1109, a determination is made whether all of the parity check equations are satisfied; if so, the decoder outputs the hard decision (step 1111). Otherwise, steps 1103-1107 are repeated.

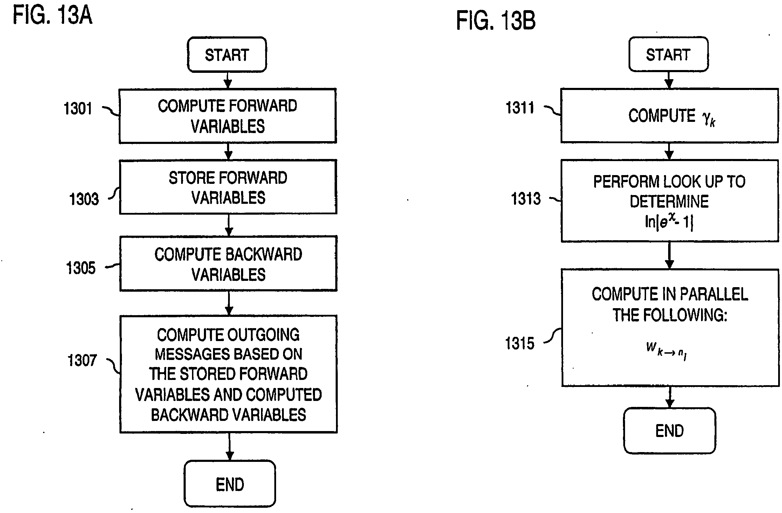

FIG. 13A is a flowchart of process for computing outgoing messages between the check nodes and the bit nodes using a forward-backward approach. For a check node with $d_c$ adjacent edges, the computation of $d_c(d_c-1)$ and numerous $g(.,.)$ functions are performed. However, the forward-backward approach reduces the complexity of the computation to $3(d_c-2)$, in which $d_c-1$ variables are stored.

Referring to FIG. 12B, the incoming messages to the check node $k$ from $d_c$ adjacent bit nodes are denoted by $v_{n1 \to k}$, $v_{n2 \to k}, \dots$, $v_{ndc \to k}$. It is desired that the outgoing messages are computed from the check node $k$ back to $d_c$ adjacent bit nodes; these outgoing messages are denoted by $W_{k \to n1}$, $w_{k \to n2}, \dots$, $w_{k \to ndc}$.

Under the forward-backward approach to computing these outgoing messages, forward variables, $f_1$, $f_2, \dots$, $f_{dc}$, are defined as follows:

$$f_1 = v_{1 \to k}$$
$$f_2 = g(f_1, v_{2 \to k})$$
$$f_3 = g(f_2, v_{3 \to k})$$
$$\vdots \quad \vdots \quad \vdots$$
$$f_{dc} = g(f_{dc-1}, v_{dc \to k})$$

In step 1301, these forward variables are computed, and stored, per step 1303.

Similarly, backward variables, $b_1, b_2, ..., b_{dc}$, are defined by the following:

$$b_{dc} = v_{dc \to k}$$
$$b_{dc-1} = g(b_{dc}, v_{dc-1 \to k})$$
$$\vdots \quad \vdots \quad \vdots$$
$$b_1 = g(b_2, v_{1 \to k})$$

In step 1305, these backward variables are then computed. Thereafter, the outgoing messages are computed, as in step 1307, based on the stored forward variables and the computed backward variables. The outgoing messages are computed as follows:

$$w_{k \to 1} = b_2$$

$$w_{k \to i} = g(f_{i-1}, b_{i+1}) \qquad i = 2, 3, ..., d_c - 1$$

$$w_{k \to dc} = f_{dc-1}$$

Under this approach, only the forward variables, $f_2, f_3, ..., f_{dc}$, are required to be stored. As the backward variables $b_i$ are computed, the outgoing messages, $w_{k \to i}$, are simultaneously computed, thereby negating the need for storage of the backward variables.

The computation load can be further enhance by a parallel approach, as next discussed.

FIG. 13B is a flowchart of process for computing outgoing messages between the check nodes and the bit nodes using a parallel approach. For a check node $k$ with inputs $v_{n1 \to k}, v_{n2 \to k}, ..., v_{ndc \to k}$ from $d_c$ adjacent bit nodes, the following parameter is computed, as in step 1311:

$$\gamma_k = g(v_{n_1 \to k}, v_{n_2 \to k}, ..., v_{n_{dc} \to k}).$$

It is noted that the $g(.,.)$ function can also be expressed as follows:

$$g(a, b) = \ln \frac{1 + e^{a+b}}{e^a + e^b}.$$

Exploiting the recursive nature of the $g(.,.)$ function, the following expression results:

$$\gamma_k = \ln \frac{1 + e^{\delta(v_{o_1 \to k} \cdots v_{q-1 \to k} \cdot v_{q+1 \to k} \cdots v_{d_c \to k}) + v_{q \to k}}}{e^{\delta(v_{n_1 \to k} \cdots v_{q-1 \to k} \cdot v_{q+1 \to k} \cdots v_{d_c \to k}) + e^{v_{q \to k}}}} = \ln \frac{1 + e^{w_{1 \to q} + v_{q \to k}}}{e^{w_{1 \to q}} + e^{v_{q \to k}}}$$

Accordingly, $W_{k \to n1}$ can be solved in the following manner:

$$w_{k \to n_i} = \ln \frac{e^{v_{q \to k} + \gamma_k} - 1}{e^{v_{q \to k} - \gamma_k} - 1} - \gamma_k$$

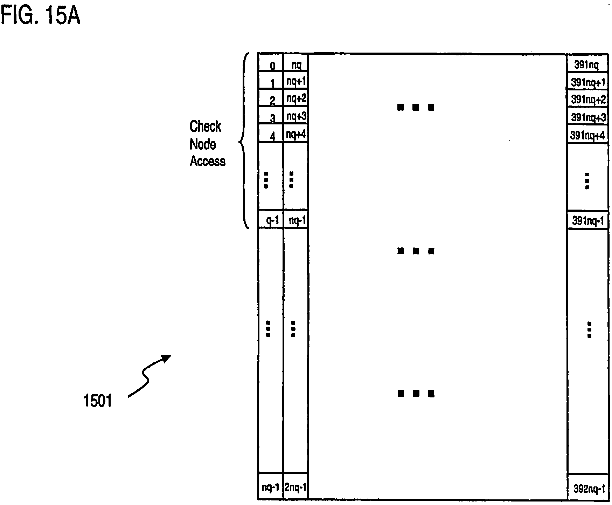

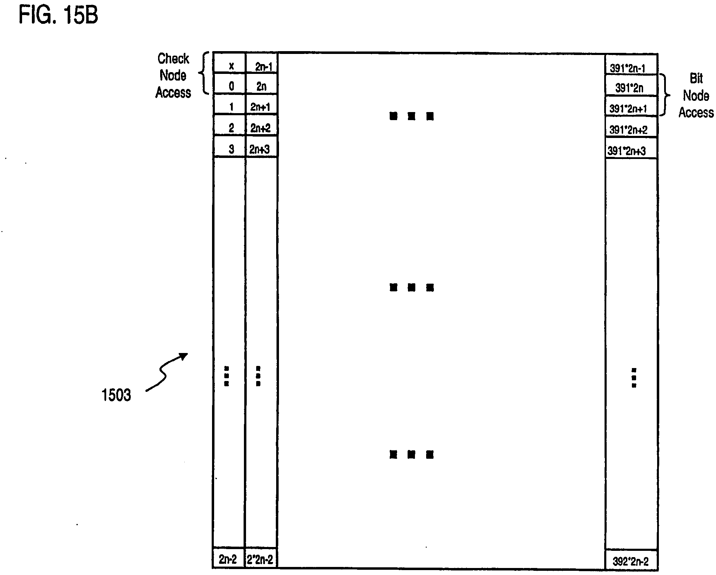

The ln(.) term of the above equation can be obtained using a look-up table $LUT_x$ that represents the function $\ln|e^x-1|$ (step 1313). Unlike the other look-up tables $LUT_f$ or $LUT_g$, the table $LUT_x$ would likely requires as many entries as the number of quantization levels. Once $\gamma_k$ is obtained, the calculation of $w_{k \to n1}$ for all $n_i$ can occur in parallel using the above equation, per step 1315.
The computational latency of $\gamma_k$ is advantageously $\log_2(d_c)$.

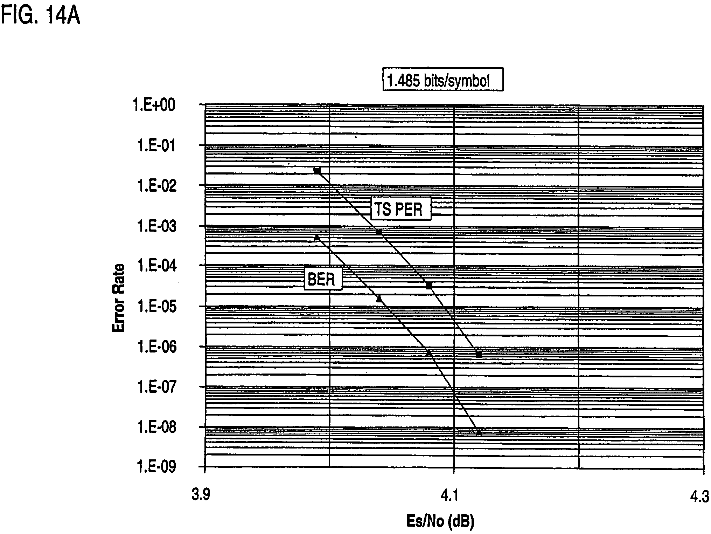

FIGs. 14A-14C are graphs showing simulation results of LDPC codes generated in accordance with various embodiments of the present invention. In particular, FIGs. 14A-14C show the performance of LDPC codes with higher order modulation and code rates of 3/4 (QPSK, 1.485 bits/symbol), 2/3 (8-PSK, 1.980 bits/symbol), and 5/6 (8-PPSK, 2.474 bits/symbol).
Two general approaches exist to realize the interconnections between check nodes and bit nodes: (1) a fully parallel approach, and (2) a partially parallel approach. In fully parallel architecture, all of the nodes and their interconnections are physically implemented. The advantage of this architecture is speed.
The fully parallel architecture, however, may involve greater complexity in realizing all of the nodes and their connections. Therefore with fully parallel architecture, a smaller block size may be required to reduce the complexity. In that case, for the same clock frequency, a proportional reduction in throughput and some degradation in FER versus Es/No performance may result.
The second approach to implementing LDPC codes is to physically realize only a subset of the total number of the nodes and use only these limited number of "physical" nodes to process all of the "functional" nodes of the code. Even though the LDPC decoder operations can be made extremely simple and can be performed in parallel, the further challenge in the design is how the communication is established between "randomly" distributed bit nodes and check nodes. The decoder 305 (of FIG. 3) addresses this problem by accessing memory in a structured way, as to realize a seemingly random code. This approach is explained with respect to FIGs. 15A and 15B.
FIGs. 15A and 15B are diagrams of the top edge and bottom edge, respectively, of memory organized to support structured access as to realize randomness in LDPC coding, according to an embodiment of the present invention. Structured access can be achieved without compromising the performance of a truly random code by focusing on the generation of the parity check matrix. In general, a parity check matrix can be specified by the connections of the check nodes with the bit nodes. For example, the bit nodes can be divided into groups of a fixed size, which for illustrative purposes is 392. Additionally, assuming the check nodes connected to the first bit node of degree 3, for instance, are numbered as $a$, $b$ and $c$, then the check nodes connected to the second bit node are numbered as $a+p$, $b+p$ and $c+p$, the check nodes connected to the third bit node are numbered as $a+2p$, $b+2p$ and c+2p etc.; where $p$=(number of check nodes)/392. For the next group of 392 bit nodes, the check nodes connected to the first bit node are different from $a$, $b$, $c$ so that with a suitable choice of $p$, all the check nodes have the same degree. A random search is performed over the free constants such that the resulting LDPC code is cycle-4 and cycle-6 free. Because of the structural characteristics of the parity check matrix of the present invention, the edge information can stored to permit concurrent access to a group of relevant edge values during decoding.
In other words the approach facilitates memory access during check node and bit node processing. The values of the edges in the bipartite graph can be stored in a storage medium, such as random access memory (RAM). It is noted that for a truly random LDPC code during check node and bit node processing, the values of the edges would need to be accessed one by one in a random fashion. However, such a conventional access scheme would be too slow for a high data rate application. The RAM of FIGs. 15A and 15B are organized in a manner, whereby a large group of relevant edges can be fetched in one clock cycle; accordingly, these values are placed "together" in memory, according to a predetermined scheme or arrangement. It is observed that, in actuality, even with a truly random code, for a group of check nodes (and respectively bit nodes), the relevant edges can be placed next to one another in RAM, but then the relevant edges adjacent to a group of bit nodes (respectively check nodes) will be randomly scattered in RAM. Therefore, the "togetherness" stems from the design of the parity check matrices themselves. That is, the check matrix design ensures that the relevant edges for a group of bit nodes and check nodes are simultaneously placed together in RAM.

As seen in FIGs. 15A and 15B, each box contains the value of an edge, which is multiple bits (e.g., 6). Edge RAM is divided into two parts: top edge RAM 1501 (FIG. 15A) and bottom edge RAM 1503 (FIG. 15B). Bottom edge RAM contains the edges between bit nodes of degree 2, for example, and check nodes. Top edge RAM 1501 contains the edges between bit nodes of degree greater than 2 and check nodes. Therefore, for every check node, 2 adjacent edges are stored in the bottom RAM 1503, and the rest of the edges are stored in the top edge RAM 1501. For example, the size of the top edge RAM 1501 and bottom edge RAM 1503 for various code rates are given in Table 14:

Table 14

|  | 1/2 | 2/3 | 3/4 | 5/6 |
|---|---|---|---|---|
| Top Edge RAM | 400 x 392 | 440 x 392 | 504 x 392 | 520 x 392 |
| Bottom Edge RAM | 160 x 392 | 110 x 392 | 72 x 392 | 52 x 392 |

Based on Table 14, an edge RAM of size 576 x 392 is sufficient to store the edge metrics for all the code rates of 1/2, 2/3, 3/4, and 5/6.

As noted, under this exemplary scenario, a group of 392 bit nodes and 392 check nodes are selected for processing at a time. For 392 check node processing, $q = d_c$-2 consecutive rows are accessed from the top edge RAM 1501, and 2 consecutive rows from the bottom edge RAM 1503. The value of $d_c$ depends on the specific code, for example $d_c$=7 for rate ½, $d_c$=10 for rate 2/3, $d_c$=16 for rate ¾ and $d_c$=22 for rate 5/6 for the above codes. Of course other values of $d_c$ for other codes are possible. In this instance, $q+2$ is the degree of each check node.

For bit node processing, if the group of 392 bit nodes has degree 2, their edges are located in 2 consecutive rows of the bottom edge RAM 1503. If the bit nodes have degree $d > 2$, their edges are located in some $d$ rows of the top edge RAM 1501. The address of these d rows can be stored in non-volatile memory, such as Read-Only Memory (ROM). The edges in one of the rows correspond to the first edges of 392 bit nodes, the edges in another row correspond to the second edges of 392 bit nodes, etc. Moreover for each row, the column index of the edge that belongs to the first bit node in the group of 392 can also be stored in ROM. The edges that correspond to the second, third, etc. bit nodes follow the starting column index in a "wrapped aground" fashion. For example, if the $j$th edge in the row belongs to the first bit node, then the $(j+1)$st edge belongs to the second bit node, $(j+2)$nd edge belongs to the third bit node,...., and $(j-1)$st edge belongs to the 392th bit node.

With the organization shown in FIGs. 15A and 15B, speed of memory access is greatly enhanced during LDPC coding.

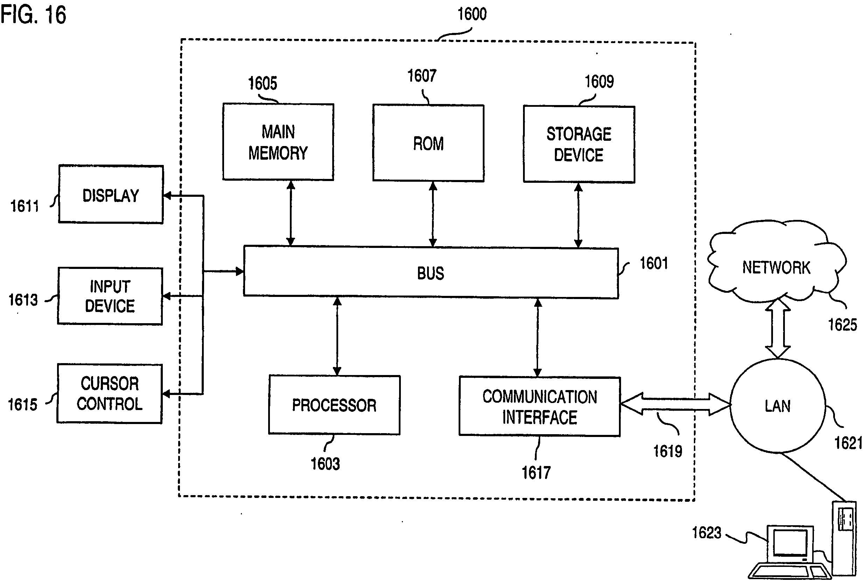

FIG. 16 illustrates a computer system upon which an embodiment according to the present invention can be implemented. The computer system 1600 includes a bus 1601 or other communication mechanism for communicating information, and a processor 1603 coupled to the bus 1601 for processing information. The computer system 1600 also includes main memory 1605, such as a random access memory (RAM) or other dynamic storage device, coupled to the bus 1601 for storing information and instructions to be executed by the processor 1603. Main memory 1605 can also be used for storing temporary variables or other intermediate information during execution of instructions to be executed by the processor 1603. The computer system 1600 further includes a read only memory (ROM) 1607 or other static storage device coupled to the bus 1601 for storing static information and instructions for the processor 1603. A storage device 1609, such as a magnetic disk or optical disk, is additionally coupled to the bus 1601 for storing information and instructions.

The computer system 1600 may be coupled via the bus 1601 to a display 1611, such as a cathode ray tube (CRT), liquid crystal display, active matrix display, or plasma display, for displaying information to a computer user. An input device 1613, such as a keyboard including ' alphanumeric and other keys, is coupled to the bus 1601 for communicating information and command selections to the processor 1603. Another type of user input device is cursor control 1615, such as a mouse, a trackball, or cursor direction keys for communicating direction information and command selections to the processor 1603 and for controlling cursor movement on the display 1611.

According to one embodiment of the invention, generation of LDPC codes is provided by the computer system 1600 in response to the processor 1603 executing an arrangement of instructions contained in main memory 1605. Such instructions can be read into main memory 1605 from another computer-readable medium, such as the storage device 1609. Execution of the arrangement of instructions contained in main memory 1605 causes the processor 1603 to perform the process steps described herein. One or more processors in a multi-processing arrangement may also be employed to execute the instructions contained in main memory 1605. In alternative embodiments, hard-wired circuitry may be used in place of or in combination with software instructions to implement the embodiment of the present invention. Thus, embodiments of the present invention are not limited to any specific combination of hardware circuitry and software.

The computer system 1600 also includes a communication interface 1617 coupled to bus 1601. The communication interface 1617 provides a two-way data communication coupling to a network link 1619 connected to a local network 1621. For example, the communication interface 1617 may be a digital subscriber line (DSL) card or modem, an integrated services digital network (ISDN) card, a cable modem, or a telephone modem to provide a data communication connection to a corresponding type of telephone line. As another example, communication interface 1617 may be a local area network (LAN) card (e.g. for Ethernet™ or an Asynchronous Transfer Model (ATM) network) to provide a data communication connection to a compatible LAN. Wireless links can also be implemented. In any such implementation, communication interface 1617 sends and receives electrical, electromagnetic, or optical signals that carry digital data streams representing various types of information. Further, the communication interface 1617 can include peripheral interface devices, such as a Universal Serial Bus (USB) interface, a PCMCIA (Personal Computer Memory Card International Association) interface, etc.

The network link 1619 typically provides data communication through one or more networks to other data devices. For example, the network link 1619 may provide a connection through local network 1621 to a host computer 1623, which has connectivity to a network 1625 (e.g. a wide area network (WAN) or the global packet data communication network now commonly referred to as the "Internet") or to data equipment operated by service provider. The local network 1621 and network 1625 both use electrical, electromagnetic, or optical signals to convey information and instructions. The signals through the various networks and the signals on network link 1619 and through communication interface 1617, which communicate digital data with computer system 1600, are exemplary forms of carrier waves bearing the information and instructions.

The computer system 1600 can send messages and receive data, including program code, through the network(s), network link 1619, and communication interface 1617. In the Internet example, a server (not shown) might transmit requested code belonging to an application program for implementing an embodiment of the present invention through the network 1625, local network 1621 and communication interface 1617. The processor 1603 may execute the transmitted code while being received and/or store the code in storage device 169, or other non-volatile storage for later execution. In this manner, computer system 1600 may obtain application code in the form of a carrier wave.

The term "computer-readable medium" as used herein refers to any medium that participates in providing instructions to the processor 1603 for execution. Such a medium may take many forms, including but not limited to non-volatile media, volatile media, and transmission media. Non-volatile media include, for example, optical or magnetic disks, such as storage device 1609. Volatile media include dynamic memory, such as main memory 1605. Transmission media include coaxial cables, copper wire and fiber optics, including the wires that comprise bus 1601. Transmission media can also take the form of acoustic, optical, or electromagnetic waves, such as those generated during radio frequency (RF) and infrared (IR) data communications. Common forms of computer-readable media include, for example, a floppy disk, a flexible disk, hard disk, magnetic tape, any other magnetic medium, a CD-ROM, CDRW, DVD, any other optical medium, punch cards, paper tape, optical mark sheets, any other physical medium with patterns of holes or other optically recognizable indicia, a RAM, a PROM, and EPROM, a FLASH-EPROM, any other memory chip or cartridge, a carrier wave, or any other medium from which a computer can read.

Various forms of computer-readable media may be involved in providing instructions to a processor for execution. For example, the instructions for carrying out at least part of the present invention may initially be borne on a magnetic disk of a remote computer. In such a scenario, the remote computer loads the instructions into main memory and sends the instructions over a telephone line using a modem. A modem of a local computer system receives the data on the telephone line and uses an infrared transmitter to convert the data to an infrared signal and transmit the infrared signal to a portable computing device, such as a personal digital assistance (PDA) and a laptop. An infrared detector on the portable computing device receives the information and instructions borne by the infrared signal and places the data on a bus. The bus conveys the data to main memory, from which a processor retrieves and executes the instructions. The instructions received by main memory may optionally be stored on storage device either before or after execution by processor.

Accordingly, the various embodiments of the present invention provide an encoder, which is a Low Density Parity Check (LDPC) encoder, which generates encoded signals by transforming an input message into a codeword represented by a plurality of set of bits.

While the present invention has been described in connection with a number of embodiments and implementations, the present invention is not so limited but covers various obvious modifications and equivalent arrangements, which fall within the purview of the appended claims.

The following are examples not forming part of the invention:

1. A method for transmitting encoded signals, the method comprising:

receiving one of a plurality of set of bits of a codeword from an encoder (203) for transforming an input message into the codeword;
non-sequentially mapping the one set of bits into a higher order constellation; and
outputting a symbol of the higher order constellation corresponding to the one set of bits based on mapping.

2. A method according to example 1, further comprising:

writing $N$ encoded bits to a block interleaver on a column by column basis; and reading out the encoded bits on a row by row basis, wherein the block interleaver has N/3 rows and 3 columns when the higher order modulation is 8-PSK (Phase Shift Keying), N/4 rows and 4 columns when the higher order modulation is 16-APSK (Amplitude Phase Shift Keying), and N/5 rows and 5 columns when the higher order modulation is 32-APSK.

3. A method according to example 1, wherein the encoder (203) in the receiving step generates the codeword according to a Low Density Parity Check (LDPC) code.

4. A method according to example 3, wherein the parity check matrix of the LDPC code is structured by restricting a triangular portion of the parity check matrix to zero values.

5. A method according to example 3, wherein the higher order constellation represents a Quadrature Phase Shift Keying (QPSK) modulation scheme, the method further comprising:

determining an $i$th QPSK symbol based on the set of $2i$th and $(2i+1)$th LDPC encoded bits, wherein $i$=0,1,2 ..., N/2-1, and N is the coded LDPC block size.

6. A method according to example 3, wherein the higher order constellation represents an 8-PSK modulation scheme, the method further comprising:

determining an $i$th 8-PSK symbol based on the set of $(N/3+i)$th, $(2N/3+i)$th and $i$th LDPC encoded bits, wherein $i$=0,1,2,...,$N$/3-1, and $N$ is the coded LDPC block size.

7. A method according to example 3, wherein the higher order constellation represents a 16-ASPK (Amplitude Phase Shift Keying) modulation scheme, the method further comprising:

determining an $i$th 16-APSK symbol based on the set of $(N/2+2i)$th, $2i$th, $(N/2+2i+1)$th and $(2i+1)$th LDPC encoded bits, wherein $i$=0,1,2,...,$N$/3-1, and $N$ is the coded LDPC block size.

8. A method according to example 3, wherein the higher order constellation represents a 32-APSK (Amplitude Phase Shift Keying) modulation scheme, the method further comprising:

determining an $i$th 32-APSK symbol based on the set of $(N/5+i)$th, $(2N/5+i)$th, $(4N/5+i)$th, $(3N/5+i)$th and $i$th LDPC encoded bits, wherein $i$=0,1,2,...,$N$/5-1, and $N$ is the encoded LDPC block size.

9. A computer-readable medium bearing instructions for transmitting encoded signals, said instruction, being arranged, upon execution, to cause one or more processors to perform the method of example 1.

10. A transmitter for generating encoded signals, the transmitter comprising:

an encoder (203) configured to transform an input message into a codeword represented by a plurality of set of bits; and
logic configured to map non-sequentially one set of bits into a higher order constellation,

wherein a symbol of the higher order constellation corresponding to the one set of bits is output based on the mapping.

11. A transmitter according to example 10, wherein the $N$ encoded bits are written to a block interleaver column by column and read out row by row, and the block interleaver has $N$/3 rows and 3 columns when the higher order modulation is 8-PSK (Phase Shift Keying), $N$/4 rows and 4 columns when the higher order modulation is 16-APSK (Amplitude Phase Shift Keying), and $N$/5 rows and 5 columns when the higher order modulation is 32-APSK.

12. A transmitter according to example 11, wherein the encoder (203) generates the codeword according to a Low Density Parity Check (LDPC) code.

13. A transmitter according to example 12, wherein the parity check matrix of the LDPC code is structured by restricting a triangular portion of the parity check matrix to zero values.

14. A transmitter according to example 12, wherein the higher order constellation represents a Quadrature Phase Shift Keying (QPSK) modulation scheme, and the logic is further configured to determine an $i^{th}$ QPSK symbol based on the set of $2i^{th}$ and $(2i+1)^{th}$ LDPC encoded bits, wherein $i=0,1,2...,N/2-1$, and $N$ is the coded LDPC block size.

15. A transmitter according to example 12, wherein the higher order constellation represents an 8-PSK modulation scheme, and the logic is further configured to determine an $i^{th}$ 8-PSK symbol based on the set of $(N/3+i)^{th}$, $(2N/3+i)^{th}$ and $i^{th}$ LDPC encoded bits, wherein $i=0,1,2,...,N/3-1$, and N is the coded LDPC block size.

16. A transmitter according to example 12, wherein the higher order constellation represents a 16-APSK (Amplitude Phase Shift Keying) modulation scheme, and the logic is further configured to determine an $i^{th}$ 16-APSK symbol based on the set of bits $(N/2+2i)^{th}$, $2i^{th}$, $(N/2+2i+1)^{th}$ and $(2i+1)^{th}$ LDPC encoded bits, wherein $i=0,1,2,...,N/3-1$, and $N$ is the coded LDPC block size.

17. A transmitter according the example 12, wherein the higher order constellation represents a 32-APSK (Amplitude Phase Shift Keying) modulation scheme, and the logic is further configured to determine an $i^{th}$ 32-APSK symbol based on the set of bits $(N/5+i)^{th}$, $(2N/5+i)^{th}$, $(4N/5+i)^{th}$, $(3N/5+i)^{th}$ and $i^{th}$ LDPC encoded bits, wherein $i=0,1,2,...,N/5-1$, and $N$ is the coded LDPC block size.

18. A method for processing encoded signals, the method comprising:

  demodulating a received encoded signal representing a codeword, wherein the encoded signal being modulated according to a non-sequential mapping of a plurality of bits corresponding to the codeword; and
  decoding the codeword associated with the encoded signal.

19. A method according to example 18, wherein the $N$ encoded bits are written to a block interleaver column by column and read out row by row, and the block interleaver has N/3 rows and 3 columns when the higher order modulation is 8-PSK (Phase Shift Keying), $N/4$ rows and 4 columns when the higher order modulation is 16-APSK (Amplitude Phase Shift Keying), and $N/5$ rows and 5 columns when the higher order modulation is 32-APSK.

20. A method according to example 19, wherein the decoding step is according to a Low Density Parity Check (LDPC) code.

21. A method according to example 20, wherein the parity check matrix of the LDPC code is structured by restricting a triangular portion of the parity check matrix to zero values.

22. A method according to example 20, wherein the higher order constellation represents a Quadrature Phase Shift Keying (QPSK) modulation scheme, and an $i^{th}$ QPSK symbol is determined based on the set of $2i^{th}$ and $(2i+1)^{th}$ LDPC encoded bits, wherein $i=0,1,2...,N/2-1$, and $N$ is the coded LDPC block size.

23. A method according to example 20, wherein the higher order constellation represents an 8-PSK modulation scheme, and an $i^{th}$ 8-PSK symbol is determined based on the set of $(N/3+i)^{th}$, $(2N/3+i)^{th}$ and $i^{th}$ LDPC encoded bits, wherein $i=0,1,2,...,N/3-1$, and $N$ is the coded LDPC block size.

24. A method according to example 20, wherein the higher order constellation represents a 16-APSK (Amplitude Phase Shift Keying) modulation scheme, and an $i^{th}$ 16-APSK symbol is determined based on the set of bits $(N/2+2i)^{th}$, $2i^{th}$, $(N/2+2i+1)^{th}$ and $(2i+1)^{th}$ LDPC encoded bits, wherein $i=0,1,2,...,N/3-1$, and $N$ is the coded LDPC block size.

25. A method according to example 20, wherein the higher order constellation represents a 32-APSK (Amplitude Phase Shift Keying) modulation scheme, and an $i^{th}$ 32-APSK symbol is determined based on the set of bits $(N/5+i)^{th}$, $(2N/5+i)^{th}$, $(4N/5+i)^{th}$, $(3N/5+i)^{th}$ and $i^{th}$ LDPC encoded bits, wherein $i=0,1,2,...,N/5-1$, and $N$ is the coded LDPC block size.

26. A computer-readable medium bearing instructions processing encoded signals, said instruction, being arranged, upon execution, to cause one or more processors to perform the method of example 18.

**Claims**

1. A method for encoding signals, the method comprising:

encoding an input message into a codeword with a Low Density Parity Check (LDPC) encoder (203), wherein the step of encoding comprises:

receiving information bits, $i_0, i_1, ..., i_m, ..., i_{kldpc-1}$;

initializing parity bits, $p_0, p_1, ..., p_j, ..., p_{nldpc - kldpc-1}$, of a Low Density Parity Check (LDPC) code having a code rate of 4/5, 3/5, 8/9, or 9/10 according to $p_0 = p_1 = ... = p_{nldpc - kldpc - 1} = 0$;

generating, based on the information bits, the parity bits by accumulating the information bits by performing operations for each information bit, $i_m$, $p_j = p_j \oplus i_m$ for each corresponding value of $j$, and subsequently performing the operation, starting with $j = 1$, $P_j = P_j \oplus p_{j-1}$, for $j = 1, 2, ..., n_{ldpc} - k_{ldpc} - 1$; and

generating the codeword, $c$, of size $n_{ldpc}$ as $c = (i_0, i_1, ..., i_{kldpc -1}, p_0, p_1, ..., p_{nldpc - kldpc - 1})$ where $p_j$, for $j = 1, 2, ..., n_{ldpc} - k_{ldpc} - 1$, is final content of $p_j$,

wherein $j$ is a parity bit address equal to $\{x + m \bmod 360 \times q\} \bmod (n_{ldpc} - k_{ldpc})$, $n_{ldpc}$ is a codeword size equating to 64800, $k_{ldpc}$ is an information block size equating to the code rate multiplied by $n_{ldpc}$, $m$ is an integer corresponding to a particular information bit, and x denotes a parity bit address, wherein each row of the following tables specifies addresses x for a particular one of the code rates of 4/5, 3/5, 8/9, or 9/10 corresponding to a particular one of the tables, wherein q is specified in the following table for each one of the code rates of 4/5, 3/5, 8/9, or 9/10, whereby each successive row of the corresponding table for the particular code rate provides all parity bit addresses $j$ for the first information bit in each successive group of 360 information bits, and each successive row of the table provides all addresses x used in calculating parity bit addresses, $j$, for the next information bits according to $\{x + m \bmod 360 \times q\} \bmod (n_{ldpc} - k_{ldpc})$ in each successive group of 360 information bits:-

Table 1

| Address of Parity Bit Accumulators (Rate 4/5) q = 36 |
|---|
| 0 149 11212 5575 6360 12559 8108 8505 408 10026 12828 |
| 1 5237 490 10677 4998 3869 3734 3092 3509 7703 10305 |
| 2 8742 5553 2820 7085 12116 10485 564 7795 2972 2157 |
| 3 2699 4304 8350 712 2841 3250 4731 10105 517 7516 |
| 4 12067 1351 11992 12191 11267 5161 537 6166 4246 2363 |
| 5 6828 7107 2127 3724 5743 11040 10756 4073 1011 3422 |
| 6 11259 1216 9526 1466 10816 940 3744 2815 11506 11573 |
| 7 4549 11507 1118 1274 11751 5207 7854 12803 4047 6484 |
| 8 8430 4115 9440 413 4455 2262 7915 12402 8579 7052 |
| 9 3885 9126 5665 4505 2343 253 4707 3742 4166 1556 |
| 10 1704 8936 6775 8639 8179 7954 8234 7850 8883 8713 |
| 11 11716 4344 9087 11264 2274 8832 9147 11930 6054 5455 |
| 12 7323 3970 10329 2170 8262 3854 2087 12899 9497 11700 |
| 13 4418 1467 2490 5841 817 11453 533 11217 11962 5251 |
| 14 1541 4525 7976 3457 9536 7725 3788 2982 6307 5997 |
| 15 11484 2739 4023 12107 6516 551 2572 6628 8150 9852 |
| 16 6070 1761 4627 6534 7913 3730 11866 1813 12306 8249 |
| 17 12441 5489 8748 7837 7660 2102 11341 2936 6712 11977 |
| 18 10155 4210 |
| 19 1010 10483 |
| 20 8900 10250 |
| 21 10243 12278 |
| 22 7070 4397 |
| 23 12271 3887 |
| 24 11980 6836 |
| 25 9514 4356 |

(continued)

| Address of Parity Bit Accumulators (Rate 4/5) q = 36 |
|---|
| 26 7137 10281 |
| 27 11881 2526 |
| 28 1969 11477 |
| 29 3044 10921 |
| 30 2236 8724 |
| 31 9104 6340 |
| 32 7342 8582 |
| 33 11675 10405 |
| 34 6467 12775 |
| 35 3186 12198 |
| 0 9621 11445 |
| 1 7486 5611 |
| 2 4319 4879 |
| 3 2196 344 |
| 4 7527 6650 |
| 5 10693 2440 |
| 6 6755 2706 |
| 7 5144 5998 |
| 8 11043 8033 |
| 9 4846 4435 |
| 10 41579228 |
| 11 12270 6562 |
| 12 11994 7592 |
| 13 7420 2592 |
| 14 88109636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |
| 28 12157 7405 |
| 29 6598 11495 |
| 30 11805 4455 |
| 31 9625 2090 |
| 32 4731 2321 |
| 33 3578 2608 |
| 34 8504 1849 |
| 35 4027 1151 |
| 0 5647 4935 |
| 1 4219 1870 |
| 2 10968 8054 |
| 3 6970 5447 |

(continued)

| Address of Parity Bit Accumulators (Rate 4/5) q = 36 |
|---|
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |
| 14 7200 3283 |
| 15 1502 11282 |
| 16 12318 2202 |
| 17 4523 965 |
| 18 9587 7011 |
| 19 2552 2051 |
| 20 12045 10306 |
| 21 11070 5104 |
| 22 6627 6906 |
| 23 9889 2121 |
| 24 829 9701 |
| 25 2201 1819 |
| 26 6689 12925 |
| 27 2139 8757 |
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |
| 6 786 3021 |
| 7 710 2086 |
| 8 7423 5601 |
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |

44

(continued)

| Address of Parity Bit Accumulators (Rate 4/5) q = 36 |
|---|
| 18 6838 9011 |
| 19 6174 9410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |
| 28 12323 9511 |
| 29 8231 1752 |
| 30 497 9022 |
| 31 9288 3080 |
| 32 2481 7515 |
| 33 2696 268 |
| 34 4023 12341 |
| 35 7108 5553 |

Table 2

| Address of Parity Bit Accumulators (Rate 3/5) q = 72 |
|---|
| 22422 10282 11626 19997 11161 2922 3122 99 5625 17064 8270 179 |
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 14487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 19721 25420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 24210 17833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |

| Address of Parity Bit Accumulators (Rate 3/5) q = 72 |
|---|
| 4127 2971 17499 16287 22368 21463 7943 18880 5567 8047 23363 6797 |
| 10651 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 10311 25767 17057 3691 |
| 20473 11294 9914 22815 2574 8439 3699 5431 24840 21908 16088 18244 |
| 8208 5755 19059 8541 24924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |
| 1 10502 3002 |
| 2 9368 10761 |
| 3 12299 7828 |
| 4 15048 13362 |
| 5 18444 24640 |
| 6 20775 19175 |
| 7 18970 10971 |
| 8 5329 19982 |
| 9 11296 18655 |
| 10 15046 20659 |
| 11 7300 22140 |
| 12 22029 14477 |
| 13 11129 742 |
| 14 13254 13813 |
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 16071 21617 |
| 25 6393 3725 |
| 26 597 19968 |
| 27 5743 8084 |
| 28 6770 9548 |
| 29 4285 17542 |
| 30 13568 22599 |
| 31 1786 4617 |
| 32 23238 11648 |
| 33 19627 2030 |
| 34 13601 13458 |
| 35 13740 17328 |
| 36 25012 13944 |
| 37 22513 6687 |
| 38 4934 12587 |
| 39 21197 5133 |
| 40 22705 6938 |

(continued)

| Address of Parity Bit Accumulators (Rate 3/5) q = 72 |
| --- |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |
| 51 24964 24690 |
| 52 14443 8816 |
| 53 6926 1291 |
| 54 6209 20806 |
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |
| 63 12402 3702 |
| 64 8314 1357 |
| 65 20071 14616 |
| 66 17014 3688 |
| 67 19837 946 |
| 68 15195 12136 |
| 69 7758 22808 |
| 70 3564 2925 |
| 71 3434 7769 |

Table 3

| Address of Parity Bit Accumulators (Rate 8/9) q = 20 |
| --- |
| 0 6235 2848 3222 |
| 1 5800 3492 5348 |
| 2 2757 927 90 |
| 3 6961 4516 4739 |
| 4 1172 3237 6264 |
| 5 1927 2425 3683 |
| 6 3714 6309 2495 |
| 7 3070 6342 7154 |
| 8 2428 613 3761 |
| 9 2906 264 5927 |
| 10 1716 1950 4273 |
| 11 4613 6179 3491 |
| 12 4865 3286 6005 |
| 13 1343 5923 3529 |

(continued)

| Address of Parity Bit Accumulators (Rate 8/9) q = 20 |
|---|
| 14 4589 4035 2132 |
| 15 1579 3920 6737 |
| 16 1644 1191 5998 |
| 17 1482 2381 4620 |
| 18 6791 6014 6596 |
| 19 2738 5918 3786 |
| 0 5156 6166 |
| 1 1504 4356 |
| 2 130 1904 |
| 3 6027 3187 |
| 4 6718 759 |
| 5 6240 2870 |
| 6 2343 1311 |
| 7 1039 5465 |
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |
| 16 3215 4163 |
| 17 973 3117 |
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |
| 12 6528 2899 |
| 13 2243 3616 |
| 14 867 3733 |
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |

(continued)

| Address of Parity Bit Accumulators (Rate 8/9) q = 20 |
|---|
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |
| 14 953 4964 |
| 15 4555 4410 |
| 16 4925 4842 |
| 17 5778 600 |
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |
| 6 1481 6847 |
| 7 4433 1932 |
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 2062 6599 |
| 2 4597 4870 |
| 3 1228 6913 |
| 4 4159 1037 |
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |

(continued)

| Address of Parity Bit Accumulators (Rate 8/9) q = 20 |
|---|
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |
| 4 3694 657 |
| 5 1355 110 |
| 6 3329 6736 |
| 7 2505 3407 |
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |
| 16 4320 6121 |
| 17 3961 1125 |
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |
| 12 4695 1600 |
| 13 680 2074 |
| 14 1801 6690 |
| 15 2669 1377 |
| 16 2463 1681 |
| 17 5972 5171 |
| 18 5728 4284 |
| 19 1696 1459 |

Table 4

| Address of Parity Bit Accumulators (Rate 9/10) q = 18 |
| --- |
| 0 5611 2563 2900 |
| 1 5220 3143 4813 |
| 2 2481 834 81 |
| 3 6265 4064 4265 |
| 4 105 2914 5638 |
| 5 1734 2182 3315 |
| 6 3342 5678 2246 |
| 7 2188 552 3385 |
| 8 261 236 5334 |
| 9 1546 1755 3846 |
| 10 4154 5561 3142 |
| 11 4382 2957 5400 |
| 12 1209 5329 3179 |
| 13 1421 3528 6063 |
| 14 1480 1072 5398 |
| 15 3843 1777 4369 |
| 16 1334 2145 4163 |
| 17 2368 5055 260 |
| 0 6118 5405 |
| 1 2994 4370 |
| 2 3405 1669 |
| 3 4640 5550 |
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |
| 0 4165 884 |
| 1 2896 3744 |
| 2 874 2801 |
| 3 3423 5579 |
| 4 3404 3552 |
| 5 2876 5115 |
| 6 516 1719 |
| 7 765 3631 |
| 8 5059 1441 |
| 9 5629 598 |
| 10 5405 473 |
| 11 4724 5210 |
| 12 155 1832 |

(continued)

| Address of Parity Bit Accumulators (Rate 9/10) q = 18 |
|---|
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |
| 4 4286 3517 |
| 5 5531 3184 |
| 6 1935 4560 |
| 7 1174 131 |
| 8 3115 956 |
| 9 3129 1088 |
| 10 5238 4440 |
| 11 5722 4280 |
| 12 3540 375 |
| 13 191 2782 |
| 14 906 4432 |
| 15 3225 1111 |
| 16 6296 2583 |
| 17 1457 903 |
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |
| 14 1907 1854 |
| 15 3601 5748 |
| 16 6056 3266 |
| 17 3322 4085 |
| 0 1768 3244 |
| 1 2149 144 |
| 2 1589 4291 |
| 3 5154 1252 |
| 4 1855 5939 |
| 5 4820 2706 |
| 6 1475 3360 |
| 7 4266 693 |
| 8 4156 2018 |

(continued)

| Address of Parity Bit Accumulators (Rate 9/10) q = 18 |
|---|
| 9 2103 752 |
| 10 3710 3853 |
| 11 5123 931 |
| 12 6146 3323 |
| 13 1939 5002 |
| 14 5140 1437 |
| 15 1263 293 |
| 16 5949 4665 |
| 17 4548 6380 |
| 0 3171 4690 |
| 1 5204 2114 |
| 2 6384 5565 |
| 3 5722 1757 |
| 4 2805 6264 |
| 5 1202 2616 |
| 6 1018 3244 |
| 7 4018 5289 |
| 8 2257 3067 |
| 9 2483 3073 |
| 10 1196 5329 |
| 11 649 3918 |
| 12 3791 4581 |
| 13 5028 3803 |
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |
| 10 5161 2293 |
| 11 4682 3845 |
| 12 3045 643 |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |

(continued)

| Address of Parity Bit Accumulators (Rate 9/10) q = 18 |
|---|
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |
| 14 1542 5401 |
| 15 5078 2687 |
| 16 316 1755 |
| 17 3392 1991 |

2. A Low Density Parity Check (LDPC) encoder (203) for generating encoded signals, comprising:

means configured to receive information bits, $i_0, i_1, ... , i_m, ... , i_{kldpc-1}$;
means configured to initialize parity bits, $p_0, p_1, ... , p_j, ... , p_{nldpc-kldpc-1}$, of a Low Density Parity Check (LDPC) code having a code rate of 4/5, 3/5, 8/9, or 9/10 according to $p_0 = p_1 = ... = p_{nldpc-kldpc-1} = 0$;
means configured to generate, based on the information bits, the parity bits by accumulating the information bits by performing operations for each information bit, $i_m$, $p_j = p_j \oplus i_m$ for each corresponding value of $j$, and subsequently performing the operation, starting with $j = 1$, $p_j = p_j \oplus p_{j-1}$, for $j = 1, 2, ... , n_{ldpc} - k_{ldpc} - 1$; and
mean configured to generate the codeword, $c$, of size $n_{ldpc}$ as $c = (i_0, i_1, ... , i_{kldpc-1}, p_0, p_1, ..., p_{nldpc-ktdpc-1})$ where $p_j$, for $j = 1, 2, ..., n_{ldpc} - k_{ldpc} - 1$, is final content of $p_j$,
wherein $j$ is a parity bit address equal to $\{x + m \bmod 360 \times q\} \bmod (n_{ldpc} - k_{ldpc})$, $n_{ldpc}$ is a codeword size equating to 64800, $k_{ldpc}$ is an information block size equating to the code rate multiplied by $n_{ldpc}$, $m$ is an integer corresponding to a particular information bit, and x denotes a parity bit address, wherein each row of the following tables specifies addresses x for a particular one of the code rates of 4/5, 3/5, 8/9, or 9/10 corresponding to a particular one of the tables, wherein $q$ is specified in the following table for each one of the code rates of 4/5, 3/5, 8/9, or 9/10, whereby each successive row of the corresponding table for the particular code rate provides all parity bit addresses $j$ for the first information bit in each successive group of 360 information bits, and each successive row of the table provides all addresses x used in calculating parity bit addresses, $j$, for the next information bits according to $\{x + m \bmod 360 \times q\} \bmod (n_{ldpc} - k_{ldpc})$ in each successive group of 360 information bits:-

Table 1

| Address of Parity Bit Accumulators (Rate 4/5) q = 36 |
|---|
| 0 149 11212 5575 6360 12559 8108 8505 408 10026 12828 |
| 1 5237 490 10677 4998 3869 3734 3092 3509 7703 10305 |
| 2 8742 5553 2820 7085 12116 10485 564 7795 2972 2157 |
| 3 2699 4304 8350 712 2841 3250 4731 10105 517 7516 |
| 4 12067 1351 11992 12191 11267 5161 537 6166 4246 2363 |
| 5 6828 7107 2127 3724 5743 11040 10756 4073 1011 3422 |
| 6 11259 1216 9526 1466 10816 940 3744 2815 11506 11573 |
| 7 4549 11507 1118 1274 11751 5207 7854 12803 4047 6484 |
| 8 8430 4115 9440 413 4455 2262 7915 12402 8579 7052 |
| 9 3885 9126 5665 4505 2343 253 4707 3742 4166 1556 |
| 10 1704 8936 6775 8639 8179 7954 8234 7850 8883 8713 |
| 11 11716 4344 9087 11264 2274 8832 9147 11930 6054 5455 |
| 12 7323 3970 10329 2170 8262 3854 2087 12899 9497 11700 |
| 13 4418 1467 2490 5841 817 11453 533 11217 11962 5251 |

(continued)

| Address of Parity Bit Accumulators (Rate 4/5) q = 36 |
|---|
| 14 1541 4525 7976 3457 9536 7725 3788 2982 6307 5997 |
| 15 11484 2739 4023 12107 6516 551 2572 6628 8150 9852 |
| 16 6070 1761 4627 6534 7913 3730 11866 1813 12306 8249 |
| 17 12441 5489 8748 7837 7660 2102 11341 2936 6712 11977 |
| 18 10155 4210 |
| 19 1010 10483 |
| 20 8900 10250 |
| 21 10243 12278 |
| 22 7070 4397 |
| 23 12271 3887 |
| 24 11980 6836 |
| 25 9514 4356 |
| 26 7137 10281 |
| 27 11881 2526 |
| 28 1969 11477 |
| 29 3044 10921 |
| 30 2236 8724 |
| 31 9104 6340 |
| 32 7342 8582 |
| 33 11675 10405 |
| 34 6467 12775 |
| 35 3186 12198 |
| 0 9621 11445 |
| 1 7486 5611 |
| 2 4319 4879 |
| 3 2196 344 |
| 4 7527 6650 |
| 5 10693 2440 |
| 6 6755 2706 |
| 7 5144 5998 |
| 8 11043 8033 |
| 9 4846 4435 |
| 10 4157 9228 |
| 11 12270 6562 |
| 12 11954 7592 |
| 13 7420 2592 |
| 14 8810 9636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |

(continued)

| Address of Parity Bit Accumulators (Rate 4/5) q = 36 |
|---|
| 28 12157 7405 |
| 29 6598 11495 |
| 30 11805 4455 |
| 31 9625 2090 |
| 32 4731 2321 |
| 33 3578 2608 |
| 34 8504 1849 |
| 35 4027 1151 |
| 0 5647 4935 |
| 1 4219 1870 |
| 2 10968 8054 |
| 3 6970 5447 |
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |
| 14 7200 3283 |
| 15 1502 11282 |
| 16 12318 2202 |
| 17 4523 965 |
| 18 9587 7011 |
| 19 2552 2051 |
| 20 12045 10306 |
| 21 11070 5104 |
| 22 6627 6906 |
| 23 9889 2121 |
| 24 829 9701 |
| 25 2201 1819 |
| 26 6689 12925 |
| 27 2139 8757 |
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |

(continued)

| Address of Parity Bit Accumulators (Rate 4/5) q = 36 |
|---|
| 6 786 3021 |
| 7 710 2086 |
| 8 7423 5601 |
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |
| 18 6838 9011 |
| 19 6174 9410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |
| 28 12323 9511 |
| 29 8231 1752 |
| 30 497 9022 |
| 31 9288 3080 |
| 32 2481 7515 |
| 33 2696 268 |
| 34 4023 12341 |
| 35 7108 5553 |

Table 2

| Address of Parity Bit Accumulators (Rate 3/5) q = 72 |
|---|
| 22422 10282 11626 19997 11161 2922 3122 99 5625 17064 8270 179 |
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 14487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 19721 25420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |

(continued)

| Address of Parity Bit Accumulators (Rate 3/5) q = 72 |
| --- |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 24210 17833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |
| 4127 2971 17499 16287 22368 21463 7943 18880 5567 8047 23363 6797 |
| 1065 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 10311 25767 17057 3691 |
| 20473 11294 9914 22815 2574 8439 3699 5431 24840 21908 16088 18244 |
| 8208 5755 19059 8541 24924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |
| 1 10502 3002 |
| 2 9368 10761 |
| 3 12299 7828 |
| 4 15048 13362 |
| 5 18444 24640 |
| 6 20775 19175 |
| 7 18970 10971 |
| 8 5329 19982 |
| 9 11296 18655 |
| 10 15046 20659 |
| 11 7300 22140 |
| 12 22029 14477 |
| 13 11129 742 |
| 14 13254 13813 |
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 16071 21617 |
| 25 6393 3725 |
| 26 597 19968 |
| 27 5743 8084 |
| 28 6770 9548 |

(continued)

| Address of Parity Bit Accumulators (Rate 3/5) q = 72 |
|---|
| 29 4285 17542 |
| 30 13568 22599 |
| 31 1786 4617 |
| 32 23238 11648 |
| 33 19627 2030 |
| 34 13601 13458 |
| 35 13740 17328 |
| 36 25012 13944 |
| 37 22513 6687 |
| 38 4934 12587 |
| 39 21197 5133 |
| 40 22705 6938 |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |
| 51 24964 24690 |
| 52 14443 8816 |
| 53 6926 1291 |
| 54 6209 20806 |
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |
| 63 12402 3702 |
| 64 8314 1357 |
| 65 20071 14616 |
| 66 17014 3688 |
| 67 19837 946 |
| 68 15195 12136 |
| 69 7758 22808 |
| 70 3564 2925 |
| 71 3434 7769 |

Table 3

| Address of Parity Bit Accumulators (Rate 8/9) q = 20 |
|---|
| 0 6235 2848 3222 |
| 1 5800 3492 5348 |

(continued)

| Address of Parity Bit Accumulators (Rate 8/9) q = 20 |
|---|
| 2 2757 927 90 |
| 3 6961 4516 4739 |
| 4 1172 3237 6264 |
| 5 1927 2425 3683 |
| 6 3714 6309 2495 |
| 7 3070 6342 7154 |
| 8 2428 613 3761 |
| 9 2906 264 5927 |
| 10 1716 1950 4273 |
| 11 4613 6179 3491 |
| 12 4865 3286 6005 |
| 13 1343 5923 3529 |
| 14 4589 4035 2132 |
| 15 1579 3920 6737 |
| 16 1644 1191 5998 |
| 17 1482 2381 4620 |
| 18 6791 6014 6596 |
| 19 2738 5918 3786 |
| 0 5156 6166 |
| 1 1504 4356 |
| 2 130 1904 |
| 3 6027 3187 |
| 4 6718 759 |
| 5 6240 2870 |
| 6 2343 1311 |
| 7 1039 5465 |
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |
| 16 3215 4163 |
| 17 973 3117 |
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |

(continued)

| Address of Parity Bit Accumulators (Rate 8/9) q = 20 |
|---|
| 12 6528 2899 |
| 13 2243 3616 |
| 14 867 3733 |
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |
| 14 953 4964 |
| 15 4555 4410 |
| 16 4925 4842 |
| 17 5778 600 |
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |
| 6 1481 6847 |
| 7 4433 1932 |
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 2062 6599 |

(continued)

| Address of Parity Bit Accumulators (Rate 8/9) q = 20 |
|---|
| 2 4597 4870 |
| 3 1228 6913 |
| 4 4159 1037 |
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |
| 4 3694 657 |
| 5 1355 110 |
| 6 3329 6736 |
| 7 2505 3407 |
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |
| 16 4320 6121 |
| 17 3961 1125 |
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |

(continued)

| Address of Parity Bit Accumulators (Rate 8/9) q = 20 |
|---|
| 12 4695 1600 |
| 13 680 2074 |
| 14 1801 6690 |
| 15 2669 1377 |
| 16 2463 1681 |
| 17 5972 5171 |
| 18 5728 4284 |
| 19 1696 1459 |

Table 4

| Address of Parity Bit Accumulators (Rate 9/10) q = 18 |
|---|
| 0 5611 2563 2900 |
| 1 5220 3143 4813 |
| 2 2481 834 81 |
| 3 6265 4064 4265 |
| 4 1055 2914 5638 |
| 5 1734 2182 3315 |
| 6 3342 5678 2246 |
| 7 2188 552 3385 |
| 8 2615 236 5334 |
| 9 1546 1755 3846 |
| 10 4154 5561 3142 |
| 11 4382 2957 5400 |
| 12 1209 5329 3179 |
| 13 1421 3528 6063 |
| 14 1480 1072 5398 |
| 1 3843 1777 4369 |
| 16 1334 2145 4163 |
| 17 2368 5055 260 |
| 0 6118 5405 |
| 1 2994 4370 |
| 2 3405 1669 |
| 3 4640 5550 |
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |

(continued)

| Address of Parity Bit Accumulators (Rate 9/10) q = 18 |
|---|
| 0 4165 884 |
| 1 2896 3744 |
| 2 874 2801 |
| 3 3423 5579 |
| 4 3404 3552 |
| 5 2876 5515 |
| 6 516 1719 |
| 7 765 3631 |
| 8 5059 1441 |
| 9 5629 598 |
| 10 5405 473 |
| 11 4724 5210 |
| 12 155 1832 |
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |
| 4 4286 3517 |
| 5 5531 3184 |
| 6 1935 4560 |
| 7 1174 131 |
| 8 3115 956 |
| 9 3129 1088 |
| 10 5238 4440 |
| 11 5722 4280 |
| 12 3540 375 |
| 13 191 2782 |
| 14 906 4432 |
| 15 3225 1111 |
| 16 6296 2583 |
| 17 1457 903 |
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |

(continued)

| Address of Parity Bit Accumulators (Rate 9/10) q = 18 |
|---|
| 14 1907 1854 |
| 15 3601 5748 |
| 16 6056 3266 |
| 17 3322 4085 |
| 0 1768 3244 |
| 1 2149 144 |
| 2 1589 4291 |
| 3 5154 1252 |
| 4 1855 5939 |
| 5 4820 2706 |
| 6 1475 3360 |
| 7 4266 693 |
| 8 4156 2018 |
| 9 2103 752 |
| 10 3710 3853 |
| 11 5123 931 |
| 12 6146 3323 |
| 13 1939 5002 |
| 14 5140 1437 |
| 15 1263 293 |
| 16 5949 4665 |
| 17 4548 6380 |
| 0 3171 4690 |
| 1 5204 2114 |
| 2 6384 5565 |
| 3 5722 1757 |
| 4 2805 6264 |
| 5 1202 2616 |
| 6 1018 3244 |
| 7 4018 5289 |
| 8 2257 3067 |
| 9 2483 3073 |
| 10 1196 5329 |
| 11 649 3918 |
| 12 3791 4581 |
| 13 5028 3803 |
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |

(continued)

| Address of Parity Bit Accumulators (Rate 9/10) q = 18 |
|---|
| 10 5161 2293 |
| 11 4682 3845 |
| 12 3045 643 |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |
| 14 1542 5401 |
| 15 5078 2687 |
| 16 316 1755 |
| 17 3392 1991 |

## Patentansprüche

1. Verfahren zum Codieren von Signalen, wobei das Verfahren Folgendes umfasst:

Codieren einer Eingangsnachricht zu einem Codewort mit einem Codierer (203) des Low Density Parity Check (LDPC), wobei der Schritt des Codierens Folgendes umfasst:

Empfangen von Informationsbit $i_0$, $i_1$, ..., $i_m$, ..., $i_{kldpc-1}$,
Initialisieren von Paritätsbit $p_0$, $p_1$, ..., $p_j$, ..., $P_{nldpc-kldpc-1}$, eines Codes des Low Density Parity Checks (LDPC) mit einer Coderate von 4/5, 3/5, 8/9 oder 9/10 gemäß $p_0 = p_1 = ... = p_{nldpc-kldpc-1} = 0$;
Erzeugen der Paritätsbit auf der Basis der Informationsbit durch Akkumulieren der Informationsbit durch Ausführen von Operationen für jedes Informationsbit $i_m$, $p_j = p_j \oplus i_m$ für jeden entsprechenden Wert von $j$ und nachfolgendes Ausführen der Operation beginnend mit $j = 1$, $p_j = p_j \oplus p_{j-1}$, für $j = 1, 2, ..., n_{ldpc} - k_{ldpc} - 1$ und Erzeugen des Codeworts c der Größe $n_{ldpc}$ als $c = (i_0, i_1, ..., i_{kldpc-1}, p_0, p_1, ..., p_{nldpc-kldpc-1})$, wobei $p_j$ für $j = 1, 2, ..., n_{ldpc}-k_{ldpc}-1$ der Endinhalt von $p_j$ ist,
wobei $j$ eine Paritätsbitadresse gleich {x + m mod 360 x q } mod ($n_{ldpc} - k_{lapc}$) ist, $n_{ldpc}$ eine Codewortgröße gleich 64800 ist, $k_{ldpc}$ eine Informationsblockgröße gleich der Coderate, multipliziert mit $n_{ldpc}$ ist, m eine ganze Zahl ist, die einem bestimmten Informationsbit entspricht, und x eine Paritätsbitadresse bedeutet, wobei jede Zeile der folgenden Tabellen Adressen x für eine bestimmte der Coderaten 4/5, 3/5, 8/9 oder 9/10 entsprechend einer bestimmten der Tabellen spezifiziert, wobei q in der folgenden Tabelle für jede einzelne der Coderaten 4/5, 3/5, 8/9 oder 9/10 spezifiziert wird, wodurch jede sukzessive Zeile der entsprechenden Tabelle für die bestimmte Coderate alle Paritätsbitadressen j für das erste Informationsbit in jeder sukzessiven Gruppe von 360 Informationsbit bereitstellt und jede sukzessive Zeile der Tabelle alle Adressen x bereitstellt, die beim Berechnen der Paritätsbitadressen j für die nächsten Informationsbit gemäß

{ $x + m$ mod $360$ x $q$} mod $(n_{ldpc} - k_{ldpc})$ in jeder sukzessiven Gruppe von 360 Informationsbit verwendet werden:-

Tabelle 1

| Adresse der Paritätsbitakkumulatoren (Rate 4/5) q = 36 |
| --- |
| 0 149 11212 5575 6360 12559 8108 8505 408 10026 12828 |
| 1 5237 490 10677 4998 3869 3734 3092 3509 7703 10305 |
| 2 8742 5553 2820 7085 12116 10485 564 7795 2972 2157 |
| 3 2699 4304 8350 712 2841 3250 4731 10105 517 7516 |
| 4 12067 1351 11992 12191 11267 5161 537 6166 4246 2363 |
| 5 6828 7107 2127 3724 5743 11040 10756 4073 1011 3422 |
| 6 11259 1216 9526 1466 10816 940 3744 2815 11506 11573 |
| 7 4549 11507 1118 1274 11751 5207 7854 12803 4047 6484 |
| 8 8430 4115 9440 413 4455 2262 7915 12402 8579 7052 |
| 9 3885 9126 5665 4505 2343 253 4707 3742 4166 1556 |
| 10 1704 8936 6775 8639 8179 7954 8234 7850 8883 8713 |
| 11 11716 4344 9087 11264 2274 8832 9147 11930 6054 5455 |
| 12 7323 3970 10329 2170 8262 3854 2087 12899 9497 11700 |
| 13 4418 1467 2490 5841 817 11453 533 11217 11962 5251 |
| 14 1541 4525 7976 3457 9536 7725 3788 2982 6307 5997 |
| 15 11484 2739 4023 12107 6516 551 2572 6628 8150 9852 |
| 16 6070 1761 4627 6534 7913 3730 11866 1813 12306 8249 |
| 17 12441 5489 8748 7837 7660 2102 11341 2936 6712 11977 |
| 18 10155 4210 |
| 19 1010 10483 |
| 20 8900 10250 |
| 21 10243 12278 |
| 22 7070 4397 |
| 23 12271 3887 |
| 24 11980 6836 |
| 25 95144356 |
| 26 7137 10281 |
| 27 11881 2526 |
| 28 1969 11477 |
| 29 3044 10921 |
| 30 2236 8724 |
| 31 9104 6340 |
| 32 7342 8582 |
| 33 11675 10405 |
| 34 6467 12775 |
| 3 3186 12198 |
| 0 9621 11445 |
| 1 7486 5611 |
| 2 4319 4879 |
| 3 2196 344 |
| 4 7527 6650 |
| 5 10693 2440 |
| 6 6755 2706 |
| 7 5144 5998 |
| 8 11043 8033 |
| 9 4846 4435 |
| 10 4157 9228 |

(fortgesetzt)

| Adresse der Paritätsbitakkumulatoren (Rate 4/5) q = 36 |
| --- |
| 11 12270 6562 |
| 12 11954 7592 |
| 13 7420 2592 |
| 14 8810 9636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |
| 28 12157 7405 |
| 29 6598 11495 |
| 30 11805 4455 |
| 31 9625 2090 |
| 32 4731 2321 |
| 33 3578 2608 |
| 34 8504 1849 |
| 35 4027 1151 |
| 0 5647 4935 |
| 1 4219 1870 |
| 2 10968 8054 |
| 3 6970 5447 |
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |
| 14 7200 3283 |
| 15 1502 11282 |
| 16 12318 2202 |
| 17 4523 965 |
| 18 9587 7011 |
| 19 2552 2051 |
| 20 12045 10306 |
| 21 11070 5104 |
| 22 6627 6906 |
| 23 9889 2121 |
| 24 829 9701 |

(fortgesetzt)

| Adresse der Paritätsbitakkumulatoren (Rate 4/5) q = 36 |
|---|
| 25 2201 1819 |
| 26 6689 12925 |
| 27 2139 8757 |
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |
| 6 786 3021 |
| 7 710 2086 |
| 8 7423 5601 |
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |
| 18 6838 9011 |
| 19 6174 9410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |
| 28 12323 9511 |
| 29 8231 1752 |
| 30 497 9022 |
| 31 9288 3080 |
| 32 2481 7515 |
| 33 2696 268 |
| 34 4023 12341 |
| 35 7108 5553 |

Tabelle 2

| Adresse der Paritätsbitakkumulatoren (Rate 3/5) q = 72 |
|---|
| 22422 10282 11626 19997 11161 2922 3122 99 5625 17064 8270 179 |
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 14487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 19721 25420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 24210 17833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |
| 4127 2971 17499 16287 22368 21463 7943 18880 5567 8047 23363 6797 |
| 10651 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 10311 25767 17057 3691 |
| 20473 11294 9914 22815 2574 8439 3699 5431 24840 21908 16088 18244 |
| 8208 5755 19059 8541 24924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |
| 1 10502 3002 |
| 2 9368 10761 |
| 3 12299 7828 |
| 4 15048 13362 |
| 5 18444 24640 |
| 6 20775 19175 |
| 7 18970 10971 |
| 8 5329 19982 |
| 9 11296 18655 |
| 10 15046 20659 |
| 11 7300 22140 |
| 12 22029 14477 |

(fortgesetzt)

| Adresse der Paritätsbitakkumulatoren (Rate 3/5) q = 72 |
| --- |
| 13 11129 742 |
| 14 13254 13813 |
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 16071 21617 |
| 25 6393 3725 |
| 26 597 19968 |
| 27 5743 8084 |
| 28 6770 9548 |
| 29 4285 17542 |
| 30 13568 22599 |
| 31 1786 4617 |
| 32 23238 11648 |
| 33 196272030 |
| 34 13601 13458 |
| 35 13740 17328 |
| 36 25012 13944 |
| 37 22513 6687 |
| 38 4934 12587 |
| 39 21197 5133 |
| 40 22705 6938 |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |
| 51 24964 24690 |
| 52 14443 8816 |
| 53 6926 1291 |
| 54 6209 20806 |
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |

(fortgesetzt)

| Adresse der Paritätsbitakkumulatoren (Rate 3/5) q = 72 |
| --- |
| 63 12402 3702 |
| 64 8314 1357 |
| 65 20071 14616 |
| 66 17014 3688 |
| 67 19837 946 |
| 68 15195 12136 |
| 69 7758 22808 |
| 70 3564 2925 |
| 71 3434 7769 |

Tabelle 3

| Adresse der Paritätsbitakkumulatoren (Rate 8/9) q = 20 |
| --- |
| 0 6235 2848 3222 |
| 1 5800 3492 5348 |
| 2 2757 927 90 |
| 3 6961 4516 4739 |
| 4 1172 3237 6264 |
| 5 1927 2425 3683 |
| 6 3714 6309 2495 |
| 7 3070 6342 7154 |
| 8 2428 613 3761 |
| 9 2906 264 5927 |
| 10 1716 1950 4273 |
| 11 4613 6179 3491 |
| 12 4865 3286 6005 |
| 13 1343 5923 3529 |
| 14 4589 4035 2132 |
| 15 1579 3920 6737 |
| 16 1644 1191 5998 |
| 17 1482 2381 4620 |
| 18 6791 6014 6596 |
| 19 2738 5918 3786 |
| 0 5156 6166 |
| 1 1504 4356 |
| 2 130 1904 |
| 3 6027 3187 |
| 4 6718 759 |
| 5 6240 2870 |
| 6 2343 1311 |
| 7 1039 5465 |
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |

(fortgesetzt)

| Adresse der Paritätsbitakkumulatoren (Rate 8/9) q = 20 |
|---|
| 16 3215 4163 |
| 17 973 3117 |
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |
| 12 6528 2899 |
| 13 2243 3616 |
| 14 867 3733 |
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |
| 14 953 4964 |
| 15 4555 4410 |
| 16 4925 4842 |
| 17 5778 600 |
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |

| Adresse der Paritätsbitakkumulatoren (Rate 8/9) q = 20 |
|---|
| 6 1481 6847 |
| 7 4433 1932 |
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 2062 6599 |
| 2 4597 4870 |
| 3 1228 6913 |
| 4 4159 1037 |
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |
| 4 3694 657 |
| 5 1355 110 |
| 6 3329 6736 |
| 7 2505 3407 |
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |

(fortgesetzt)

| Adresse der Paritätsbitakkumulatoren (Rate 8/9) q = 20 |
|---|
| 16 4320 6121 |
| 17 3961 1125 |
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |
| 12 4695 1600 |
| 13 680 2074 |
| 14 1801 6690 |
| 15 2669 1377 |
| 16 2463 1681 |
| 17 5972 5171 |
| 18 5728 4284 |
| 19 1696 1459 |

Tabelle 4

| Adresse der Paritätsbitakkumulatoren (Rate 9/10) q = 18 |
|---|
| 0 5611 2563 2900 |
| 1 5220 3143 4813 |
| 2 2481 834 81 |
| 3 6265 4064 4265 |
| 4 1055 2914 5638 |
| 5 1734 2182 3315 |
| 6 3342 5678 2246 |
| 7 2185 552 3385 |
| 8 2615 236 5334 |
| 9 1546 1755 3846 |
| 10 4154 5561 3142 |
| 11 4382 2957 5400 |
| 12 1209 5329 3179 |
| 13 1421 3528 6063 |
| 14 1480 1072 5398 |
| 15 3843 1777 4369 |
| 16 1334 2145 4163 |
| 17 2368 5055 260 |
| 0 6118 5405 |
| 1 2994 4370 |

| Adresse der Paritätsbitakkumulatoren (Rate 9/10) q = 18 |
|---|
| 2 3405 1669 |
| 3 4640 5550 |
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |
| 0 4165 884 |
| 1 2896 3744 |
| 2 874 2801 |
| 3 3423 5579 |
| 4 3404 3552 |
| 5 2876 5515 |
| 6 516 1719 |
| 7 765 3631 |
| 8 5059 1441 |
| 9 5629 598 |
| 10 5405 473 |
| 11 4724 5210 |
| 12 155 1832 |
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |
| 4 4286 3517 |
| 5 5531 3184 |
| 6 1935 4560 |
| 7 1174 131 |
| 8 3115 956 |
| 9 3129 1088 |
| 10 5238 4440 |
| 11 5722 4280 |
| 12 3540 375 |
| 13 191 2782 |
| 14 906 4432 |
| 15 3225 1111 |

(fortgesetzt)

| Adresse der Paritätsbitakkumulatoren (Rate 9/10) q = 18 |
|---|
| 16 6296 2583 |
| 17 1457 903 |
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |
| 14 1907 1854 |
| 15 3601 5748 |
| 16 6056 3266 |
| 17 3322 4085 |
| 0 1768 3244 |
| 1 2149 144 |
| 2 1589 4291 |
| 3 5154 1252 |
| 4 1855 5939 |
| 5 4820 2706 |
| 6 1475 3360 |
| 7 4266 693 |
| 8 4156 2018 |
| 9 2103 752 |
| 10 3710 3853 |
| 11 5123 931 |
| 12 6146 3323 |
| 13 1939 5002 |
| 14 5140 1437 |
| 15 1263 293 |
| 16 5949 4665 |
| 17 4548 6380 |
| 0 3171 4690 |
| 1 5204 2114 |
| 2 6384 5565 |
| 3 5722 1757 |
| 4 2805 6264 |
| 5 1202 2616 |
| 6 1018 3244 |
| 7 4018 5289 |
| 8 2257 3067 |
| 9 2483 3073 |
| 10 1196 5329 |
| 11 649 3918 |

(fortgesetzt)

| Adresse der Paritätsbitakkumulatoren (Rate 9/10) q = 18 |
|---|
| 12 3791 4581 |
| 13 5028 3803 |
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |
| 10 5161 2293 |
| 11 4682 3845 |
| 12 3045 643 |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |
| 14 1542 5401 |
| 15 5078 2687 |
| 16 316 1755 |
| 17 3392 1991 |

2. Codierer (203) des Low Density Parity Check (LDPC) zum Erzeugen von codierten Signalen, umfassend:

Mittel, ausgelegt zum Empfangen von Informationsbit $i_0$, $i_1$, ..., $i_m$, ..., $i_{kldpc-1}$,
Mittel, ausgelegt zum Initialisieren von Paritätsbit $p_0$, $p_1$, ..., $p_j$, ..., $p_{nldpc-kldpc-1}$, eines Codes des Low Density Parity Checks (LDPC) mit einer Coderate von 4/5, 3/5, 8/9 oder 9/10 gemäß $p_0 = p_1 = ... = p_{nldpc-kldpc-1} = 0$;
Mittel, ausgelegt zum Erzeugen der Paritätsbit auf der Basis der Informationsbit durch Akkumulieren der Informationsbit durch Ausführen von Operationen für jedes Informationsbit $i_m$, $p_j = p_j \oplus i_m$ für jeden entsprechenden

Wert von $j$ und nachfolgendes Ausführen der Operation beginnend mit $j = 1$, $p_j = p_j \oplus p_{j-1}$, für $j = 1, 2, ..., n_{ldpc} - k_{ldpc} - 1$ und

Mittel, ausgelegt zum Erzeugen des Codeworts c der Größe $n_{ldpc}$ als $c = (i_0, i_1, ..., i_{kldpc-1}, p_0, p_1, ..., p_{nldpc-kldpc-1})$, wobei $p_j$ für $j = 1, 2, ..., n_{ldpc} - k_{ldpc}-1$ der Endinhalt von $p_j$ ist,

wobei $j$ eine Paritätsbitadresse gleich $\{x + m \bmod 360 \times q\} \bmod (n_{ldpc} - k_{ldpc})$ ist, $n_{ldpc}$ eine Codewortgröße gleich 64800 ist, $k_{ldpc}$ eine Informationsblockgröße gleich der Coderate, multipliziert mit $n_{ldpc}$ ist, $m$ eine ganze Zahl ist, die einem bestimmten Informationsbit entspricht, und $x$ eine Paritätsbitadresse bedeutet, wobei jede Zeile der folgenden Tabellen Adressen $x$ für eine bestimmte der Coderaten 4/5, 3/5, 8/9 oder 9/10 entsprechend einer bestimmten der Tabellen spezifiziert, wobei $q$ in der folgenden Tabelle für jede einzelne der Coderaten 4/5, 3/5, 8/9 oder 9/10 spezifiziert wird, wodurch jede sukzessive Zeile der entsprechenden Tabelle für die bestimmte Coderate alle Paritätsbitadressen j für das erste Informationsbit in jeder sukzessiven Gruppe von 360 Informationsbit bereitstellt und jede sukzessive Zeile der Tabelle alle Adressen $x$ bereitstellt, die beim Berechnen der Paritätsbitadressen j für die nächsten Informationsbit gemäß $\{x + m \bmod 360 \times q\} \bmod (n_{ldpc} - k_{ldpc})$ in jeder sukzessiven Gruppe von 360 Informationsbit verwendet werden:-

Tabelle 1

| Adresse der Paritätsbitakkumulatoren (Rate 4/5) q = 36 |
|---|
| 0 149 11212 5575 6360 12559 8108 8505 408 10026 12828 |
| 1 5237 490 10677 4998 3869 3734 3092 3509 7703 10305 |
| 2 8742 5553 2820 7085 12116 10485 564 7795 2972 2157 |
| 3 2699 4304 8350 712 2841 3250 4731 10105 517 7516 |
| 4 12067 1351 11992 12191 11267 5161 537 6166 4246 2363 |
| 5 6828 7107 2127 3724 5743 11040 10756 4073 1011 3422 |
| 6 11259 1216 9526 1466 10816 940 3744 2815 11506 11573 |
| 7 4549 11507 1118 1274 11751 5207 7854 12803 4047 6484 |
| 8 8430 4115 9440 413 4455 2262 7915 12402 8579 7052 |
| 9 3885 9126 5665 4505 2343 253 4707 3742 4166 1556 |
| 10 1704 8936 6775 8639 8179 7954 8234 7850 8883 8713 |
| 11 11716 4344 9087 11264 2274 8832 9147 11930 6054 5455 |
| 12 7323 3970 10329 2170 8262 3854 2087 12899 9497 11700 |
| 13 4418 1467 2490 5841 817 11453 533 11217 11962 5251 |
| 14 1541 4525 7976 3457 9536 7725 3788 2982 6307 5997 |
| 15 11484 2739 4023 12107 6516 551 2572 6628 8150 9852 |
| 16 6070 1761 4627 6534 7913 3730 11866 1813 12306 8249 |
| 17 12441 5489 8748 7837 7660 2102 11341 2936 6712 11977 |
| 18 10155 4210 |
| 19 1010 10483 |
| 20 8900 10250 |
| 21 10243 12278 |
| 22 7070 4397 |
| 23 12271 3887 |
| 24 11980 6836 |
| 25 9514 4356 |
| 26 7137 10281 |
| 27 11881 2526 |
| 28 1969 11477 |
| 29 3044 10921 |
| 30 2236 8724 |
| 31 9104 6340 |
| 32 7342 8582 |
| 33 11675 10405 |
| 34 6467 12775 |
| 35 3186 12198 |

(fortgesetzt)

| Adresse der Paritätsbitakkumulatoren (Rate 4/5) q = 36 |
|---|
| 0 9621 11445 |
| 1 7486 5611 |
| 2 4319 4879 |
| 3 2196 344 |
| 4 7527 6650 |
| 5 10693 2440 |
| 6 6755 2706 |
| 7 5144 5998 |
| 8 11043 8033 |
| 9 4846 4435 |
| 10 4157 9228 |
| 11 12270 6562 |
| 12 11954 7592 |
| 13 7420 2592 |
| 14 8810 9636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |
| 28 12157 7405 |
| 29 6598 11495 |
| 30 11805 4455 |
| 31 9625 2090 |
| 32 4731 2321 |
| 33 3578 2608 |
| 34 8504 1849 |
| 35 4027 1151 |
| 0 5647 4935 |
| 1 4219 1870 |
| 2 10968 8054 |
| 3 6970 5447 |
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |

(fortgesetzt)

| Adresse der Paritätsbitakkumulatoren (Rate 4/5) q = 36 |
| --- |
| 14 7200 3283 |
| 15 1502 11282 |
| 16 12318 2202 |
| 17 4523 965 |
| 18 9587 7011 |
| 19 2552 2051 |
| 20 12045 10306 |
| 21 110705104 |
| 22 6627 6906 |
| 23 9889 2121 |
| 24 829 9701 |
| 25 2201 1819 |
| 26 6689 12925 |
| 27 2139 8757 |
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |
| 6 786 3021 |
| 7 710 2086 |
| 8 7423 5601 |
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |
| 18 6838 9011 |
| 19 6174 9410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |

(fortgesetzt)

| Adresse der Paritätsbitakkumulatoren (Rate 4/5) q = 36 |
|---|
| 28 12323 9511 |
| 29 8231 1752 |
| 30 497 9022 |
| 31 9288 3080 |
| 32 2481 7515 |
| 33 2696 268 |
| 34 4023 12341 |
| 35 7108 5553 |

Tabelle 2

| Adresse der Paritätsbitakkumulatoren (Rate 3/5) q = 72 |
|---|
| 22422 10282 11626 19997 11161 2922 3122 99 5625 17064 8270 179 |
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 14487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 19721 25420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 24210 17833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |
| 4127 2971 17499 16287 22368 21463 7943 18880 5567 8047 23363 6797 |
| 10651 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 10311 25767 17057 3691 |
| 20473 11294 9914 22815 2574 8439 3699 5431 24840 21908 16088 18244 |
| 8208 5755 19059 8541 24924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |

(fortgesetzt)

| Adresse der Paritätsbitakkumulatoren (Rate 3/5) q = 72 |
|---|
| 1 10502 3002 |
| 2 9368 10761 |
| 3 12299 7828 |
| 4 15048 13362 |
| 5 18444 24640 |
| 6 20775 19175 |
| 7 18970 10971 |
| 8 5329 19982 |
| 9 11296 18655 |
| 10 15046 20659 |
| 11 7300 22140 |
| 12 22029 14477 |
| 13 11129 742 |
| 14 13254 13813 |
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 16071 21617 |
| 25 6393 3725 |
| 26 597 19968 |
| 27 5743 8084 |
| 28 6770 9548 |
| 29 4285 17542 |
| 30 13568 22599 |
| 31 1786 4617 |
| 32 23238 11648 |
| 33 19627 2030 |
| 34 13601 13458 |
| 35 13740 17328 |
| 36 25012 13944 |
| 37 22513 6687 |
| 38 4934 12587 |
| 39 21197 5133 |
| 40 22705 6938 |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |

(fortgesetzt)

| Adresse der Paritätsbitakkumulatoren (Rate 3/5) q = 72 |
|---|
| 51 24964 24690 |
| 52 14443 8816 |
| 53 6926 1291 |
| 54 6209 20806 |
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |
| 63 12402 3702 |
| 64 8314 1357 |
| 65 20071 14616 |
| 66 17014 3688 |
| 67 19837 946 |
| 68 15195 12136 |
| 69 7758 22808 |
| 70 3564 2925 |
| 71 3434 7769 |

Tabelle 3

| Adresse der Paritätsbitakkumulatoren (Rate 8/9) q = 20 |
|---|
| 0 6235 2848 3222 |
| 1 5800 3492 5348 |
| 2 2757 927 90 |
| 3 6961 4516 4739 |
| 4 1172 3237 6264 |
| 5 1927 2425 3683 |
| 6 3714 6309 2495 |
| 7 3070 6342 7154 |
| 8 2428 613 3761 |
| 9 2906 264 5927 |
| 10 1716 1950 4273 |
| 11 4613 6179 3491 |
| 12 4865 3286 6005 |
| 13 1343 5923 3529 |
| 14 4589 4035 2132 |
| 15 1579 3920 6737 |
| 16 1644 1191 5998 |
| 17 1482 2381 4620 |
| 18 6791 6014 6596 |
| 19 2738 5918 3786 |
| 0 5156 6166 |
| 1 1504 4356 |
| 2 130 1904 |
| 3 6027 3187 |

(fortgesetzt)

| Adresse der Paritätsbitakkumulatoren (Rate 8/9) q = 20 |
|---|
| 4 6718 759 |
| 5 6240 2870 |
| 6 2343 1311 |
| 7 1039 5465 |
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |
| 16 3215 4163 |
| 17 973 3117 |
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |
| 12 6528 2899 |
| 13 2243 3616 |
| 14 867 3733 |
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |

(fortgesetzt)

| Adresse der Paritätsbitakkumulatoren (Rate 8/9) q = 20 |
|---|
| 14 953 4964 |
| 15 4555 4410 |
| 16 4925 4842 |
| 17 5778 600 |
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |
| 6 1481 6847 |
| 7 4433 1932 |
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 2062 6599 |
| 2 4597 4870 |
| 3 1228 6913 |
| 4 4159 1037 |
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |

(fortgesetzt)

| Adresse der Paritätsbitakkumulatoren (Rate 8/9) q = 20 |
|---|
| 4 3694 657 |
| 5 1355 110 |
| 6 3329 6736 |
| 7 2505 3407 |
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |
| 16 4320 6121 |
| 17 3961 1125 |
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |
| 12 4695 1600 |
| 13 680 2074 |
| 14 1801 6690 |
| 15 2669 1377 |
| 16 2463 1681 |
| 17 5972 5171 |
| 18 5728 4284 |
| 19 1696 1459 |

Tabelle 4

| Adresse der Paritätsbitakkumulatoren (Rate 9/10) q = 18 |
|---|
| 0 5611 2563 2900 |
| 1 5220 3143 4813 |
| 2 2481 834 81 |
| 3 6265 4064 4265 |
| 4 1055 2914 5638 |
| 5 1734 2182 3315 |
| 6 3342 5678 2246 |
| 7 2185 552 3385 |

(fortgesetzt)

| Adresse der Paritätsbitakkumulatoren (Rate 9/10) q = 18 |
|---|
| 8 2615 236 5334 |
| 9 1546 1755 3846 |
| 10 4154 5561 3142 |
| 11 4382 2957 5400 |
| 12 1209 5329 3179 |
| 13 1421 3528 6063 |
| 14 1480 1072 5398 |
| 15 3843 1777 4369 |
| 16 1334 2145 4163 |
| 17 2368 5055 260 |
| 0 6118 5405 |
| 1 2994 4370 |
| 2 3405 1669 |
| 3 4640 5550 |
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |
| 0 4165 884 |
| 1 2896 3744 |
| 2 874 2801 |
| 3 3423 5579 |
| 4 3404 3552 |
| 5 2876 5515 |
| 6 516 1719 |
| 7 765 3631 |
| 8 5059 1441 |
| 9 5629 598 |
| 10 5405 473 |
| 11 4724 5210 |
| 12 155 1832 |
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |

(fortgesetzt)

| Adresse der Paritätsbitakkumulatoren (Rate 9/10) q = 18 |
|---|
| 4 4286 3517 |
| 5 5531 3184 |
| 6 1935 4560 |
| 7 1174 131 |
| 8 3115 956 |
| 9 3129 1088 |
| 10 5238 4440 |
| 11 5722 4280 |
| 12 3540 375 |
| 13 191 2782 |
| 14 906 4432 |
| 15 3225 1111 |
| 16 6296 2583 |
| 17 1457 903 |
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |
| 14 1907 1854 |
| 15 3601 5748 |
| 16 6056 3266 |
| 17 3322 4085 |
| 0 1768 3244 |
| 1 2149 144 |
| 2 1589 4291 |
| 3 5154 1252 |
| 4 1855 5939 |
| 5 4820 2706 |
| 6 1475 3360 |
| 7 4266 693 |
| 8 4156 2018 |
| 9 2103 752 |
| 10 3710 3853 |
| 11 5123 931 |
| 12 6146 3323 |
| 13 19395002 |
| 14 5140 1437 |
| 15 1263 293 |
| 16 5949 4665 |
| 17 4548 6380 |

(fortgesetzt)

| Adresse der Paritätsbitakkumulatoren (Rate 9/10) q = 18 |
| --- |
| 0 3171 4690 |
| 1 5204 2114 |
| 2 6384 5565 |
| 3 5722 1757 |
| 4 2805 6264 |
| 5 1202 2616 |
| 6 1018 3244 |
| 7 4018 5289 |
| 8 2257 3067 |
| 9 2483 3073 |
| 10 1196 5329 |
| 11 649 3918 |
| 12 3791 4581 |
| 13 5028 3803 |
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |
| 10 5161 2293 |
| 11 4682 3845 |
| 12 3045 643 |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |

(fortgesetzt)

| Adresse der Paritätsbitakkumulatoren (Rate 9/10) q = 18 |
| --- |
| 14 1542 5401 |
| 15 5078 2687 |
| 16 316 1755 |
| 17 3392 1991 |

**Revendications**

1. Procédé pour coder des signaux, le procédé comprenant l'étape consistant à :

coder un message d'entrée pour former un mot de code au moyen d'un codeur à contrôle de parité de faible densité (LDPC) (203), laquelle étape consistant à coder comprend les étapes consistant à :

recevoir des bits d'information, $i_0, i_1, ..., i_m, ..., i_{k_{ldpc}-1}$ ;
initialiser des bits de parité, $p_0, p_1, ..., P_j, ..., P_{n_{ldpc}-k_{ldpc}-1}$, d'un code de contrôle de parité de faible densité (LDPC) possédant un taux de code de 4/5, 3/5, 8/9 ou 9/10 conformément à $p_0 = p_1 = ... = p_{n_{ldpc}-k_{ldpc}-1} = 0$ ;
générer, sur la base des bits d'information, les bits de parité en accumulant les bits d'information en effectuant des opérations pour chaque bit d'information, $i_m$, $p_j = p_j \oplus i_m$ pour chaque valeur correspondante de $j$, et effectuer ensuite l'opération, en partant de $j = 1$, $p_j = p_j \oplus p_{j-1}$, pour $j = 1, 2, ..., n_{ldpc} - k_{ldpc} - 1$ ; et générer le mot de code, $c$, de taille $n_{ldpc}$ sous la forme $c = (i_0, i_1, ..., i_{k_{ldpc}-1}, p_0, p_1, ..., p_{n_{ldpc}-k_{ldpc}-1})$ où $p_j$, pour $j = 1, 2, ..., n_{ldpc}-k_{ldpc}-1$, est le contenu final de $p_j$,
procédé dans lequel $j$ est une adresse de bit de parité égale à $\{x + m \bmod 360 \times q\} \bmod (n_{ldpc} - k_{ldpc})$, $n_{ldpc}$ est une taille de mot de code égale à 64800, $k_{ldpc}$ est une taille de bloc d'information égale au taux de code multiplié par $n_{ldpc}$, $m$ est un entier correspondant à un bit d'information particulier, et $x$ désigne une adresse de bit de parité, chaque ligne des tables qui suivent précisant des adresses $x$ pour un taux de code particulier parmi les taux de code 4/5, 3/5, 8/9 ou 9/10 correspondant à une table particulière parmi les tables, q est précisé dans la table qui suit pour chacun des taux de code 4/5, 3/5, 8/9 ou 9/10, de telle sorte que chaque ligne successive de la table correspondante pour le taux de code particulier fournisse toutes les adresses de bit de parité $j$ pour le premier bit d'information dans chaque groupe successif de 360 bits d'information, et chaque ligne successive de la table fournisse toutes les adresses $x$ utilisées pour calculer des adresses de bit de parité, $j$, pour les bits d'information suivants conformément à $\{x + m \bmod 360 \times q\} \bmod (n_{ldpc} - k_{ldpc})$ dans chaque groupe successif de 360 bits d'information :-

Table 1

| Adresse des accumulateurs de bits de parité (Taux 4/5) q = 36 |
| --- |
| 0 149 11212 5575 6360 12559 8108 8505 408 10026 12828 |
| 1 5237 490 10677 4998 3869 3734 3092 3509 7703 10305 |
| 2 8742 5553 2820 7085 12116 10485 564 7795 2972 2157 |
| 3 2699 4304 8350 712 2841 3250 4731 10105 517 7516 |
| 4 12067 1351 11992 12191 11267 5161 537 6166 4246 2363 |
| 5 6828 7107 2127 3724 5743 11040 10756 4073 1011 3422 |
| 6 11259 1216 9526 1466 10816 940 3744 2815 11506 11573 |
| 7 4549 11507 1118 1274 11751 5207 7854 12803 4047 6484 |
| 8 8430 4115 9440 413 4455 2262 7915 12402 8579 7052 |
| 9 3885 9126 5665 4505 2343 253 4707 3742 4166 1556 |
| 10 1704 8936 6775 8639 8179 7954 8234 7850 8883 8713 |
| 11 11716 4344 9087 11264 2274 8832 9147 11930 6054 5455 |
| 12 7323 3970 10329 2170 8262 3854 2087 12899 9497 11700 |
| 13 4418 1467 2490 5841 817 11453 533 11217 11962 5251 |
| 14 1541 4525 7976 3457 9536 7725 3788 2982 6307 5997 |
| 15 11484 2739 4023 12107 6516 551 2572 6628 8150 9852 |
| 16 6070 1761 4627 6534 7913 3730 11866 1813 12306 8249 |

(suite)

| Adresse des accumulateurs de bits de parité (Taux 4/5) q = 36 |
|---|
| 17 12441 5489 8748 7837 7660 2102 11341 2936 6712 11977 |
| 18 10155 4210 |
| 19 1010 10483 |
| 20 8900 10250 |
| 21 10243 12278 |
| 22 7070 4397 |
| 23 12271 3887 |
| 24 11980 6836 |
| 25 9514 4356 |
| 26 7137 10281 |
| 27 11881 2526 |
| 28 1969 11477 |
| 29 3044 10921 |
| 30 2236 8724 |
| 31 9104 6340 |
| 32 7342 8582 |
| 33 11675 10405 |
| 34 6467 12775 |
| 35 3186 12198 |
| 0 9621 11445 |
| 1 7486 5611 |
| 2 4319 4879 |
| 3 2196 344 |
| 4 7527 6650 |
| 5 10693 2440 |
| 6 6755 2706 |
| 7 5144 5998 |
| 8 11043 8033 |
| 9 4846 4435 |
| 10 4157 9228 |
| 11 12270 6562 |
| 12 1192 7592 |
| 13 7420 2592 |
| 14 8810 9636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |
| 28 12157 7405 |
| 29 6598 11495 |
| 30 11805 4455 |

(suite)

| Adresse des accumulateurs de bits de parité (Taux 4/5) q = 36 |
|---|
| 31 9625 2090 |
| 32 4731 2321 |
| 33 3578 2608 |
| 34 8504 1849 |
| 35 4027 1151 |
| 0 5647 4935 |
| 1 4219 1870 |
| 2 10968 8054 |
| 3 6970 5447 |
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |
| 14 7200 3283 |
| 15 1502 11282 |
| 16 12318 2202 |
| 17 4523 965 |
| 18 9587 7011 |
| 19 2552 2051 |
| 20 12045 10306 |
| 21 11070 5104 |
| 22 6627 6906 |
| 23 9889 2121 |
| 24 829 9701 |
| 25 2201 1819 |
| 26 6689 12925 |
| 27 2139 8757 |
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |
| 6 786 3021 |
| 7 710 2086 |
| 8 7423 5601 |

(suite)

| Adresse des accumulateurs de bits de parité (Taux 4/5) q = 36 |
|---|
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |
| 18 6838 9011 |
| 19 6174 9410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |
| 28 12323 9511 |
| 29 8231 1752 |
| 30 497 9022 |
| 31 9288 3080 |
| 32 2481 7515 |
| 33 2696 268 |
| 34 4023 12341 |
| 35 7108 5553 |

Table 2

| Adresse des accumulateurs de bits de parité (Taux 3/5) q = 72 |
|---|
| 22422 10282 11626 19997 11161 2922 3122 99 5625 17064 8270 179 |
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 1487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 19721 25420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |

(suite)

| Adresse des accumulateurs de bits de parité (Taux 3/5) q = 72 |
|---|
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 24210 17833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |
| 4127 2971 17499 16287 22368 21463 7943 18880 5567 8047 23363 6797 |
| 10651 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 10311 25767 17057 3691 |
| 20473 11294 9914 22815 2574 8439 3699 5431 24840 21908 16088 18244 |
| 8208 5755 19059 8541 24924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |
| 1 10502 3002 |
| 2 9368 10761 |
| 3 12299 7828 |
| 4 15048 13362 |
| 5 18444 24640 |
| 6 20775 19175 |
| 7 18970 10971 |
| 8 5329 19982 |
| 9 11296 18655 |
| 10 15046 20659 |
| 11 7300 22140 |
| 12 22029 14477 |
| 13 11129 742 |
| 14 13254 13813 |
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 16071 21617 |
| 25 6393 3725 |
| 26 597 19968 |
| 27 5743 8084 |
| 28 6770 9548 |
| 29 4285 17542 |
| 30 13568 22599 |
| 31 1786 4617 |

(suite)

| Adresse des accumulateurs de bits de parité (Taux 3/5) q = 72 |
|---|
| 32 23238 11648 |
| 33 19627 2030 |
| 34 13601 13458 |
| 35 13740 17328 |
| 36 25012 13944 |
| 37 22513 6687 |
| 38 4934 12587 |
| 39 21197 5133 |
| 40 22705 6938 |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |
| 51 24964 24690 |
| 52 14443 8816 |
| 53 6926 1291 |
| 54 6209 20806 |
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |
| 63 12402 3702 |
| 64 8314 1357 |
| 65 20071 14616 |
| 66 17014 3688 |
| 67 19837 946 |
| 68 15195 12136 |
| 69 7758 22808 |
| 70 3564 2925 |
| 71 3434 7769 |

Table 3

| Adresse des accumulateurs de bits de parité (Taux 8/9) q = 20 |
|---|
| 0 6235 2848 3222 |
| 1 5800 3492 5348 |
| 2 2757 927 90 |
| 3 6961 4516 4739 |
| 4 1172 3237 6264 |

(suite)

| Adresse des accumulateurs de bits de parité (Taux 8/9) q = 20 |
|---|
| 5 1927 2425 3683 |
| 6 3714 6309 2495 |
| 7 3070 6342 7154 |
| 8 2428 613 3761 |
| 9 2906 264 5927 |
| 10 1716 1950 4273 |
| 11 4613 6179 3491 |
| 12 4865 3286 6005 |
| 13 1343 5923 3529 |
| 14 4589 4035 2132 |
| 15 1579 3920 6737 |
| 16 1644 1191 5998 |
| 17 1482 2381 4620 |
| 18 6791 6014 6596 |
| 19 2738 5918 3786 |
| 0 5156 6166 |
| 1 1504 4356 |
| 2 130 1904 |
| 3 6027 3187 |
| 4 6718 759 |
| 5 6240 2870 |
| 6 2343 1311 |
| 7 1039 5465 |
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |
| 16 3215 4163 |
| 17 973 3117 |
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |
| 12 6528 2899 |
| 13 2243 3616 |
| 14 867 3733 |

(suite)

| Adresse des accumulateurs de bits de parité (Taux 8/9) q = 20 |
|---|
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |
| 14 953 4964 |
| 15 4555 4410 |
| 16 4925 4842 |
| 17 5778 600 |
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |
| 6 1481 6847 |
| 7 4433 1932 |
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 2062 6599 |
| 2 4597 4870 |
| 3 1228 6913 |
| 4 4159 1037 |

(suite)

| Adresse des accumulateurs de bits de parité (Taux 8/9) q = 20 |
|---|
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |
| 4 3694 657 |
| 5 1355 110 |
| 6 3329 6736 |
| 7 2505 3407 |
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |
| 16 4320 6121 |
| 17 3961 1125 |
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |
| 12 4695 1600 |
| 13 680 2074 |
| 14 1801 6690 |

(suite)

| Adresse des accumulateurs de bits de parité (Taux 8/9) q = 20 |
|---|
| 15 2669 1377 |
| 16 2463 1681 |
| 17 5972 5171 |
| 18 5728 4284 |
| 19 1696 1459 |

Table 4

| Adresse des accumulateurs de bits de parité (Taux 9/10) q = 18 |
|---|
| 0 5611 2563 2900 |
| 1 5220 3143 4813 |
| 2 2481 83481 |
| 3 6265 4064 4265 |
| 4 1055 2914 5638 |
| 5 1734 2182 3315 |
| 6 3342 5678 2246 |
| 7 2185 552 3385 |
| 8 2615 236 5334 |
| 9 1546 1755 3846 |
| 10 4154 5561 3142 |
| 11 4382 2957 5400 |
| 12 1209 5329 3179 |
| 13 1421 3528 6063 |
| 14 1480 1072 5398 |
| 15 3843 1777 4369 |
| 16 1334 2145 4163 |
| 17 2368 5055 260 |
| 0 6118 5405 |
| 1 2994 4370 |
| 2 3405 1669 |
| 3 4640 5550 |
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |
| 0 4165 884 |
| 1 2896 3744 |
| 2 874 2801 |

(suite)

| Adresse des accumulateurs de bits de parité (Taux 9/10) q = 18 |
|---|
| 3 3423 5579 |
| 4 3404 3552 |
| 5 2876 5515 |
| 6 516 1719 |
| 7 765 3631 |
| 8 5059 1441 |
| 9 5629 598 |
| 10 5405 473 |
| 11 4724 5210 |
| 12 155 1832 |
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |
| 4 4286 3517 |
| 5 5531 3184 |
| 6 1935 4560 |
| 7 1174 131 |
| 8 3115 956 |
| 9 3129 1088 |
| 10 5238 4440 |
| 11 5722 4280 |
| 12 3540 375 |
| 13 191 2782 |
| 14 906 4432 |
| 15 3225 1111 |
| 16 6296 2583 |
| 17 1457 903 |
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |
| 14 1907 1854 |
| 15 3601 5748 |
| 16 6056 3266 |

(suite)

| Adresse des accumulateurs de bits de parité (Taux 9/10) q = 18 |
|---|
| 17 3322 4085 |
| 0 1768 3244 |
| 1 2149 144 |
| 2 1589 4291 |
| 3 5154 1252 |
| 4 1855 5939 |
| 5 4820 2706 |
| 6 1475 3360 |
| 7 4266 693 |
| 8 4156 2018 |
| 9 2103 752 |
| 10 3710 3853 |
| 11 5123 931 |
| 12 6146 3323 |
| 13 1939 5002 |
| 14 5140 1437 |
| 15 1263 293 |
| 16 5949 4665 |
| 17 4548 6380 |
| 0 3171 4690 |
| 1 5204 2114 |
| 2 6384 5565 |
| 3 5722 1757 |
| 4 2805 6264 |
| 5 1202 2616 |
| 6 10183244 |
| 7 4018 5289 |
| 8 2257 3067 |
| 9 2483 3073 |
| 10 1196 5329 |
| 11 649 3918 |
| 12 3791 4581 |
| 13 5028 3803 |
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |
| 10 5161 2293 |
| 11 4682 3845 |
| 12 3045 643 |

(suite)

| Adresse des accumulateurs de bits de parité (Taux 9/10) q = 18 |
| --- |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |
| 14 1542 5401 |
| 15 5078 2687 |
| 16 316 1755 |
| 17 3392 1991 |

2. Codeur à contrôle de parité de faible densité (LDPC) (203), le codeur comprenant :

un moyen conçu pour recevoir des bits d'information, $i_0$, $i_1$, ..., $i_m$, ..., $i_{kldpc-1}$ ;

un moyen conçu pour initialiser des bits de parité, $p_0$, $p_1$, ..., $p_j$, ..., $p_{nldpc-kldpc-1}$, d'un code de contrôle de parité de faible densité (LDPC) possédant un taux de code de 4/5, 3/5, 8/9 ou 9/10 conformément à $p_0 = p_1 = ... = p_{nldpc-kldpc-1} = 0$;

un moyen pour générer, sur la base des bits d'information, les bits de parité en accumulant les bits d'information en effectuant des opérations pour chaque bit d'information, $i_m$, $p_j = p_j \oplus i_m$ pour chaque valeur correspondante de $j$, et effectuer ensuite l'opération, en partant de $j = 1$, $p_j = p_j \oplus p_{j-1}$, pour $j = 1, 2, ..., n_{ldpc}-k_{ldpc}-1$ ; et

un moyen pour générer le mot de code, c, de taille $n_{ldpc}$ sous la forme $c = (i_0, i_1, ..., i_{kldpc-1}, p_0, p_1, ..., p_{nldpc-kldpc-1})$ où $p_j$, pour $j = 1, 2, ..., n_{ldpc}-k_{ldpc}-1$, est le contenu final de $p_j$,

codeur dans lequel $j$ est une adresse de bit de parité égale à $\{x + m \bmod 360 \times q\} \bmod (n_{ldpc}-k_{ldpc})$, $n_{ldpc}$ est une taille de mot de code égale à 64800, $k_{ldpc}$ est une taille de bloc d'information égale au taux de code multiplié par $n_{ldpc}$, $m$ est un entier correspondant à un bit d'information particulier, et x désigne une adresse de bit de parité, chaque ligne des tables qui suivent précisant des adresses x pour un taux de code particulier parmi les taux de code 4/5, 3/5, 8/9 ou 9/10 correspondant à une table particulière parmi les tables, $q$ est précisé dans la table qui suit pour chacun des taux de code 4/5, 3/5, 8/9 ou 9/10, de telle sorte que chaque ligne successive de la table correspondante pour le taux de code particulier fournisse toutes les adresses de bit de parité $j$ pour le premier bit d'information dans chaque groupe successif de 360 bits d'information, et chaque ligne successive de la table fournisse toutes les adresses $x$ utilisées pour calculer des adresses de bit de parité, $j$, pour les bits d'information suivants conformément à $\{x + m \bmod 360 \times q\} \bmod(n_{ldpc}-k_{ldpc})$ dans chaque groupe successif de 360 bits d'information :-

Table 1

| Adresse des accumulateurs de bits de parité (Taux 4/5) q = 36 |
| --- |
| 0 149 11212 5575 6360 12559 8108 8505 408 10026 12828 |
| 1 5237 490 10677 4998 3869 3734 3092 3509 7703 10305 |

(suite)

| Adresse des accumulateurs de bits de parité (Taux 4/5) q = 36 |
|---|
| 2 8742 5553 2820 7085 12116 10485 564 7795 2972 2157 |
| |

3 2699 4304 8350 712 2841 3250 4731 10105 517 7516
4 12067 1351 11992 12191 11267 5161 537 6166 4246 2363
5 6828 7107 2127 3724 5743 11040 10756 4073 1011 3422
6 11259 1216 9526 1466 10816 940 3744 2815 11506 11573
7 4549 11507 1118 1274 11751 5207 7854 12803 4047 6484
8 8430 4115 9440 413 4455 2262 7915 12402 8579 7052
9 3885 9126 5665 4505 2343 253 4707 3742 4166 1556
10 1704 8936 6775 8639 8179 7954 8234 7850 8883 8713
11 11716 4344 9087 11264 2274 8832 9147 11930 6054 5455
12 7323 3970 10329 2170 8262 3854 2087 12899 9497 11700
13 4418 1467 2490 5841 817 11453 533 11217 11961 5251
14 1541 4525 7976 3457 9536 7725 3788 2982 6307 5997
15 11484 2739 4023 12107 6516 5512572 6628 8150 9852
16 6070 1761 4627 6534 7913 3730 11866 1813 12306 8249
17 12441 5489 8748 7837 7660 2102 11341 2936 6712 11977
18 10155 4210
19 1010 10483
20 8900 10250
21 10243 12278
22 7070 4397
23 12271 3887
24 11980 6836
25 9514 4356
26 7137 10281
27 11881 2526
28 1969 11477
29 3044 10921
30 2236 8724
31 9104 6340
32 7342 8582
33 11675 10405
34 6467 12775
35 3186 12198
0 9621 11445
1 7486 5611
2 4319 4879
3 2196 344
4 7527 6650
5 10693 2440
6 6755 2706
7 5144 5998
8 11043 8033
9 4846 4435
10 4157 9228
11 12270 6562
12 11954 7592
13 7420 2592

(suite)

| Adresse des accumulateurs de bits de parité (Taux 4/5) q = 36 |
|---|
| 14 8810 9636 |
| 15 689 5430 |
| 16 920 1304 |
| 17 1253 11934 |
| 18 9559 6016 |
| 19 312 7589 |
| 20 4439 4197 |
| 21 4002 9555 |
| 22 12232 7779 |
| 23 1494 8782 |
| 24 10749 3969 |
| 25 4368 3479 |
| 26 6316 5342 |
| 27 2455 3493 |
| 28 12157 7405 |
| 29 6598 11495 |
| 30 11805 4455 |
| 31 9625 2090 |
| 32 47312321 |
| 33 3578 2608 |
| 34 8504 1849 |
| 35 4027 1151 |
| 0 5647 4935 |
| 1 4219 1870 |
| 2 10968 8054 |
| 3 6970 5447 |
| 4 3217 5638 |
| 5 8972 669 |
| 6 5618 12472 |
| 7 1457 1280 |
| 8 8868 3883 |
| 9 8866 1224 |
| 10 8371 5972 |
| 11 266 4405 |
| 12 3706 3244 |
| 13 6039 5844 |
| 14 7200 3283 |
| 15 1502 11282 |
| 16 12318 2202 |
| 17 4523 965 |
| 18 9587 7011 |
| 19 2552 2051 |
| 20 12045 10306 |
| 21 11070 5104 |
| 22 6627 6906 |
| 23 9889 2121 |
| 24 829 9701 |
| 25 2201 1819 |
| 26 6689 12925 |
| 27 2139 8757 |

(suite)

| Adresse des accumulateurs de bits de parité (Taux 4/5) q = 36 |
|---|
| 28 12004 5948 |
| 29 8704 3191 |
| 30 8171 10933 |
| 31 6297 7116 |
| 32 616 7146 |
| 33 5142 9761 |
| 34 10377 8138 |
| 35 7616 5811 |
| 0 7285 9863 |
| 1 7764 10867 |
| 2 12343 9019 |
| 3 4414 8331 |
| 4 3464 642 |
| 5 6960 2039 |
| 6 786 3021 |
| 7 710 2086 |
| 8 7423 5601 |
| 9 8120 4885 |
| 10 12385 11990 |
| 11 9739 10034 |
| 12 424 10162 |
| 13 1347 7597 |
| 14 1450 112 |
| 15 7965 8478 |
| 16 8945 7397 |
| 17 6590 8316 |
| 18 6838 9011 |
| 19 61749410 |
| 20 255 113 |
| 21 6197 5835 |
| 22 12902 3844 |
| 23 4377 3505 |
| 24 5478 8672 |
| 25 4453 2132 |
| 26 9724 1380 |
| 27 12131 11526 |
| 28 12323 9511 |
| 29 8231 1752 |
| 30 497 9022 |
| 31 9288 3080 |
| 32 2481 7515 |
| 33 2696 268 |
| 34 4023 12341 |
| 35 7108 5553 |

Table 2

| Adresse des accumulateurs de bits de parité (Taux 3/5) q = 72 |
|---|
| 22422 10282 11626 19997 11161 2922 3122 99 5625 17064 8270 179 |

(suite)

| Adresse des accumulateurs de bits de parité (Taux 3/5) q = 72 |
|---|
| 25087 16218 17015 828 20041 25656 4186 11629 22599 17305 22515 6463 |
| 11049 22853 25706 14388 5500 19245 8732 2177 13555 11346 17265 3069 |
| 16581 22225 12563 19717 23577 11555 25496 6853 25403 5218 15925 21766 |
| 16529 14487 7643 10715 17442 11119 5679 14155 24213 21000 1116 15620 |
| 5340 8636 16693 1434 5635 6516 9482 20189 1066 15013 25361 14243 |
| 18506 22236 20912 8952 5421 15691 6126 21595 500 6904 13059 6802 |
| 8433 4694 5524 14216 3685 19721 25420 9937 23813 9047 25651 16826 |
| 21500 24814 6344 17382 7064 13929 4004 16552 12818 8720 5286 2206 |
| 22517 2429 19065 2921 21611 1873 7507 5661 23006 23128 20543 19777 |
| 1770 4636 20900 14931 9247 12340 11008 12966 4471 2731 16445 791 |
| 6635 14556 18865 22421 22124 12697 9803 25485 7744 18254 11313 9004 |
| 19982 23963 18912 7206 12500 4382 20067 6177 21007 1195 23547 24837 |
| 756 11158 14646 20534 3647 17728 11676 11843 12937 4402 8261 22944 |
| 9306 24009 10012 11081 3746 24325 8060 19826 842 8836 2898 5019 |
| 7575 7455 25244 4736 14400 22981 5543 8006 24203 13053 1120 5128 |
| 3482 9270 13059 15825 7453 23747 3656 24585 16542 17507 22462 14670 |
| 15627 15290 4198 22748 5842 13395 23918 16985 14929 3726 25350 24157 |
| 24896 16365 16423 13461 16615 8107 24741 3604 25904 8716 9604 20365 |
| 3729 17245 18448 9862 20831 25326 20517 24618 13282 5099 14183 8804 |
| 16455 17646 15376 18194 25528 1777 6066 21855 14372 12517 4488 17490 |
| 1400 8135 23375 20879 8476 4084 12936 25536 22309 16582 6402 24360 |
| 25119 23586 128 4761 10443 22536 8607 9752 25446 15053 1856 4040 |
| 377 21160 13474 5451 17170 5938 10256 11972 24210 17833 22047 16108 |
| 13075 9648 24546 13150 23867 7309 19798 2988 16858 4825 23950 15125 |
| 20526 3553 11525 23366 2452 17626 19265 20172 18060 24593 13255 1552 |
| 18839 21132 20119 15214 14705 7096 10174 5663 18651 19700 12524 14033 |
| 4127 2971 17499 16287 22368 21463 7943 18880 5567 8047 23363 6797 |
| 10651 24471 14325 4081 7258 4949 7044 1078 797 22910 20474 4318 |
| 21374 13231 22985 5056 3821 23718 14178 9978 19030 23594 8895 25358 |
| 6199 22056 7749 13310 3999 23697 16445 22636 5225 22437 24153 9442 |
| 7978 12177 2893 20778 3175 8645 11863 24623 10311 25767 17057 3691 |
| 20473 11294 9914 22815 2574 8439 3699 5431 24840 21908 16088 18244 |
| 8208 5755 19059 8541 24924 6454 11234 10492 16406 10831 11436 9649 |
| 16264 11275 24953 2347 12667 19190 7257 7174 24819 2938 2522 11749 |
| 3627 5969 13862 1538 23176 6353 2855 17720 2472 7428 573 15036 |
| 0 18539 18661 |
| 1 10502 3002 |
| 2 9368 10761 |
| 3 12299 7828 |
| 4 15048 13362 |
| 5 18444 24640 |
| 6 20775 19175 |
| 7 18970 10971 |
| 8 5329 19982 |
| 9 11296 18655 |
| 10 15046 20659 |
| 11 7300 22140 |
| 12 22029 14477 |
| 13 11129 742 |
| 14 13254 13813 |

(suite)

| Adresse des accumulateurs de bits de parité (Taux 3/5) q = 72 |
|---|
| 15 19234 13273 |
| 16 6079 21122 |
| 17 22782 5828 |
| 18 19775 4247 |
| 19 1660 19413 |
| 20 4403 3649 |
| 21 13371 25851 |
| 22 22770 21784 |
| 23 10757 14131 |
| 24 16071 21617 |
| 25 6393 3725 |
| 26 597 19968 |
| 27 5743 8084 |
| 28 6770 9548 |
| 29 4285 17542 |
| 30 13568 22599 |
| 31 1786 4617 |
| 32 23238 11648 |
| 33 19627 2030 |
| 34 13601 13458 |
| 35 13740 17328 |
| 36 25012 13944 |
| 37 2253 6687 |
| 38 4934 12587 |
| 39 21197 5133 |
| 40 22705 6938 |
| 41 7534 24633 |
| 42 24400 12797 |
| 43 21911 25712 |
| 44 12039 1140 |
| 45 24306 1021 |
| 46 14012 20747 |
| 47 11265 15219 |
| 48 4670 15531 |
| 49 9417 14359 |
| 50 2415 6504 |
| 51 24964 24690 |
| 52 14443 8816 |
| 53 6926 1291 |
| 54 6209 20806 |
| 55 13915 4079 |
| 56 24410 13196 |
| 57 13505 6117 |
| 58 9869 8220 |
| 59 1570 6044 |
| 60 25780 17387 |
| 61 20671 24913 |
| 62 24558 20591 |
| 63 12402 3702 |
| 64 8314 1357 |

(suite)

| Adresse des accumulateurs de bits de parité (Taux 3/5) q = 72 |
|---|
| 65 20071 14616 |
| 66 17014 3688 |
| 67 19837 946 |
| 68 15195 12136 |
| 69 7758 22808 |
| 70 3564 2925 |
| 71 3434 7769 |

Table 3

| Adresse des accumulateurs de bits de parité (Taux 8/9) q = 20 |
|---|
| 0 6235 2848 3222 |
| 1 5800 3492 5348 |
| 2 2757 927 90 |
| 3 6961 4516 4739 |
| 4 1172 3237 6264 |
| 5 1927 2425 3683 |
| 6 3714 6309 2495 |
| 7 3070 6342 7154 |
| 8 2428 61 3761 |
| 9 2906 264 5927 |
| 10 1716 1950 4273 |
| 11 4613 6179 3491 |
| 12 4865 3286 6005 |
| 13 1343 5923 3529 |
| 14 4589 4035 2132 |
| 15 1579 3920 6737 |
| 16 1644 1191 5998 |
| 17 1482 23814620 |
| 18 6791 6014 6596 |
| 19 2738 5918 3786 |
| 0 5156 6166 |
| 1 1504 4356 |
| 2 130 1904 |
| 3 6027 3187 |
| 4 6718 759 |
| 5 6240 2870 |
| 6 2343 1311 |
| 7 1039 5465 |
| 8 6617 2513 |
| 9 1588 5222 |
| 10 6561 535 |
| 11 4765 2054 |
| 12 5966 6892 |
| 13 1969 3869 |
| 14 3571 2420 |
| 15 4632 981 |
| 16 3215 4163 |
| 17 973 3117 |

**EP 2 273 683 B1**

(suite)

| Adresse des accumulateurs de bits de parité (Taux 8/9) q = 20 |
|---|
| 18 3802 6198 |
| 19 3794 3948 |
| 0 3196 6126 |
| 1 573 1909 |
| 2 850 4034 |
| 3 5622 1601 |
| 4 6005 524 |
| 5 5251 5783 |
| 6 172 2032 |
| 7 1875 2475 |
| 8 497 1291 |
| 9 2566 3430 |
| 10 1249 740 |
| 11 2944 1948 |
| 12 6528 2899 |
| 13 2243 3616 |
| 14 867 3733 |
| 15 1374 4702 |
| 16 4698 2285 |
| 17 4760 3917 |
| 18 1859 4058 |
| 19 6141 3527 |
| 0 2148 5066 |
| 1 1306 145 |
| 2 2319 871 |
| 3 3463 1061 |
| 4 5554 6647 |
| 5 5837 339 |
| 6 5821 4932 |
| 7 6356 4756 |
| 8 3930 418 |
| 9 211 3094 |
| 10 1007 4928 |
| 11 3584 1235 |
| 12 6982 2869 |
| 13 1612 1013 |
| 14 953 4964 |
| 1 4555 4410 |
| 16 4925 4842 |
| 17 5778 600 |
| 18 6509 2417 |
| 19 1260 4903 |
| 0 3369 3031 |
| 1 3557 3224 |
| 2 3028 583 |
| 3 3258 440 |
| 4 6226 6655 |
| 5 4895 1094 |
| 6 1481 6847 |
| 7 4433 1932 |

(suite)

**110**

(suite)

| Adresse des accumulateurs de bits de parité (Taux 8/9) q = 20 |
|---|
| 8 2107 1649 |
| 9 2119 2065 |
| 10 4003 6388 |
| 11 6720 3622 |
| 12 3694 4521 |
| 13 1164 7050 |
| 14 1965 3613 |
| 15 4331 66 |
| 16 2970 1796 |
| 17 4652 3218 |
| 18 1762 4777 |
| 19 5736 1399 |
| 0 970 2572 |
| 1 2062 6599 |
| 2 4597 4870 |
| 3 1228 6913 |
| 4 4159 1037 |
| 5 2916 2362 |
| 6 395 1226 |
| 7 6911 4548 |
| 8 4618 2241 |
| 9 4120 4280 |
| 10 5825 474 |
| 11 2154 5558 |
| 12 3793 5471 |
| 13 5707 1595 |
| 14 1403 325 |
| 15 6601 5183 |
| 16 6369 4569 |
| 17 4846 896 |
| 18 7092 6184 |
| 19 6764 7127 |
| 0 6358 1951 |
| 1 3117 6960 |
| 2 2710 7062 |
| 3 1133 3604 |
| 4 3694 657 |
| 5 1355 110 |
| 6 3329 6736 |
| 7 2505 3407 |
| 8 2462 4806 |
| 9 4216 214 |
| 10 5348 5619 |
| 11 6627 6243 |
| 12 2644 5073 |
| 13 4212 5088 |
| 14 3463 3889 |
| 15 5306 478 |
| 16 4320 6121 |
| 17 3961 1125 |

**111**

(suite)

| Adresse des accumulateurs de bits de parité (Taux 8/9) q = 20 |
|---|
| 18 5699 1195 |
| 19 6511 792 |
| 0 3934 2778 |
| 1 3238 6587 |
| 2 1111 6596 |
| 3 1457 6226 |
| 4 1446 3885 |
| 5 3907 4043 |
| 6 6839 2873 |
| 7 1733 5615 |
| 8 5202 4269 |
| 9 3024 4722 |
| 10 5445 6372 |
| 11 370 1828 |
| 12 4695 1600 |
| 13 6802074 |
| 14 1801 6690 |
| 15 2669 1377 |
| 16 2463 1681 |
| 17 5972 5171 |
| 18 5728 4284 |
| 19 1696 1459 |

Table 4

| Adresse des accumulateurs de bits de parité (Taux 9/10) q = 18 |
|---|
| 0 5611 2563 2900 |
| 1 5220 3143 4813 |
| 2 2481 834 81 |
| 3 6265 4064 4265 |
| 4 1055 2914 5638 |
| 5 1734 2182 3315 |
| 6 3342 5678 2246 |
| 7 2185 552 3385 |
| 8 261 236 334 |
| 9 1546 1755 3846 |
| 10 4154 5561 3142 |
| 11 4382 2957 5400 |
| 12 1209 5329 3179 |
| 13 1421 3528 6063 |
| 14 1480 1072 5398 |
| 15 3843 1777 4369 |
| 16 1334 2145 4163 |
| 17 2368 5055 260 |
| 0 6118 5405 |
| 1 2994 4370 |
| 2 3405 1669 |
| 3 4640 5550 |

(suite)

| Adresse des accumulateurs de bits de parité (Taux 9/10) q = 18 |
|---|
| 4 1354 3921 |
| 5 117 1713 |
| 6 5425 2866 |
| 7 6047 683 |
| 8 5616 2582 |
| 9 2108 1179 |
| 10 933 4921 |
| 11 5953 2261 |
| 12 1430 4699 |
| 13 5905 480 |
| 14 4289 1846 |
| 15 5374 6208 |
| 16 1775 3476 |
| 17 3216 2178 |
| 0 4165 884 |
| 1 2896 3744 |
| 2 874 2801 |
| 3 3423 5579 |
| 4 3404 3552 |
| 5 2876 5515 |
| 6 516 1719 |
| 7 765 3631 |
| 8 5059 1441 |
| 9 5629 598 |
| 10 5405 473 |
| 11 4724 5210 |
| 12 155 1832 |
| 13 1689 2229 |
| 14 449 1164 |
| 15 2308 3088 |
| 16 1122 669 |
| 17 2268 5758 |
| 0 5878 2609 |
| 1 782 3359 |
| 2 1231 4231 |
| 3 4225 2052 |
| 4 4286 3517 |
| 5 5531 3184 |
| 6 1935 4560 |
| 7 1174 131 |
| 8 3115 956 |
| 9 3129 1088 |
| 10 5238 4440 |
| 11 5722 4280 |
| 12 3540 375 |
| 13 191 2782 |
| 14 906 4432 |
| 15 3225 1111 |
| 16 6296 2583 |
| 17 1457 903 |

(suite)

| Adresse des accumulateurs de bits de parité (Taux 9/10) q = 18 |
|---|
| 0 855 4475 |
| 1 4097 3970 |
| 2 4433 4361 |
| 3 5198 541 |
| 4 1146 4426 |
| 5 3202 2902 |
| 6 2724 525 |
| 7 1083 4124 |
| 8 2326 6003 |
| 9 5605 5990 |
| 10 4376 1579 |
| 11 4407 984 |
| 12 1332 6163 |
| 13 5359 3975 |
| 14 1907 1854 |
| 15 3601 5748 |
| 16 6056 3266 |
| 17 3322 4085 |
| 0 1768 3244 |
| 1 2149 144 |
| 2 15894291 |
| 3 5154 1252 |
| 4 1855 5939 |
| 5 4820 2706 |
| 6 1475 3360 |
| 7 4266 693 |
| 8 4156 2018 |
| 9 2103 752 |
| 10 3710 3853 |
| 11 5123 931 |
| 12 6146 3323 |
| 13 1939 5002 |
| 14 5140 1437 |
| 15 1263 293 |
| 16 5949 4665 |
| 17 4548 6380 |
| 0 3171 4690 |
| 1 5204 2114 |
| 2 6384 5565 |
| 3 5722 1757 |
| 4 2805 6264 |
| 5 1202 2616 |
| 6 1018 3244 |
| 7 4018 5289 |
| 8 2257 3067 |
| 9 2483 3073 |
| 10 1196 5329 |
| 11 649 3918 |
| 12 3791 4581 |
| 13 5028 3803 |

(suite)

| Adresse des accumulateurs de bits de parité (Taux 9/10) q = 18 |
|---|
| 14 3119 3506 |
| 15 4779 431 |
| 16 3888 5510 |
| 17 4387 4084 |
| 0 5836 1692 |
| 1 5126 1078 |
| 2 5721 6165 |
| 3 3540 2499 |
| 4 2225 6348 |
| 5 1044 1484 |
| 6 6323 4042 |
| 7 1313 5603 |
| 8 1303 3496 |
| 9 3516 3639 |
| 10 5161 2293 |
| 11 4682 3845 |
| 12 3045 643 |
| 13 2818 2616 |
| 14 3267 649 |
| 15 6236 593 |
| 16 646 2948 |
| 17 4213 1442 |
| 0 5779 1596 |
| 1 2403 1237 |
| 2 2217 1514 |
| 3 5609 716 |
| 4 5155 3858 |
| 5 1517 1312 |
| 6 2554 3158 |
| 7 5280 2643 |
| 8 4990 1353 |
| 9 5648 1170 |
| 10 1152 4366 |
| 11 3561 5368 |
| 12 3581 1411 |
| 13 5647 4661 |
| 14 1542 5401 |
| 15 5078 2687 |
| 16 316 1755 |
| 17 3392 1991 |

FIG. 1

100

101

TRANSMITTER

103

CHANNEL

105

RECEIVER

EP 2 273 683 B1

EP 2 273 683 B1

**FIG. 2A**

TRANSMITTER 200

SOURCE 201 → (k) → LDPC ENCODER 203 → (Y) → MAPPER 206 → MODULATOR 205 → 207

X

**FIG. 2B**

CRC ENCODER 209 → BCH ENCODER 211 → LDPC ENCODER 203

117

FIG. 3

RECEIVER 300

DEMODULATOR
301

$Y'$

d

BIT METRIC
GENERATOR
307

u

a

LDPC
DECODER
305

$X'$

303

FIG. 4

$$H = \begin{bmatrix} \overset{n_1}{1} & \overset{n_2}{0} & \overset{n_3}{0} & \overset{n_4}{1} & \overset{n_5}{1} & \overset{n_6}{0} & \overset{n_7}{0} & \overset{n_8}{1} \\ 0 & 1 & 1 & 0 & 1 & 0 & 1 & 0 \\ 1 & 0 & 1 & 0 & 0 & 1 & 0 & 1 \\ 0 & 1 & 0 & 1 & 0 & 1 & 1 & 0 \end{bmatrix} \begin{matrix} m_1 \\ m_2 \\ m_3 \\ m_4 \end{matrix}$$

FIG. 5

bit nodes

check nodes

$$B = \begin{bmatrix} 1 & & & & & \\ x & 1 & & & \mathbf{0} & \\ x & x & 1 & & & \\ x & x & x & 1 & & \\ x & x & x & x & 1 & \\ x & x & x & x & x & 1 \end{bmatrix}$$

FIG. 6

**FIG. 7**

FIG. 8A

$010$
$s_2$ o
$011$ o $s_3$

$110$ o $s_6$

$111$ o $s_7$

$s_1$ o $001$

$s_0$ o $000$

$s_5$ o $101$

$s_4$
o
$100$

FIG. 8B

$010$
o
$011$ o $s_7$        $s_5$

$111$ o $s_6$

$110$ o $s_2$

$s_4$ o $001$

$s_0$ o $000$

$s_1$ o $101$

$s_3$
o
$100$

## FIG. 8C

```
          ┌─────────┐
          │  START  │
          └─────────┘
               │
               ▼
     ┌───────────────────┐
801  │  OBTAIN CODEWORD  │
     │  FROM LDPC ENCODER│
     └───────────────────┘
               │
               ▼
     ┌───────────────────┐
     │   MAP CODEWORD TO  │
803  │ A CONSTELLATION POINT│
     │ ON A NON-SEQUENTIAL │
     │ BASIS (e.g., INTERLEAVING)│
     └───────────────────┘
               │
               ▼
     ┌───────────────────┐
805  │  MODULATE SIGNAL  │
     │ BASED ON THE MAPPING│
     └───────────────────┘
               │
               ▼
     ┌───────────────────┐
807  │     TRANSMIT      │
     │  MODULATED SIGNAL │
     └───────────────────┘
               │
               ▼
          ┌─────────┐
          │   END   │
          └─────────┘
```

# FIG. 8D

CONSTELLATION A

CONSTELLATION B

FIG. 8E

## FIG. 8F

**QPSK**

```
            |
   10       |      00
            |
------------+------------
            |
   11       |      01
            |
```

**8-PSK**

```
   101      |      001
            |
  100       |       000
------------+------------
            |
   110      |       010
     111    |    011
```

16-APSK

32-APSK

FIG. 8G

FIG. 8H

FIG. 9

FIG. 10

```
                          ┌──────────┐
                          │  START   │
                          └────┬─────┘
                               │
              ┌────────────────▼────────────────┐
   1001 ─────▶│     PERFORM INITIALIZATION       │
              └────────────────┬────────────────┘
                               │
              ┌────────────────▼────────────────┐
   1003 ─────▶│       UPDATE CHECK NODE          │◀──────────────┐
              └────────────────┬────────────────┘                │
                               │                                 │
              ┌────────────────▼────────────────┐                │
   1005 ─────▶│            OUTPUT                │                │
              │         A POSTERIORI             │                │
              └────────────────┬────────────────┘                │
                               │                                 │
                        1007   ▼                                 │
          YES         ╱─────────────────╲      NO   ┌────────────────────────┐
       ┌────────────◀│   ALL PARITY      │─────────▶│   RE-DERIVE 8-PSK BIT  │
       │             │ CHECK EQUATIONS   │          │  METRICS AND CHANNEL   │
       │              ╲   SATISFIED?    ╱           │         INPUT          │
       │               ╲───────────────╱            └───────────┬────────────┘
       │                            1011                        │
       ▼                                            ┌───────────▼────────────┐
┌──────────────────────┐                      1013  │     UPDATE BIT NODE    │
│ OUTPUT HARD DECISION  │                            └───────────┬────────────┘
└──────────┬───────────┘                                         │
           │                                                     │
           ▼                                                     │
      ┌─────────┐                                                │
      │   END   │                                                │
      └─────────┘                                                │
                                                                 └──────────────▶
```

1009 OUTPUT HARD DECISION

FIG. 11

```
                              ┌──────────┐
                              │  START   │
                              └────┬─────┘
                                   │
                    ┌──────────────▼──────────────┐
           1101     │    PERFORM INITIALIZATION    │
                    └──────────────┬──────────────┘
                                   │
                    ┌──────────────▼──────────────┐
           1103     │      UPDATE CHECK NODE       │◄───┐
                    └──────────────┬──────────────┘    │
                                   │                   │
                    ┌──────────────▼──────────────┐    │
           1105     │       UPDATE BIT NODE        │    │
                    └──────────────┬──────────────┘    │
                                   │                   │
                    ┌──────────────▼──────────────┐    │
                    │          OUTPUT              │    │
           1107     │        A POSTERIORI          │    │
                    └──────────────┬──────────────┘    │
                                   │                   │
                  1109            ╱ ╲                   │
                          YES    ╱   ╲    NO            │
                      ┌─────────╱ALL PARITY╲────────────┘
                      │        ╱CHECK EQUATIONS╲
                      │        ╲ SATISFIED?   ╱
                      │         ╲           ╱
                      │          ╲ ╱
          ┌───────────▼──────────┐
   1111   │  OUTPUT HARD DECISION │
          └───────────┬──────────┘
                      │
                 ┌────▼────┐
                 │   END   │
                 └─────────┘
```

EP 2 273 683 B1

FIG. 12A

$v_{n \to k_1} = U_n$

$v_{n \to k_2} = U_n$

Bit node n

$v_{n \to k_i} = U_n$

FIG. 12B

$w_{k \to n_1}$

$w_{k \to n_2}$

$w_{k \to n_3}$

$v_{n_1 \to k}$

$v_{n_2 \to k}$

$v_{n_3 \to k}$

Check node k

$v_{n_{dc} \to k}$

$w_{k \to dc}$

$w_{k \to n_i} = g(v_{n_1 \to k}, v_{n_2 \to k}, \ldots, v_{n_{i-1} \to k}, v_{n_{i+1} \to k}, \ldots, v_{n_{dc} \to k})$

FIG. 12C

$v_{n \to k_1}$

$w_{k_1 \to n}$

Bit node n

$v_{n \to k_2}$

$w_{k_2 \to n}$

$w_{k_3 \to n}$

$v_{n \to k_3}$

$w_{dv \to n}$

$v_{n \to k_i} = U_n + \sum_{j \neq i} w_{k_j \to n}$

$v_{n \to k_{dv}}$

EP 2 273 683 B1

## FIG. 13A

```
        START
          │
          ▼
```

1301 — COMPUTE FORWARD VARIABLES

1303 — STORE FORWARD VARIABLES

1305 — COMPUTE BACKWARD VARIABLES

1307 — COMPUTE OUTGOING MESSAGES BASED ON THE STORED FORWARD VARIABLES AND COMPUTED BACKWARD VARIABLES

```
          │
          ▼
        END
```

## FIG. 13B

```
        START
          │
          ▼
```

1311 — COMPUTE $\gamma_k$

1313 — PERFORM LOOK UP TO DETERMINE $\ln|e^x - 1|$

1315 — COMPUTE IN PARALLEL THE FOLLOWING:

$$W_{k \to n_l}$$

```
          │
          ▼
        END
```

EP 2 273 683 B1

## FIG. 14A

1.485 bits/symbol

EP 2 273 683 B1

FIG. 14B

0.990 bits/symbol

Error Rate

1.E+00

1.E-01

1.E-02

1.E-03

1.E-04

TS PER

1.E-05

BER

1.E-06

1.E-07

1.E-08

1.E-09

0.9                              1.1                              1.3

Es/No (dB)

EP 2 273 683 B1

FIG. 14C

FIG. 15A

| 391nq | 391nq+1 | 391nq+2 | 391nq+3 | 391nq+4 | ... | 391nq-1 | ... | 392nq-1 |

| nq | nq+1 | nq+2 | nq+3 | nq+4 | ... | nq-1 | ... | 2nq-1 |
| 0 | 1 | 2 | 3 | 4 | ... | q-1 | ... | ng-1 |

Check Node Access

1501

FIG. 15B

EP 2 273 683 B1

# FIG. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **J.W.BOND et al.** Constructing Low-Density Parity-Check Codes. *Proc., IEEE/AFCEA Information Systems for Enhanced Public Safety and Security, EUROCOMM 2000,* 17 May 2000